# EUROPÄISCHE PATENTSCHRIFT

(11) **EP 4 049 510 B1**
(45) Veröffentlichungstag und Bekanntmachung des Hinweises auf die Patenterteilung: **01.11.2023**
(21) Anmeldenummer: 20792382.2
(22) Anmeldetag: 14.10.2020
(51) Int. Cl.: H05B 1/02, B62D 1/06, H03K 17/955, H03K 17/96

(54) **KOMBINIERTE, KAPAZITIVE SENSOR- UND HEIZVORRICHTUNG, VERFAHREN ZUM BETRIEB EINER SENSOR- UND HEIZVORRICHTUNG, LENKEINGABEVORRICHTUNGS-BAUGRUPPE MIT EINER SENSOR- UND HEIZVORRICHTUNG UND FAHRZEUG MIT EINER LENKEINGABEVORRICHTUNGS-BAUGRUPPE**
COMBINED CAPACITIVE SENSOR AND HEATING APPARATUS, METHOD FOR OPERATING A SENSOR AND HEATING APPARATUS, STEERING INPUT APPARATUS ASSEMBLY HAVING A SENSOR AND HEATING APPARATUS, AND VEHICLE HAVING A STEERING INPUT APPARATUS ASSEMBLY
CAPTEUR CAPACITIF COMBINÉ ET APPAREIL DE CHAUFFAGE, PROCÉDÉ POUR FAIRE FONCTIONNER UN CAPTEUR ET APPAREIL DE CHAUFFAGE, ENSEMBLE APPAREIL D'ENTRÉE DE DIRECTION AYANT UN CAPTEUR ET APPAREIL DE CHAUFFAGE, ET VÉHICULE AYANT UN ENSEMBLE APPAREIL D'ENTRÉE DE DIRECTION

(30) Priorität: 25.10.2019 DE 102019128887
(43) Veröffentlichungstag der Anmeldung: 31.08.2022
(73) Patentinhaber: Valeo Schalter und Sensoren GmbH, 74321 Bietigheim-Bissingen (DE)
(72) Erfinder: STAUDE, Sascha, 74321 Bietigheim-Bissingen (DE); POSLOWSKY, Georg, 74321 Bietigheim-Bissingen (DE); TSINISTIDIS, Iordanis, 74321 Bietigheim-Bissingen (DE); HARTMUELLER, Markus, 74321 Bietigheim-Bissingen (DE); MACK, Raphael, 74321 Bietigheim-Bissingen (DE)
(74) Vertreter: Ralf, Thorge
(86) Internationale Anmeldenummer: PCT/EP2020/078818
(87) Internationale Veröffentlichungsnummer: WO 2021/078592

(56) Entgegenhaltungen:
- DE-A1-102014 117 820
- DE-A1-102014 117 823
- DE-T5-112016 001 183
- US-A1- 2016 101 805

## Beschreibung

Die Erfindung betrifft eine kombinierte, kapazitive Sensor- und Heizvorrichtung mit einer kapazitiven Sensoreinrichtung zum Erkennen einer Anwesenheit eines kapazitiv wirksamen Betätigungsmittels in einem Detektionsbereich der Sensoreinrichtung, insbesondere zum Erkennen einer Anwesenheit einer menschlichen Hand in einem Greifbereich einer Lenkeingabevorrichtung, und mit einer Heizeinrichtung, insbesondere mit einer Heizeinrichtung für eine Lenkeingabevorrichtung eines Fahrzeugs, wobei die kombinierte, kapazitive Sensor- und Heizvorrichtung wenigstens ein elektrisches, kombiniertes Sensor- und Heizelement aufweist, welches sowohl von der Sensoreinrichtung als kapazitives Sensorelement als auch von der Heizeinrichtung als elektrisches Heizelement nutzbar ist. Das kombinierte Sensor- und Heizelement weist dabei einen ersten Anschluss und einen zweiten Anschluss auf, wobei der erste Anschluss des kombinierten Sensor- und Heizelements über einen ersten elektrischen Pfad mit wenigstens einer ersten Schalteinrichtung mit einem ersten Pol einer Spannungsquelle elektrisch verbindbar und von diesem elektrisch trennbar ist, und wobei der zweite Anschluss des kombinierten Sensor- und Heizelements über einen zweiten elektrischen Pfad mit wenigstens einer zweiten Schalteinrichtung mit einem zweiten Pol der Spannungsquelle elektrisch verbindbar und von diesem elektrisch trennbar ist. Zum Betreiben des kombinierten Sensor- und Heizelements als Sensorelement kann der erste Anschluss des kombinierten Sensor- und Heizelements durch Öffnen wenigstens einer Schalteinrichtung des ersten elektrischen Pfades, insbesondere durch Öffnen sämtlicher Schalteinrichtungen des ersten elektrischen Pfades, vom ersten Pol der Spannungsquelle elektrisch getrennt werden, und durch Öffnen wenigstens einer Schalteinrichtung des zweiten elektrischen Pfades, insbesondere durch Öffnen sämtlicher Schalteinrichtungen des zweiten elektrischen Pfades, kann der zweite Anschluss des kombinierten Sensor-und Heizelements vom zweiten Pol der Spannungsquelle getrennt werden. Zum Betreiben des kombinierten Sensor- und Heizelements als Heizelement ist der erste Anschluss des kombinierten Sensor- und Heizelements durch Schließen aller Schalteinrichtungen des ersten elektrischen Pfades mit dem ersten Pol der Spannungsquelle elektrisch verbindbar. Durch Schließen aller Schalteinrichtungen des zweiten elektrischen Pfades ist der zweite Anschluss des kombinierten Sensor- und Heizelements mit dem zweiten Pol der Spannungsquelle elektrisch verbindbar. Die kombinierte Sensor- und Heizvorrichtung weist ferner eine Synchronisierungseinrichtung auf, zur zumindest teilweisen Synchronisierung einer Ansteuerung von Sensoreinrichtung und Heizeinrichtung.

Des Weiteren betrifft die vorliegende Erfindung ein Verfahren zum Betrieb einer solchen Sensor- und Heizvorrichtung.

Darüber hinaus betrifft die vorliegende Erfindung eine Lenkeingabevorrichtungs-Baugruppe für ein Fahrzeug, insbesondere eine Lenkradbaugruppe, mit einem lenkradseitigen Teil, der insbesondere wenigstens ein Lenkradmodul aufweist, insbesondere ein Lenkrad mit einem Lenkradmodul, und einem fahrzeugaufbauseitigen Teil, insbesondere einem Lenksäulenmodul, wobei in einem funktionsgemäßen Einbauzustand der Lenkeingabevorrichtungs-Baugruppe in einem Fahrzeug der lenkradseitige Teil relativ gegenüber dem fahrzeugaufbauseitigen Teil bewegbar ist, insbesondere drehbar gegenüber dem fahrzeugaufbauseitigen Teil, insbesondere um eine Drehachse einer Lenkwelle, wobei die Lenkeingabevorrichtungs-Baugruppe eine kombinierte, kapazitive Sensor- und Heizvorrichtung aufweist.

Ferner betrifft die Erfindung ein Fahrzeug mit einer Lenkeingabevorrichtungs-Baugruppe. Kombinierte, kapazitive Sensor- und Heizvorrichtungen mit einem kombinierten Sensor-und Heizelement sind als solche aus dem Stand der Technik grundsätzlich bekannt, wobei unterschiedlichste Ausgestaltungen von Sensor- und Heizvorrichtungen bekannt sind, insbesondere mit unterschiedlichsten Verschaltungen und Ansteuerungen des kombinierten Sensor- und Heizelements. Die Dokumenten DE 11 2016 001183 T5, DE 10 2014 117823 A1, DE 10 2014 117820 A1 und US 2016/101805 A1 offenbaren kombinierte, kapazitive Sensor- und Heizvorrichtungen nach dem Stand der Technik.

Vor diesem Hintergrund ist es eine Aufgabe der Erfindung, eine alternative kombinierte, kapazitive Sensor- und Heizvorrichtung bereitzustellen, insbesondere eine verbesserte Sensor- und Heizvorrichtung, sowie ferner ein alternatives, insbesondere verbessertes Verfahren zum Betrieb einer solchen Sensor- und Heizvorrichtung, eine alternative, insbesondere verbesserte Lenkeingabevorrichtungs-Baugruppe und ein alternatives, insbesondere verbessertes Fahrzeug mit einer Lenkeingabevorrichtungs-Baugruppe. Diese Aufgabe wird erfindungsgemäß durch eine kombinierte, kapazitive Sensor- und Heizvorrichtung, durch ein Verfahren zum Betrieb einer solchen Sensor- und Heizvorrichtung, durch eine Lenkeingabevorrichtungs-Baugruppe mit einer solchen Sensor- und Heizvorrichtung und durch ein Fahrzeug mit einer Lenkeingabevorrichtungs-Baugruppe gemäß den jeweiligen unabhängigen Patentansprüchen gelöst. Vorteilhafte Ausführungen der vorliegenden Erfindung sind Gegenstand der abhängigen Patentansprüche, der Beschreibung und der Figuren.

Eine erfindungsgemäße kombinierte, kapazitive Sensor- und Heizvorrichtung mit einer kapazitiven Sensoreinrichtung zum Erkennen einer Anwesenheit eines kapazitiv wirksamen Betätigungsmittels in einem Detektionsbereich der Sensoreinrichtung, insbesondere zum Erkennen einer Anwesenheit einer menschlichen Hand in einem Greifbereich einer Lenkeingabevorrichtung, und mit einer Heizeinrichtung, insbesondere mit einer Heizeinrichtung für eine Lenkeingabevorrichtung eines Fahrzeugs, weist wenigstens ein elektrisches, kombiniertes Sensor- und Heizelement auf, welches sowohl von der Sensoreinrichtung als kapazitives Sensorelement als auch von der Heizeinrichtung als elektrisches Heizelement nutzbar ist, wobei das kombinierte Sensor-und Heizelement einen ersten Anschluss und einen zweiten Anschluss aufweist, wobei der erste Anschluss des kombinierten Sensor- und Heizelements über einen ersten elektrischen Pfad mit wenigstens einer ersten Schalteinrichtung mit einem ersten Pol einer Spannungsquelle elektrisch verbindbar und von diesem elektrisch trennbar ist, wobei der zweite Anschluss des kombinierten Sensor- und Heizelements über einen zweiten elektrischen Pfad mit wenigstens einer zweiten Schalteinrichtung mit einem zweiten Pol der Spannungsquelle elektrisch verbindbar und von diesem elektrisch trennbar ist, wobei zum Betreiben des kombinierten Sensor- und Heizelements als Sensorelement der erste Anschluss des kombinierten Sensor- und Heizelements durch Öffnen wenigstens einer Schalteinrichtung des ersten elektrischen Pfades, insbesondere durch Öffnen sämtlicher Schalteinrichtungen des ersten elektrischen Pfades, vom ersten Pol der Spannungsquelle elektrisch trennbar ist und durch Öffnen wenigstens einer Schalteinrichtung des zweiten elektrischen Pfades, insbesondere durch Öffnen sämtlicher Schalteinrichtungen des zweiten elektrischen Pfades, der zweite Anschluss des kombinierten Sensor- und Heizelements vom zweiten Pol der Spannungsquelle trennbar ist, wobei zum Betreiben des kombinierten Sensor- und Heizelements als Heizelement der erste Anschluss des kombinierten Sensor- und Heizelements durch Schließen aller Schalteinrichtungen des ersten elektrischen Pfades mit dem ersten Pol der Spannungsquelle elektrisch verbindbar ist und der zweite Anschluss des kombinierten Sensor- und Heizelements durch Schließen aller Schalteinrichtungen des zweiten elektrischen Pfades mit dem zweiten Pol der Spannungsquelle elektrisch verbindbar ist, und wobei die kombinierte Sensor- und Heizvorrichtung ferner eine Synchronisierungseinrichtung aufweist zur zumindest teilweisen Synchronisierung einer Ansteuerung von Sensoreinrichtung und Heizeinrichtung.

Eine erfindungsgemäße kombinierte, kapazitive Sensor- und Heizvorrichtung ist dadurch gekennzeichnet, dass die Synchronisierungseinrichtung über wenigstens einen weiteren elektrischen Pfad mit dem ersten elektrischen Pfad oder dem zweiten elektrischen Pfad elektrisch verbunden oder verbindbar ist und dazu ausgebildet und eingerichtet ist, zumindest zeitweise, insbesondere während eines Heizbetriebs, vorzugsweise außerhalb einer kapazitiven Messung, eine am ersten elektrischen Pfad zwischen dem ersten Pol der Spannungsquelle und dem ersten Anschluss des kombinierten Sensor- und Heizelements anliegende Ist-Spannung, insbesondere einen Ist-Spannungsverlauf über der Zeit, und/oder einen aktuellen Ist-Stromfluss, insbesondere einen Ist-Stromflussverlauf über der Zeit, entlang des ersten elektrisch Pfades zu erfassen und/oder eine am zweiten elektrischen Pfad zwischen dem zweiten Anschluss des kombinierten Sensor- und Heizelements und dem zweiten Pol anliegende Ist-Spannung, insbesondere einen Ist-Spannungsverlauf über der Zeit, und/oder einen aktuellen Ist-Stromfluss, insbesondere einen Ist-Stromflussverlauf über der Zeit, entlang des zweiten elektrisch Pfades zu erfassen, wobei die Synchronisierungseinrichtung dazu ausgebildet und eingerichtet ist, in Abhängigkeit von der erfassten Ist-Spannung, insbesondere in Abhängigkeit von dem erfassten Ist-Spannungsverlauf über der Zeit, und/oder in Abhängigkeit von dem erfassten Ist-Stromfluss, insbesondere in Abhängigkeit von dem erfassten Ist-Stromfluss über der Zeit, einen aktuellen Ist-Zustand der Heizeinrichtung zu erkennen oder zu bestimmen, und in Abhängigkeit von dem erkannten oder bestimmten Ist-Zustand der Heizeinrichtung wenigstens zumindest teilweise die Sensoreinrichtung anzusteuern und/oder wenigstens ein Steuersignal zur zumindest teilweisen Ansteuerung der Sensoreinrichtung auszugeben.

Das direkte Erfassen einer Ist-Spannung und/oder eines Ist-Stromflusses und/oder eines zugehörigen -verlaufs und damit vorzugsweise einer an das kombinierte Sensor- und Heizelement abgegebenen Heizleistung, ermöglicht eine gezielt an den aktuellen Ist-Zustand der Heizeinrichtung angepasste Steuerung der Sensoreinrichtung, insbesondere einen gezielt auf den Heizbetrieb synchronisierten Sensorbetrieb. Insbesondere ermöglicht dies ein Betreiben der Heizeinrichtung mit einer variablen Taktung und insbesondere mit einer Sensoreinrichtung mit einer von der Steuerung der Heizeinrichtung getrennt ausgebildeten Steuerungs- und Auswerteeinrichtung ohne ein separates (zusätzliches) Synchronisationssignal.

Unter dem Begriff "Synchronisation" oder "Synchronisierung" wird im Sinne der vorliegenden Erfindung dabei lediglich die geeignete zeitliche Abstimmung von Heizeinrichtung und Sensoreinrichtung als solche verstanden, insbesondere die zeitliche Abstimmung einer Ansteuerung der diesen zugeordneten Komponenten, d.h. die zeitliche Abstimmung der Ansteuerung der der Sensoreinrichtung und/oder der Heizeinrichtung zugeordneten Komponenten. Eine Synchronisation im Sinne der vorliegenden Erfindung erfordert somit nicht zwingend ein gleichzeitiges Eintreten eines Ereignisses.

Die variable Taktung der Heizeinrichtung ermöglicht eine anforderungsoptimiertere Steuerung der Heizeinrichtung und damit einen vorteilhafteren und somit verbesserten Betrieb der Heizeinrichtung.

Die Synchronisation der Steuerung der Sensoreinrichtung in Abhängigkeit von der tatsächlich erfassten Heizleistung, statt beispielsweise über ein separates (zusätzliches Synchronisationssignal, welches beispielsweise und wie zur Kommunikation zwischen Steuer- und Auswerteeinrichtungen üblich über einen Datenbus übertragen wird, beispielsweise über einen LIN-Bus oder einen CAN-Bus, welche jeweils nur eine begrenzte Übertragungsrate und damit nur eine begrenzte Synchronisierungsgeschwindigkeit ermöglichen, ermöglicht eine besonders schnelle Synchronisation, so dass sich auch bei einer hohen Taktung, d.h. einer hohen Pulsfrequenz einer Heizleistungsabgabe, zwischen den einzelnen Heizpulsen, noch vollständige kapazitive Sensormessungen oder anderweitige Sensor-Betriebszyklen wie beispielsweise entsprechende Diagnosemessungen und/oder Plausibilitätsprüfungen durchführen lassen, aufgrund einer nicht durch die Übertragungsrate des Synchronisationssignals verzögerten Ansteuerung der Sensoreinrichtung.

Die vorgenannten Vorteile schaffen ferner vorteilhafte Voraussetzungen für eine Trennung bzw. Aufteilung der Steuerungsfunktionen zur Steuerung der Heizeinrichtung und zur Steuerung der Sensoreinrichtung, insbesondere für eine Aufteilung auf verschiedene, separat ausgebildete und insbesondere räumlich getrennt voneinander anordbare Steuerungs- und Auswerteeinrichtungen.

Dies eröffnet insbesondere die Möglichkeit, Teile der kombinierten, kapazitiven Sensor-und Heizvorrichtung auf verschiedenen Baugruppen aufzuteilen bzw. verschiedenen Baugruppen zuzuordnen, wodurch sich in einigen Fällen besonders vorteilhafte Bauraum-und/oder Package-Verhältnisse und/oder besonders vorteilhafte Möglichkeiten im Hinblick auf eine Systemarchitektur ergeben können, was im Folgenden noch näher beschrieben wird.

Die Verwendung eines kombinierten Sensor- und Heizelements sowohl als elektrisches Heizelement als auch als kapazitive Sensorelektrode erfordert zum Betrieb der Heizeinrichtung, insbesondere zum Erzeugen von Heizwärme, eine elektrische Verbindung des Sensor- und Heizelements mit einer Spannungsquelle, insbesondere einen Stromfluss durch das Sensor- und Heizelement hindurch, insbesondere einen geschlossenen Stromkreis. Zum Betrieb einer kombinierten Sensor- und Heizvorrichtung als Sensoreinrichtung hingegen, d.h. für eine Nutzung des Sensor- und Heizelements als kapazitive Sensorelektrode, ist eine allpolige elektrische Trennung des Sensor- und Heizelements von der Spannungsversorgung erforderlich, d.h. eine elektrische Trennung des Sensor- und Heizelements von beiden Polen der zugehörigen Spannungsquelle. Dazu sind wenigstens zwei Schalteinrichtungen erforderlich.

Bei einer erfindungsgemäßen Sensor- und Heizvorrichtung sind dazu insbesondere die erste Schalteinrichtung, die Teil des ersten elektrischen Pfades ist und über welche das kombinierte Sensor- und Heizelement, insbesondere dessen erster Anschluss, mit dem ersten Pol einer Spannungsquelle elektrisch verbindbar ist oder von diesem elektrisch trennbar ist, sowie die zweite Schalteinrichtung, die Teil des zweiten elektrischen Pfades ist und über welche das kombinierte Sensor- und Heizelement, insbesondere dessen zweiter Anschluss, mit dem zweiten Pol der Spannungsquelle elektrisch verbindbar ist oder von diesem elektrisch trennbar ist, vorgesehen.

Unter einer "kombinierten, kapazitiven Sensor- und Heizvorrichtung" wird im Sinne der vorliegenden Erfindung eine Vorrichtung verstanden, welche sowohl eine kapazitive Sensoreinrichtung als auch eine Heizeinrichtung aufweist, wobei insbesondere wenigstens ein Bauteil gemeinsam sowohl von der Sensoreinrichtung als auch von der Heizeinrichtung genutzt wird, in diesem Fall wenigstens das kombinierte Sensor- und Heizelement.

Ein "kombiniertes Sensor- und Heizelement" im Sinne der vorliegenden Erfindung ist insbesondere ein elektrisch leitfähiges Element, welches sowohl als elektrisches Heizelement der Heizeinrichtung als auch als kapazitive Sensorelektrode der Sensoreinrichtung betreibbar ist, vorzugsweise wenigstens zeitlich nacheinander versetzt.

Unter einer "Heizeinrichtung" wird im Sinne der vorliegenden Erfindung eine Vorrichtung verstanden, welche zur zumindest zeitweisen Abgabe von Heizwärme eingerichtet ist, wobei die Heizwärme besonders bevorzugt durch einen Stromfluss durch das kombinierte Sensor- und Heizelement hindurch erzeugt werden kann und insbesondere an die Umgebung des Sensor- und Heizelements abgegeben werden kann, wobei das kombinierte Sensor- und Heizelement insbesondere dazu ausgebildet und eingerichtet ist, als elektrischer Heizwiderstand zu dienen.

Entsprechende Heizeinrichtungen, auch für Lenkräder eines Fahrzeugs, sind aus dem Stand der Technik grundsätzlich bekannt, auf welchen für nähere Informationen zur grundsätzlichen Funktionsweise sowie zu allgemeinen Anforderungen an die Ausgestaltung derartiger Heizeinrichtungen verwiesen wird.

Zum Einschalten der Heizeinrichtung und damit zum Erzeugen von Heizwärme, insbesondere zum Erzeugen des Stromflusses durch das kombinierte Sensor- und Heizelement hindurch, können insbesondere die erste Schalteinrichtung und die zweite Schalteinrichtung geschlossen werden, falls vorhanden insbesondere sämtliche Schalteinrichtungen, mit welchen das kombinierte Sensor- und Heizelement zwischen dem ersten Pol einer Spannungsquelle und dem zweiten Pol der Spannungsquelle in Reihe geschaltet ist, besonders bevorzugt jeweils gleichzeitig und/oder derart, dass sie zumindest zeitweise gleichzeitig geschlossen sind, wodurch der erste Anschluss des kombinierten Sensor- und Heizelements mit dem ersten Pol der Spannungsquelle elektrisch verbunden wird und der zweite Pol der Spannungsquelle mit dem zweiten Anschluss des Sensor- und Heizelements, so dass ein Stromfluss durch das Sensor- und Heizelement, gespeist von der Spannungsquelle, möglich ist.

Die Spannungsquelle ist vorzugsweise eine Versorgungsspannungsquelle, insbesondere eine Gleichspannungsquelle, wobei der erste Pol vorzugsweise ein Pol ist, an dem eine positive Betriebsspannung anliegt oder anlegbar ist, beispielsweise +12V oder 24V wie in einem Fahrzeug, und der zweite Pol insbesondere ein Pol, an dem ein Nullpotential anliegt, d.h. Masse (0V).

Zum Abschalten der Heizeinrichtung und damit zum Beenden der Erzeugung von Heizwärme, insbesondere zum Beenden des Stromflusses durch das Sensor- und Heizelement hindurch, kann wenigstens eine Schalteinrichtung geöffnet werden, wobei besonders bevorzugt zum Abschalten der Heizeinrichtung wenigstens die erste Schalteinrichtung und/oder die zweite Schalteinrichtung geöffnet werden kann, vorzugsweise wenigstens die erste Schalteinrichtung und die zweite Schalteinrichtung, insbesondere sämtliche Schalteinrichtungen, mit welchen das kombinierte Sensor- und Heizelement zwischen dem ersten Pol einer Spannungsquelle und dem zweiten Pol der Spannungsquelle in Reihe geschaltet ist, insbesondere jeweils gleichzeitig und/oder derart, dass sie zumindest zeitweise gleichzeitig geöffnet sind, wodurch der erste Anschluss des kombinierten Sensor- und Heizelement von dem ersten Pol der Spannungsquelle elektrisch getrennt wird und/oder der zweite Pol der Spannungsquelle von dem zweiten Anschluss des Sensor- und Heizelements, wodurch die das kombinierte Sensor- und Heizelement allpolig abgeschaltet werden kann.

Besonders bevorzugt ist die Heizeinrichtung einer erfindungsgemäßen Sensor- und Heizvorrichtung dabei dazu ausgebildet und eingerichtet, eine definierte Heizleistung abzugeben, insbesondere eine gewünschte definierte Heizleistung, insbesondere in Abhängigkeit von einer Anforderung, beispielsweise in Abhängigkeit von einem erfassten Temperaturwert, beispielsweise in Abhängigkeit von einer Lenkradtemperatur oder dergleichen, wobei die abgebbare Heizleistung besonders bevorzugt veränderlich ist und insbesondere mittels einer steuerbaren oder regelbaren Pulsweitenmodulation (PWM) gezielt einstellbar ist, wie dies aus dem Stand der Technik grundsätzlich bekannt ist, auf welchen für nähere Informationen und Details in Bezug auf Anforderungen und Ausgestaltungsmöglichkeiten diesbezüglich verwiesen wird.

Eine "kapazitive Sensoreinrichtung" im Sinne der vorliegenden Erfindung ist eine Sensoreinrichtung, welche vorzugsweise dazu ausgebildet und insbesondere dazu eingerichtet ist, eine Kapazität, d. h. eine Größe einer kapazitiven Kopplung, und/oder eine Änderung einer Kapazität und/oder eine entsprechende Größe, welche eine Kapazität und/oder eine Änderung einer Kapazität charakterisiert, zu erfassen und vorzugsweise auszuwerten.

Kapazitive Sensoreinrichtungen zum Erkennen einer Anwesenheit eines kapazitiv wirksamen Betätigungsmittels in einem Detektionsbereich der Sensoreinrichtung sind aus dem Stand der Technik grundsätzlich bekannt, auch für Lenkräder von Fahrzeugen, insbesondere zum Erkennen einer menschlichen Hand in einem Greifbereich eines Lenkrads, auf welchen für nähere Informationen zur Funktionsweise und zu allgemeinen Anforderungen an die Ausgestaltung Einrichtungen verwiesen wird.

Die kapazitive Sensoreinrichtung einer erfindungsgemäßen Sensor- und Heizvorrichtung ist dabei insbesondere dazu ausgebildet und eingerichtet, eine kapazitive Kopplung des kombinierten Sensor- und Heizelements mit einer Umgebung des Sensor- und Heizelements und/oder mit einer Referenzelektrode, insbesondere mit einer Referenzelektrode, an welcher ein definiertes Potenzial anliegt, anlegbar ist oder angelegt wird, eine Änderung dieser kapazitiven Kopplung und/oder eine diese kapazitive Kopplung und/oder die Änderung dieser kapazitiven Kopplung charakterisierenden Größe zu erfassen und insbesondere auszuwerten. Das Erfassen der kapazitiven Kopplung beziehungsweise einer Änderung dieser ist dabei grundsätzlich auf verschiedene Arten möglich, insbesondere auf die üblichen, aus dem Stand der Technik allgemein bekannten Arten und Weisen, beispielsweise mit einer einfachen Spannungsmessung, einer Strommessung, mithilfe eines Schwingkreises oder mittels einer Impedanzmessung.

In einer möglichen Ausgestaltung kann die Erfassung der kapazitiven Kopplung bzw. der Änderung dieser mittels des sogenannten CVD-Verfahrens (Capacitive Voltage Divider-Verfahrens) erfolgen. Aus der erfassten kapazitiven Kopplung bzw. deren Änderung lässt sich schließen, ob sich ein kapazitives Betätigungsmittel im Detektionsbereich der Sensoreinrichtung befindet oder nicht. Alternativ dazu kann in einer anderen möglichen Ausgestaltung einer kombinierten Sensor- und Heizvorrichtung die Erfassung der kapazitiven Kopplung bzw. der Änderung dieser beispielsweise auch erfolgen, in dem an dem kombinierten Sensor- und Heizelement ein definiertes Spannungssignal angelegt wird, gleichzeitig der dabei entstehende Stromfluss gemessen wird und eine Phasenverschiebung zwischen dem Spannungssignal und dem Stromfluss ermittelt wird und aus der Phasenverschiebung, welche sich in Abhängigkeit von der kapazitiven Kopplung des Heiz- und Sensorelements mit der Umgebung und/oder einer Referenzelektrode einstellt, die Größe der kapazitiven Kopplung bzw. eine Änderung dieser bestimmt werden, beispielsweise mittels eines oder mehrerer ASICs (ASIC = anwendungsspezifischer IC), die speziell hierzu eingerichtet sind.

Die Sensoreinrichtung einer erfindungsgemäßen Sensor- und Heizvorrichtung ist besonders bevorzugt zum Erkennen einer Anwesenheit einer menschlichen Hand in einem Greifbereich eines Lenkrads ausgebildet, insbesondere zum Erkennen einer Annäherung und/oder einer Entfernung einer menschlichen Hand an das Lenkrad bzw. vom Lenkrad weg und/oder zum Erkennen einer Berührung des Lenkrads mit einer menschlichen Hand, insbesondere zum Erkennen einer Änderung einer Berührung des Lenkrads durch eine menschliche Hand, beispielsweise einer Positionsänderung einer Hand am Lenkrad.

Das kombinierte Sensor- und Heizelement einer erfindungsgemäßen kombinierten Sensor- und Heizvorrichtung ist dabei insbesondere dazu ausgebildet, mit einer Umgebung und/oder einer Referenzelektrode eine definierte Kapazität auszubilden, welche sich bei Anwesenheit eines kapazitiv wirksamen Betätigungsmittels im Detektionsbereich des Sensor- und Heizelements gegenüber einem Referenzzustand ändert, wobei die Änderung der Kapazität und damit die Änderung der kapazitiven Kopplung zwischen dem Sensor- und Heizelement und der Umgebung und/oder der Referenzelektrode insbesondere proportional zu einem Abstand des Betätigungsmittels zum Sensorelement ist.

Eine erfindungsgemäße Sensor- und Heizvorrichtung kann dabei ein kombiniertes Sensor- und Heizelement aufweisen oder mehrere kombinierte Sensor- und Heizelemente, welche vorzugsweise jeweils nach dem gleichen Prinzip mit einer zugehörigen Spanungsquelle verschaltet sind. Dies ermöglicht eine ortsaufgelöste Detektion und damit beispielsweise eine Unterscheidung, ob ein oder zwei Hände eines Fahrers eines Fahrzeugs an einem Lenkrad anliegen und/oder wo in einem Greifbereich eines Lenkrads ein Fahrer das Lenkrad greift.

Das kombinierte Sensor- und Heizelement ist besonders bevorzugt eine elektrisch leitfähige Struktur, welche einen oder mehrere elektrische Leiter aufweist, wobei im Fall von mehreren elektrischen Leitern diese insbesondere geeignet elektrisch miteinander gekoppelt sind, insbesondere geeignet miteinander kontaktiert und/oder verschaltet sind.

Ein kombiniertes Sensor- und Heizelement kann beispielsweise ein länglicher Draht- oder fadenähnlicher Leiter sein, welcher insbesondere um einen Kern eines Lenkradkranzes herum angeordnet werden kann, beispielsweise mäanderförmig. Das Sensor- und Heizelement kann dabei auf einem Trägerkörper angeordnet und/oder aufgebracht sein, beispielsweise aufgestickt und/oder aufgeklebt, oder in einen Trägerkörper eingearbeitet sein und beispielsweise in diesen eingewebt oder eingebettet sein oder dergleichen, vorzugsweise jeweils derart, dass sich das Sensor- und Heizelement über eine möglichst große Fläche erstreckt.

Wenigstens ein Sensor- und Heizelement kann auch eine Heizmatte sein, insbesondere ein Gewebe aus elektrischen Leitern oder dergleichen oder ein Gitter aus mehreren einzelnen Leitern, die gitterförmig angeordnet sind oder anordbar sind oder gitterförmig auf einem Träger angeordnet oder in einen Träger eingearbeitet sind.

Der erste Anschluss des kombinierten Sensor- und Heizelements ist dabei vorzugsweise ein Eingangsanschluss und der zweite Anschluss des Sensor- und Heizelements ist insbesondere ein Ausgangsanschluss.

Zum Betreiben der kombinierten Sensor- und Heizvorrichtung als Sensoreinrichtung und damit des kombinierten Sensor- und Heizelements als kapazitive Sensorelektrode kann das Sensor- und Heizelement vorzugsweise sowohl vom ersten Pol einer Spannungsquelle als auch vom zweiten Pol der Spannungsquelle elektrisch getrennt werden, insbesondere, indem wenigstens die erste Schalteinrichtung und die zweite Schalteinrichtung geöffnet werden, vorzugsweise jeweils gleichzeitig und/oder derart, dass sie zumindest zeitweise gleichzeitig geöffnet sind. Darüber hinaus können zusätzlich bevorzugt auch jeweils entlang des ersten elektrischen Pfades und/oder des zweiten elektrischen Pfades vorhandene Schalteinrichtungen geöffnet werden.

Eine "Schalteinrichtung" im Sinne der vorliegenden Erfindung ist eine Einrichtung, welche dazu ausgebildet ist, eine elektrische Verbindung zwischen zwei Komponenten einer elektrischen Schaltungsanordnung herzustellen oder elektrisch zu trennen, wobei in einem geöffneten Zustand der Schalteinrichtung die elektrische Verbindung getrennt ist und in einem geschlossenen Zustand der Schalteinrichtung die elektrische Verbindung hergestellt ist. Eine Schalteinrichtung kann dabei eine Baugruppe sein, welche mehrere elektronische Bauteile aufweist, insbesondere mehrere Schaltelemente, oder aber auch nur ein einzelnes Schaltelement, d. h. einen einzelnen Schalter, wobei ein Schaltelement beispielsweise ein Feldeffekttransistor sein kann.

Wenigstens eine Schalteinrichtung einer erfindungsgemäßen Sensor- und Heizvorrichtung ist eine elektronische Schalteinrichtung, d.h. keine mechanische Schalteinrichtung, und weist insbesondere wenigstens ein Halbleiterbauteil auf, wobei wenigstens eine Schalteinrichtung insbesondere von einer Steuerungseinrichtung ansteuerbar ist, vorzugsweise mittels wenigstens eines Steuersignals, wobei insbesondere wenigstens die erste Schalteinrichtung und/oder die zweite Schalteinrichtung elektronische Schalteinrichtungen sind, insbesondere sämtliche Schalteinrichtungen einer erfindungsgemäßen Sensor- und Heizvorrichtung.

In einer möglichen, insbesondere vorteilhaften Ausgestaltung einer kombinierten, kapazitiven Sensor- und Heizvorrichtung gemäß der vorliegenden Erfindung ist die kombinierte, kapazitive Sensor- und Heizvorrichtung, insbesondere die Heizeinrichtung, bevorzugt dazu ausgebildet und eingerichtet, eine Heizleistung gepulst abzugeben, insbesondere eine gewünschte Heizleistung, vorzugsweise in Abhängigkeit von einer Anforderung, wobei dazu vorzugsweise ein gepulster Stromfluss, insbesondere mit einer definierten, vorzugsweise konstanten Spannung, durch das wenigstens eine kombinierte Sensor- und Heizelement hindurchleitbar ist, wobei der gepulste Stromfluss insbesondere mittels einer Pulsweitenmodulation derart modulierbar ist, dass die gewünschte Heizleistung abgegeben wird, wobei besonders bevorzugt durch eine Änderung der Periodendauer, einer Pulsbreite und/oder eines Abstands zwischen den Pulsen eine mittlere abgegebene Heizleistung veränderbar ist. Dies ermöglicht auf einfache Art und Weise eine Anpassung der abgegebenen Heizleistung, beispielsweise in Abhängigkeit von einer Heizleistungsanforderung oder auf eine Heizleistungsanforderung hin.

Besonders bevorzugt kann eine Spannung dabei konstant gehalten werden, dies ist jedoch nicht zwingend, eine Veränderung der Spannung zur Veränderung der abgegebenen Heizleistung ist ebenfalls denkbar. Eine konstante Spannung ermöglicht jedoch eine besonders einfache Ausgestaltung einer Heizeinrichtung, insbesondere wenn die am ersten Pol der zugehörigen Spannungsquelle nicht in der Höhe moduliert werden muss.

In einer weiteren möglichen, insbesondere vorteilhaften Ausgestaltung einer kombinierten, kapazitiven Sensor- und Heizvorrichtung gemäß der vorliegenden Erfindung ist die kombinierte, kapazitive Sensor- und Heizvorrichtung, insbesondere die Sensoreinrichtung, insbesondere dazu ausgebildet und eingerichtet, einen Sensorbetrieb, insbesondere eine oder mehrere kapazitive Messungen zum Erkennen einer Anwesenheit eines kapazitiv wirksamen Betätigungsmittels in einem Detektionsbereich der Sensoreinrichtung und/oder eine Diagnose der Sensoreinrichtung, zumindest teilweise zwischen zwei Heizleistungspulsen auszuführen, insbesondere vollständig. Dies ermöglicht auf einfache Art und Weise eine wahlweise, zeitlich versetzte, jedoch im Ergebnis gemeinsame Nutzung des kombinierten Sensor- und Heizelements.

In einer weiteren möglichen, insbesondere vorteilhaften Ausgestaltung einer kombinierten, kapazitiven Sensor- und Heizvorrichtung gemäß der vorliegenden Erfindung ist der wenigstens eine weitere elektrische Pfad, über welchen die Synchronisierungseinrichtung eine Ist-Spannung und/oder einen Ist-Stromfluss im ersten elektrischen Pfad oder im zweiten elektrischen Pfad erfassen kann, über einen sich zwischen der ersten Schalteinrichtung und dem ersten Anschluss des kombinierten Sensor- und Heizelements entlang des ersten elektrischen Pfades befindenden Synchronisierungs-Anschlussknoten elektrisch mit dem ersten elektrischen Pfad verbunden oder verbindbar ist und/oder über einen sich zwischen dem zweiten Anschluss des kombinierten Sensor- und Heizelements und der zweiten Schalteinrichtung entlang des zweiten elektrischen Pfades befindenden Synchronisierungs-Anschlussknoten mit dem zweiten elektrischen Pfad.

Ein "Anschlussknoten" im Sinne der vorliegenden Erfindung ist insbesondere eine Leitungsabzweig oder eine Leitungsverzweigung einer elektrischen Leitung.

Dieser Aufbau, d.h. ein Abgriff nach wenigstens der ersten oder zweiten Schalteinrichtung im ersten oder zweiten elektrischen Pfad bzw. zwischen Schalteinrichtung und Anschluss des Sensor- und Heizelements, d.h. nicht unmittelbar nach dem jeweiligen Pol der Spannungsquelle, ermöglicht eine besonders vorteilhafte und einfache Erfassung eines Ist-Zustandes der Heizeinrichtung. Insbesondere ermöglicht dieser Aufbau neben einer Erfassung eines Stromflusses, welcher einen Rückschluss auf eine abgegebene Heizleistung ermöglicht (kein Stromfluss, keine Heizleistung, Erfassung von Strom und Spannung über Zeit = Heizleistung) insbesondere eine Erfassung eines allpoligen Abschaltens und/oder eines allpoliges Einschaltens zusätzlich zu einem Erfassen eines Aufbringens einer Heizleistung (Heizbetrieb) und/oder keiner aufgebrachten Heizleistung (Null-Leistung, aber ohne ein allpoliges Abschalten) sowie das Erfassen eines konstanten Heizbetriebs.

In einer weiteren möglichen, insbesondere vorteilhaften Ausgestaltung einer kombinierten, kapazitiven Sensor- und Heizvorrichtung gemäß der vorliegenden Erfindung weist die kombinierte Sensor- und Heizvorrichtung ferner besonders bevorzugt wenigstens eine Steuerungs- und Auswerteeinrichtung auf, insbesondere eine erste Steuerungs- und Auswerteinrichtung, die zur zumindest teilweisen Steuerung der Sensoreinrichtung der kombinierten, kapazitiven Sensor- und Heizvorrichtung eingerichtet ist, insbesondere zur Steuerung eines Betriebs des kombinierten Sensor- und Heizelementes als Sensorelement, und eine Steuerungs- und Auswerteeinrichtung, die zur zumindest teilweisen Steuerung der Heizeinrichtung der kombinierten, kapazitiven Sensor- und Heizvorrichtung eingerichtet ist, insbesondere eine zweite Steuerungs- und Auswertungseinrichtung, insbesondere zur Steuerung eines Betriebs des Sensor- und Heizelementes als Heizelement, wobei die zweite Steuerungs- und Auswerteinrichtung insbesondere separat von der ersten Steuerungs- und Auswertungseinrichtung ausgebildet ist.

Die getrennte Ausgestaltung von Heiz- und Sensorfunktion, insbesondere die Zuordnung zu separaten Steuerungseinrichtungen ermöglicht eine besonders flexible Systemarchitektur sowie eine Aufteilung der Komponenten einer erfindungsgemäßen Sensor- und Heizvorrichtung auf wenigstens zwei separate Baugruppen, insbesondere eine besonders vorteilhafte Aufteilung für eine Lenkeingabevorrichtungs-Baugruppe eines Fahrzeugs mit einem lenkradseitigen Teil und einem fahrzeugaufbauseitigen Teil. Die Synchronisierungseinrichtung ermöglicht auf einfache und besonders vorteilhafte Art und Weise einen synchronisierten Betrieb der separat ausgebildeten Steuerungs- und Auswerteinrichtungen und infolgedessen eine besonders effiziente Ausgestaltung einer erfindungsgemäßen, kombinierten Sensor- und Heizvorrichtung.

In einer weiteren möglichen, insbesondere vorteilhaften Ausgestaltung einer kombinierten, kapazitiven Sensor- und Heizvorrichtung gemäß der vorliegenden Erfindung ist die kombinierte Sensor- und Heizvorrichtung insbesondere zur Integration in eine Lenkeingabevorrichtungs-Baugruppe eines Kraftfahrzeugs mit einem lenkradseitigen Teil und einem fahrzeugaufbauseitigen Teil ausgebildet und eingerichtet, wobei die kombinierte Sensor- und Heizvorrichtung vorzugsweise eine erste Baugruppe aufweist, welche zur Integration im fahrzeugaufbauseitigen Teil einer Lenkeingabevorrichtungs-Baugruppe ausgebildet und eingerichtet ist, und insbesondere eine zweite Baugruppe, welche zur Integration im lenkradseitigen Teil einer Lenkeingabevorrichtungs-Baugruppe ausgebildet und eingerichtet ist, und wobei vorzugsweise einige Teile der kombinierten Sensor- und Heizvorrichtung der ersten Baugruppe zugeordnet sind und andere Teile der zweiten Baugruppe.

Eine "Baugruppe" im Sinne der vorliegenden Erfindung ist eine Gruppe von wenigstens zwei Bauteilen, insbesondere ein Zusammenbau aus wenigstens zwei Bauteilen.

Eine "Lenkeingabevorrichtungs-Baugruppe" im Sinne der vorliegenden Erfindung ist eine Baugruppe, welche wenigstens einen lenkradseitigen Teil aufweist mit wenigstens einem, zur lenkradseitigen Anordnung ausgebildeten Bauteil, sowie einem fahrzeugaufbauseitigen Teil mit wenigstens einem, zur fahrzeugaufbauseitigen, insbesondere lenksäulenseitigen, Anordnung ausgebildeten Bauteil, wobei in einem funktionsgemäßen Einbauzustand der Lenkeingabevorrichtungs-Baugruppe in einem Fahrzeug der lenkradseitige Teil der Lenkeingabevorrichtungs-Baugruppe insbesondere relativ gegenüber dem fahrzeugaufbauseitigen Teil bewegbar ist, insbesondere drehbar gegenüber dem fahrzeugaufbauseitigen Teil, insbesondere um eine Drehachse einer Lenkwelle. Der lenkradseitige Teil kann dabei auch eine oder mehrere, zur lenkradseitigen Anordnung ausgebildete Baugruppen aufweisen. Der fahrzeugaufbauseitige Teil kann entsprechend auch eine oder mehrere, zur fahrzeugaufbauseitigen Anordnung ausgebildet Baugruppen aufweisen. Eine Lenkeingabevorrichtung kann insbesondere ein Lenkrad sein oder Lenkhörnchen oder ein Joystick oder dergleichen.

Hierdurch kann eine Lenkeingabevorrichtungs-Baugruppe bereitgestellt werden, welche lenkradseitig nur wenige Komponenten erfordert. Durch die Aufteilung in wenigstens zwei Baugruppen kann eine Sensor- und Heizvorrichtung mit einer zweiten, zur Integration in einen lenkradseitigen Teil ausgebildeten Baugruppe bereitgestellt werden, welche im Vergleich zu einer Ausgestaltung mit nur einer, komplett in den lenkradseitigen Teil zu integrierenden Baugruppe einen geringeren, lenkradseitigen Bauraumbedarf aufweist aufgrund einer geringeren Anzahl an der zweiten Baugruppe zugeordneten Komponenten, welche aber dennoch eine hohe Erfassungsgenauigkeit ermöglicht. Die Aufteilung der einzelnen Komponenten in wenigstens zwei Baugruppen ermöglicht eine besonders vorteilhafte Integration einer erfindungsgemäßen Sensor- und Heizvorrichtung in eine Lenkeingabevorrichtungs-Baugruppe.

Eine derartige Ausgestaltung ermöglicht insbesondere eine Auslagerung einer Vielzahl an Komponenten in einen fahrzeugaufbauseitigen Teil. Hierdurch kann ein geringerer Bauraumbedarf des lenkradseitigen Teils erreicht werden.

In einer weiteren möglichen, insbesondere vorteilhaften Ausgestaltung einer kombinierten, kapazitiven Sensor- und Heizvorrichtung gemäß der vorliegenden Erfindung sind die erste Baugruppe und die zweite Baugruppe insbesondere über eine elektrische Verbindungseinrichtung elektrisch miteinander verbunden, insbesondere zur Signal- und/oder Energieübertragung, wobei die elektrische Verbindungseinrichtung insbesondere eine Wickelfeder aufweist oder eine Wickelfeder ist.

Die elektrische Verbindung von wenigstens zwei Schalteinrichtungen verschiedener Baugruppen über die elektrische Verbindungseinrichtung ermöglicht eine baugruppenübergreifende, gemeinsame Nutzung der Schalteinrichtungen sowohl für die Heizeinrichtung als auch für die Sensoreinrichtung.

Eine "Wickelfeder" im Sinne der vorliegenden Erfindung ist insbesondere eine elektrische Verbindungseinrichtung, welche dazu ausgebildet ist, ein zur fahrzeugaufbauseitigen Befestigung ausgebildetes Bauteil und/oder eine zur fahrzeugaufbauseitigen Befestigung ausgebildete Baugruppe, beispielsweise einen mit einer Lenkwelle drehfest verbindbaren Stator und/oder ein Lenksäulenmodul, mit einem zur lenkradseitigen Befestigung ausgebildeten Bauteil und/oder einer zur lenkradseitigen Befestigung ausgebildeten Baugruppe, beispielsweise mit einem, mit dem Lenkrad drehfest verbindbaren Rotor und/oder mit einem in ein Lenkrad integrierbares Lenkradmodul, elektrisch zu verbinden, insbesondere zur Signal- und/oder Energieübertragung, wobei das zur lenkradseitigen Befestigung ausgebildete Bauteil bzw. die zur lenkradseitigen Befestigung ausgebildete Baugruppe in einem funktionsgemäßen Einbauzustand in einem Fahrzeug relativ gegenüber dem zur fahrzeugaufbauseitigen Befestigung ausgebildeten Bauteil bzw. der zur fahrzeugaufbauseitigen Befestigung ausgebildeten Baugruppe beweglich ist, insbesondere drehbar, vorzugsweise um eine Drehachse einer Lenkwelle.

Eine Wickelfeder und damit eine elektrische Verbindungseinrichtung weist vorzugsweise ein oder mehrere elektrisch leitfähige und voneinander isolierte Leiterbahnen auf, welche in einer oder mehreren Ebenen angeordnet sein können, wobei eine Wickelfeder besonders bevorzugt ein Flachleiter mit einer oder mehreren Leiterbahnebenen sein kann, wobei die Wickelfeder besonders bevorzugt dazu ausgebildet ist, zumindest teilweise von einer sogenannten Wickelfeder-Kassette aufgenommen zu werden, insbesondere zumindest teilweise in einer Wickelfeder-Kassette aufgerollt zu werden. Wickelfeder und Wickelfeder Kassetten sind aus dem Stand der Technik grundsätzlich bekannt, auf welchen für nähere Ausführungen zur allgemeinen Funktionsweise und Ausgestaltung von Wickelfedern verwiesen wird.

Grundsätzlich ist jede beliebige Ausgestaltung der elektrischen Verbindungseinrichtung möglich, wobei die elektrische Verbindungseinrichtung jedoch besonders bevorzugt derart ausgebildet ist, dass die erste Baugruppe einer erfindungsgemäßen Sensor- und Heizvorrichtung mit der zweiten Baugruppe der Sensor- und Heizvorrichtung derart verbunden werden kann, dass die erfindungsgemäße Sensor- und Heizvorrichtung in eine Lenkeingabevorrichtungs-Baugruppe mit einem lenkradseitigen Teil und einem fahrzeugaufbauseitigen Teil integriert werden kann, wobei die erste Baugruppe insbesondere in den fahrzeugaufbauseitigen Teil integriert werden kann und die zweite Baugruppe in den lenkradseitigen Teil.

Bevorzugt ist die erste Baugruppe einer erfindungsgemäßen Sensor- und Heizvorrichtung dabei dazu ausgebildet und eingerichtet, in ein, insbesondere an einem Fahrzeugaufbau befestigbares, Lenksäulenmodul, insbesondere in ein sogenanntes "Top Column Modul (TCM)" integriert zu werden, d. h. zumindest teilweise in diesem angeordnet und/oder von diesem aufgenommen zu werden.

Die zweite Baugruppe einer erfindungsgemäßen Sensor- und Heizvorrichtung ist vorzugsweise dazu ausgebildet und eingerichtet, in ein Lenkrad eines Fahrzeugs integriert zu werden, wobei besonders bevorzugt das kombinierte Heiz- und Sensorelement dazu ausgebildet ist, in einen Lenkradkranz eines Lenkrads integriert und/oder eingebracht zu werden und wenigstens die jeweiligen Schalteinrichtungen der zweiten Baugruppe insbesondere zur Integration in ein Lenkradmodul ausgebildet und eingerichtet sind, wobei das Lenkradmodul besonders bevorzugt zur Anordnung und/oder Integration einem Lenkrad ausgebildet ist.

Das kombinierte Sensor- und Heizelement ist dabei vorzugsweise der zweiten Baugruppe zugeordnet. Die Steuerungs- und Auswerteeinrichtung, die zur zumindest teilweisen Steuerung der Sensoreinrichtung ausgebildet und eingerichtet ist, insbesondere die erste Steuerungs- und Auswerteinrichtung, ist vorzugsweise der zweiten Baugruppe zugeordnet. Vorzugsweise ist die Steuerungs- und Auswerteeinrichtung, die zur zumindest teilweisen Steuerung der Heizeinrichtung ausgebildet und eingerichtet ist, insbesondere die zweite Steuerungs- und Auswerteinrichtung, der ersten Baugruppe zugeordnet.

Vorzugsweise sind weitere Komponenten der Heizeinrichtung, beispielsweise leistungsrelevante Komponenten der Heizeinrichtung und/oder entsprechende Sicherheitseinrichtungen wie beispielsweise eine oder mehrere Überspannungsschutzeinrichtungen und/oder Verpolungsschutzreinrichtungen ebenfalls der ersten Baugruppe zugeordnet, insbesondere auch die erste Schalteinrichtung und/oder die zweite Schalteinrichtung.

Grundsätzlich ist jeweils aber auch eine Zuordnung zur jeweils anderen Baugruppe denkbar oder keine Aufteilung in Baugruppen.

In einer weiteren möglichen, insbesondere vorteilhaften Ausgestaltung einer kombinierten, kapazitiven Sensor- und Heizvorrichtung gemäß der vorliegenden Erfindung ist die Synchronisierungseinrichtung besonders bevorzugt Teil der zweiten Baugruppe, insbesondere wenn die Steuerungs- und Auswerteinrichtung zur Steuerung der Sensoreinrichtung (Sensor-Steuerungseinrichtung) Teil der zweiten Baugruppe ist. Hierdurch wird eine besonders effiziente Steuerung der Sensoreinrichtung möglich, da keine oder kaum Zeitverluste bei einer Kommunikation zwischen der Synchronisierungseinrichtung und der Sensor-Steuerungseinrichtung auftreten, da insbesondere keine baugruppenübergreifende Kommunikation erforderlich ist. Die Synchronisationseinrichtung kann auch in die Steuerungs- und Auswerteinrichtung zur Steuerung der Sensoreinrichtung integriert sein. Eine erfindungsgemäße Sensor- und Heizeinrichtung ist in diesem Fall besonders bevorzugt dazu ausgebildet, unmittelbar nach Eingang in die zweite Baugruppe und innerhalb der zweiten Baugruppe am jeweiligen, zugehörigen elektrischen Pfad, insbesondere unmittelbar nach der elektrischen Verbindungseinrichtung die Ist-Spannung und/oder einen Ist-Stromfluss und/oder einen entsprechenden -verlauf zu erfassen.

In einer weiteren möglichen, insbesondere vorteilhaften Ausgestaltung einer kombinierten, kapazitiven Sensor- und Heizvorrichtung gemäß der vorliegenden Erfindung ist vorzugsweise die Steuerungs- und Auswertungseinrichtung, die zur zumindest teilweisen Steuerung der der Heizeinrichtung ausgebildet ist (Heiz-Steuerungseinrichtung), zur Steuerung der ersten Schalteinrichtung und/oder der zweiten Schalteinrichtung ausgebildet, wobei die erste Schalteinrichtung und/oder die zweite Schalteinrichtung besonders bevorzugt ebenfalls Teile der ersten Baugruppe sind.

Besonders bevorzugt sind die Steuerungseinrichtungen, insbesondere die erste Steuerungseinrichtung und die zweite Steuerungseinrichtung, dabei ebenfalls über die elektrische Verbindungseinrichtung elektrisch miteinander verbunden, insbesondere zur Signal- und/oder Energieübertragung, wobei besonders bevorzugt zur Signalübertragung wenigstens eine von einer Energieübertragungsleitungen getrennte Signalübertragungsleitung vorgesehen ist, wobei insbesondere jeweils getrennte Signalübertragungs- und/oder Energieübertragungsleitungen vorgesehen sein können.

Hierdurch lässt sich eine vorteilhafte Architektur einer erfindungsgemäßen Sensor- und Heizvorrichtung erreichen, insbesondere ein einfacher und kostengünstiger Aufbau. Dies ermöglicht vor allem, dass die Lastpfade zur Energieübertragung an das kombinierte Heiz- und Sensorelement, welche zur Übertragung hoher Ströme ausgelegt sein müssen, von den Pfaden zur Signalübertragung und den Pfaden zur Energieversorgung, beispielsweise einer der zweiten Baugruppe zugeordneten Steuerungseinrichtung, über welche im Verhältnis nur geringe Ströme übertragen werden müssen, getrennt werden können. Dies ermöglicht eine einfache Absicherung, beispielsweise gegenüber Überlastung, insbesondere von der geringer belasteten Baugruppe mit geringer dimensionierten Bauteilen, wodurch sich ein Kostenvorteil erreichen lässt.

Zur Kommunikation der Steuerungseinrichtungen können die Steuerungseinrichtungen, insbesondere zusätzlich, über einen Bus gekoppelt sein, insbesondere über einen LIN-Bus, einen CAN-Bus oder einen FlexRay-Bus. Besonders bevorzugt kann die zweite Baugruppe, insbesondere die zweite Steuerungseinrichtung, nur über die elektrische Verbindungseinrichtung und die erste Baugruppe, mit einer oder mehreren weiteren Komponenten kommunikationsverbunden werden, beispielsweise mit einem am Fahrzeugaufbau befestigten Steuergerät. Grundsätzlich ist aber auch eine direkte Anbindung der zweiten Baugruppe möglich, d.h. ohne ein Durchschleifen der Signal-und/oder Energie-Übertragungspfade durch die erste Baugruppe.

In einer weiteren möglichen, insbesondere vorteilhaften Ausgestaltung einer kombinierten, kapazitiven Sensor- und Heizvorrichtung gemäß der vorliegenden Erfindung können im ersten elektrischen Pfad und/oder im zweiten elektrischen Pfad jeweils mehr als eine Schalteinrichtung in Reihe geschaltet sein. Hierdurch kann die Messgenauigkeit der Sensoreinrichtung deutlich verbessert werden. Insbesondere können mittels zusätzlichen, jeweils mit der ersten bzw. zweiten Schalteinrichtungen in Reihe geschalteten Schalteinrichtungen Störeffekte infolge auftretender parasitärer Kapazitäten reduziert werden, was im Folgenden noch näher erläutert wird.

Vorzugsweise ist im ersten elektrischen Pfad wenigstens eine dritte Schalteinrichtung mit der ersten Schalteinrichtung in Reihe geschaltet und/oder eine vierte Schalteinrichtung mit der zweiten Schalteinrichtung, wobei, sofern vorhanden, die dritte Schalteinrichtung insbesondere zwischen der ersten Schalteinrichtung und dem ersten Anschluss des kombinierten Sensor- und Heizelements angeordnet ist und die vierte Schalteinrichtung, sofern vorhanden, insbesondere zwischen dem zweiten Anschluss des kombinierten Sensor- und Heizelements und der zweiten Schalteinrichtung, wobei vorzugsweise, wenn die erste Schalteinrichtung und die dritte Schalteinrichtung jeweils Teile der ersten Baugruppe sind und die dritte Schalteinrichtung und die vierte Schalteinrichtung jeweils Teile der zweiten Baugruppe sind, die erste und die zweite Baugruppe der kombinierten Sensor- und Heizvorrichtung derart über die elektrische Verbindungseinrichtung miteinander elektrisch verbunden sind, dass die erste Schalteinrichtung und die mit dieser in Reihe geschaltete, dritte Schalteinrichtung zur Signal- und/oder Energieübertragung elektrisch miteinander verbunden sind, und die zweite Schalteinrichtung und die mit dieser in Reihe geschaltete, vierte Schalteinrichtung zur Signal- und/oder Energieübertragung elektrisch miteinander verbunden sind.

In einer weiteren vorteilhaften Ausgestaltung einer Sensor- und Heizvorrichtung gemäß der vorliegenden Erfindung kann die kombinierte, kapazitive Sensor- und Heizvorrichtung insbesondere einen ersten Sensor-Anschlussknoten aufweisen, insbesondere einen zwischen der dritten Schalteinrichtung und dem ersten Anschluss des kombinierten Heiz- und Sensorelements angeordneten ersten Sensor-Anschlussknoten, der mit dem ersten Anschluss des kombinierten Heiz- und Sensorelements elektrisch verbunden ist.

Ferner kann wenigstens eine Steuerungseinrichtung, vorzugsweise die zur zumindest teilweisen Steuerung einer Sensorfunktion eingerichtete Steuerungseinrichtung, dazu ausgebildet und eingerichtet sein, zur Erkennung einer Anwesenheit eines kapazitiv wirksamen Betätigungsmittels in einem Detektionsbereich der Sensoreinrichtung am ersten Sensor-Anschlussknoten ein definiertes Eingangs-Messsignal einzuspeisen und/oder ein Ausgangs-Messsignal abzugreifen und insbesondere auszuwerten, wobei die Steuerungseinrichtung dazu vorzugsweise wenigstens einen Ausgang und/oder Eingang aufweist, der über den ersten Sensor-Anschlussknoten mit dem ersten Anschluss des kombinierten Heiz- und Sensorelements elektrisch verbunden oder verbindbar ist. Dies ermöglicht eine besonders einfache und vorteilhafte Erfassung einer kapazitiven Kopplung des Heiz- und Sensorelements mit der Umgebung und/oder einer Referenzelektrode bzw. einer Änderung dieser zur Erkennung einer Anwesenheit eines kapazitiv wirksamen Betätigungsmittels im Bereich des Lenkrades.

In einer weiteren vorteilhafte Ausgestaltung einer Sensor- und Heizvorrichtung gemäß der vorliegenden Erfindung kann die kombinierte, kapazitive Sensor- und Heizvorrichtung ferner insbesondere einen zweiten Sensor-Anschlussknoten aufweisen, insbesondere einen zwischen dem zweiten Anschluss des kombinierten Heiz- und Sensorelements und der vierten Schalteinrichtung angeordneten zweiten Sensor-Anschlussknoten, der mit dem zweiten Anschluss des kombinierten Heiz- und Sensorelements elektrisch verbunden ist, wobei insbesondere wenigstens eine Steuerungseinrichtung, vorzugsweise die zur zumindest teilweisen Steuerung einer Sensorfunktion eingerichtete Steuerungseinrichtung, dazu ausgebildet und eingerichtet ist, zur Erkennung einer Anwesenheit eines kapazitiv wirksamen Betätigungsmittels im Bereich des Lenkrades am zweiten Sensor-Anschlussknoten ein definiertes Eingangs-Messsignal einzuspeisen und/oder ein Ausgangs-Messsignal abzugreifen und insbesondere auszuwerten, wobei die Steuerungseinrichtung dazu vorzugsweise wenigstens einen Eingang und/oder Ausgang aufweist, der über den zweiten Sensor-Anschlussknoten mit dem zweiten Anschluss des kombinierten Heiz- und Sensorelements elektrisch verbunden oder verbindbar ist.

Hierdurch kann beispielsweise über den ersten Sensor-Anschlussknoten an dem kombinierten Heiz- und Sensorelement ein definiertes Spannungssignal angelegt werden, gleichzeitig der dabei entstehende Stromfluss gemessen werden und eine Phasenverschiebung zwischen dem Spannungssignal und dem Stromfluss ermittelt werden und aus der Phasenverschiebung, welche sich in Abhängigkeit von der kapazitiven Kopplung des Heiz- und Sensorelements mit der Umgebung und/oder einer Referenzelektrode einstellt, die Größe der kapazitiven Kopplung bzw. eine Änderung dieser bestimmt werden, beispielsweise mittels eines oder mehrerer ASICs (ASIC = anwendungsspezifischer IC), die speziell hierzu eingerichtet sind.

Durch einen Vergleich der am ersten Sensor-Anschlussknoten und der am zweiten Sensor-Anschlussknoten ermittelten Ergebnisse lässt sich die kapazitive Kopplung des Heiz-und Sensorelementes mit der Umgebung und/oder einer Referenzelektrode bzw. eine Änderung dieser plausibilisieren, insbesondere auf übliche und grundsätzlich aus dem Stand der Technik bekannte Art und Weise.

Die Schalteinrichtungen erzeugen jeweils parasitäre Kapazitäten (bzw. diese sind vielmehr technisch bedingt stets vorhanden), über welche beim Betrieb der kombinierten Sensor- und Heizvorrichtung als Sensoreinrichtung jeweils ein Anteil eines während einer Erfassung einer kapazitiven Kopplung des Heiz- und Sensorelements mit der Umgebung und/oder einer Referenzelektrode aufgebrachten Eingangs-Messsignals, welches insbesondere zwischen der ersten Schalteinrichtung und dem ersten Anschluss des Heiz-und Sensorelements und/oder zwischen dem zweiten Anschluss des Heiz- und Sensorelements und der zweiten Schalteinrichtung aufgebracht wird, abfließen kann, wodurch das erfasste Ausgangs-Messsignal und damit eine erfasste kapazitive Kopplung des Heiz- und Sensorelements mit der Umgebung und/oder einer Referenzelektrode unerwünscht verfälscht werden kann.

Dem Abfluss eines Anteils eines zwischen der ersten Schalteinrichtung und dem ersten Anschluss des Heiz- und Sensorelements aufgebrachten Eingangs-Messsignals kann insbesondere durch die zusätzliche dritte Schalteinrichtung entgegengewirkt werden, welche zwischen dem ersten Anschluss des Heiz- und Sensorelements und der ersten Schalteinrichtung mit der ersten Schalteinrichtung in Reihe geschaltet sein kann, vorzugsweise indem während eines Sensorbetriebs, insbesondere während einer kapazitiven Messung, beide (die erste und die dritte Schalteinrichtung) geöffnet werden und zwischen der ersten Schalteinrichtung und der dritten Schalteinrichtung, insbesondere an einem dritten Sensor-Anschlussknoten, ein Kompensationssignal angelegt und oder eingespeist wird, wobei das Kompensationssignal insbesondere dem Eingangs-Messsignal entspricht und vorzugsweise identisch zu diesem ist und/oder zusätzlich einen entsprechenden Kompensationsanteil aufweist. Dadurch kann ein Abfluss eines Anteils eines aufgebrachten Eingangs-Messignals und/oder eines Kompensationssignals in Richtung des ersten Pols erheblich reduziert werden, wodurch der Einfluss der durch die Schalteinrichtung verursachten parasitären Kapazität reduziert werden kann, wenn auch nicht ganz nicht kompensiert werden. Es lässt sich jedoch eine höhere Erfassungsgenauigkeit der Sensoreinrichtung erreichen.

Dem Abfluss eines Anteils eines zwischen dem zweiten Anschluss des Heiz- und Sensorelements und der zweiten Schalteinrichtung aufgebrachten Eingangs-Messignals kann insbesondere durch die zusätzliche vierte Schalteinrichtung entgegengewirkt werden, die zwischen dem zweiten Anschluss des Heiz- und Sensorelements mit der zweiten Schalteinrichtung in Reihe geschaltet sein kann, indem diese vorzugsweise während eines Sensorbetriebs, insbesondere während einer kapazitiven Messung, geöffnet werden (die zweite und die vierte Schalteinrichtung) und zwischen der vierten Schalteinrichtung und der zweiten Schalteinrichtung, insbesondere an einem vierten Sensor-Anschlussknoten, ein Kompensationssignal angelegt und oder eingespeist wird, wobei das Kompensationssignal insbesondere dem Eingangs-Messsignal entspricht und vorzugsweise identisch zu diesem ist und/oder zusätzlich einen entsprechenden Kompensationsanteil aufweist. Dadurch kann ein Abfluss eines Anteils eines Eingangs-Messignals und/oder eines Kompensationssignals in Richtung des zweiten Pols erheblich reduziert werden, wodurch der Einfluss der durch die Schalteinrichtungen verursachten parasitären Kapazität reduziert werden kann, wenn auch nicht ganz nicht kompensiert werden. Es lässt sich jedoch eine höhere Erfassungsgenauigkeit der Sensoreinrichtung erreichen.

Die in Reihe zu der ersten Schalteinrichtung beziehungsweise zu der zweiten Schalteinrichtung jeweils zusätzlich vorhandene dritte Schalteinrichtung bzw. vierte Schalteinrichtung ermöglicht das Beaufschlagen des Stromkreises mit einem Kompensationssignal, insbesondere das Anlegen und/oder Einspeisen eines Kompensationssignals zwischen zwei Schalteinrichtungen, insbesondere zwischen der ersten und der dritten Schalteinrichtung sowie zwischen der vierten Schalteinrichtung und der zweiten Schalteinrichtung, ohne dass das Kompensationssignal über den jeweiligen, zugehörigen Pol unmittelbar ausgeglichen wird, wenn die zusätzliche Schalteinrichtung beim Betrieb der Sensoreinrichtung geöffnet wird, sodass durch das Kompensationssignal ein ansonsten an der dritten bzw. vierten Schalteinrichtung anliegendes Potentialungleichgewicht ausgeglichen werden kann. Je kleiner das Potentialungleichgewicht an einer Schalteinrichtung ist, desto kleiner ist der Einfluss der von dieser verursachten, parasitären Kapazität.

Um die vorstehend beschriebene, zumindest teilweise Kompensation parasitärer Kapazitäten zu ermöglichen, weist in einer weiteren vorteilhaften Ausgestaltung einer Sensor- und Heizvorrichtung gemäß der vorliegenden Erfindung die Sensor- und Heizvorrichtung daher insbesondere neben der dritten Schalteinrichtung ferner vorzugsweise einen zwischen der ersten Schalteinrichtung und der dritten Schalteinrichtung angeordneten, weiteren Sensor-Anschlussknoten auf, insbesondere einen dritten Sensor-Anschlussknoten, der über die dritte Schalteinrichtung mit dem ersten Anschluss des kombinierten Heiz- und Sensorelements elektrisch verbindbar ist, und/oder einen zwischen der vierten Schalteinrichtung und der zweiten Schalteinrichtung angeordneten, weiteren Sensor-Anschlussknoten, insbesondere einen vierten Sensor-Anschlussknoten, der über die vierte Schalteinrichtung mit dem zweiten Anschluss des kombinierten Heiz- und Sensorelements elektrisch verbindbar ist, wobei wenigstens eine Steuerungseinrichtung, vorzugsweise die zur zumindest teilweisen Steuerung einer Sensorfunktion eingerichtete Steuerungseinrichtung, dazu ausgebildet und eingerichtet ist, an diesem Sensor-Anschlussknoten ein Kompensationssignal anzulegen, vorzugsweise ein Kompensationssignal, welches dem Eingangs-Messignal entspricht, wobei die Steuerungseinrichtung dazu vorzugsweise wenigstens einen Ausgang aufweist, der mit dem weiteren Sensor-Anschlussknoten elektrisch verbunden oder verbindbar ist. Der dritte Sensor-Anschlussknoten und der vierte Sensor-Anschlussknoten können dabei mit demselben Ausgang einer zugehörigen Steuerungseinrichtung elektrisch verbunden oder verbindbar sein oder aber auch mit unterschiedlichen Ausgängen.

Der weitere Sensor-Anschlussknoten, insbesondere der dritte Sensor-Anschlussknoten und/oder der vierte Sensor-Anschlussknoten, ist dabei bevorzugt jeweils der zweiten Baugruppe zugeordnet, und insbesondere zwischen der elektrischen Verbindungseinrichtung, über welche die erste Schalteinrichtung und die dritte Schalteinrichtung elektrisch miteinander verbunden sind, und der dritten bzw. vierten Schalteinrichtung angeordnet. Eine derartige Ausgestaltung einer erfindungsgemäßen Sensor- und Heizvorrichtung ermöglicht auf besonders einfache Art und Weise eine zumindest teilweise Kompensation parasitärer Kapazitäten.

In einer vorteilhaften Ausgestaltung einer erfindungsgemäßen kombinierten, kapazitiven Sensor- und Heizvorrichtung ist die erste Schalteinrichtung vorzugsweise eine sogenannte High-Side-Schalteinrichtung (HSS), insbesondere die einzige High-Side-Schalteinrichtung zur Verbindung des kombinierten Heiz- und Sensorelements mit dem ersten Pol einer Spannungsquelle, wobei wenigstens die erste Schalteinrichtung und/oder die dritte Schalteinrichtung besonders bevorzugt als sogenannte P-MOS-Schalteinrichtung ausgebildet ist. Alternativ können die erste Schalteinrichtung und/oder die dritte Schalteinrichtung grundsätzlich aber auch als eine sogenannte N-MOS-Schalteinrichtung ausgebildet sein, eine geeignete Kontaktierung vorausgesetzt.

In einer weiteren vorteilhaften Ausgestaltung einer erfindungsgemäßen kombinierten, kapazitiven Sensor- und Heizvorrichtung ist die zweite Schalteinrichtung vorzugsweise eine sogenannte Low-Side-Schalteinrichtung (LSS), insbesondere die einzige Low-Side-Schalteinrichtung zur Verbindung des kombinierten Heiz- und Sensorelements mit dem zweiten Pol der Spannungsquelle, wobei die zweite Schalteinrichtung und/oder die vierte Schalteinrichtung besonders bevorzugt als sogenannte N-MOS-Schalteinrichtung ausgebildet ist. Alternativ können die zweite Schalteinrichtung und/oder die vierte Schalteinrichtung grundsätzlich aber auch als eine sogenannte P-MOS-Schalteinrichtung ausgebildet sein, eine geeignete Kontaktierung vorausgesetzt.

High-Side-Schalteinrichtungen (HS-Schalteinrichtungen), Low-Side-Schalteinrichtungen (LS-Schalteinrichtungen), P-MOS- und N-MOS-Schalteinrichtungen sind aus dem Stand der Technik grundsätzlich bekannt, wobei in einer Schaltungsbaugruppe mit einer Gleichspannungsquelle als High-Side-Schalteinrichtung insbesondere diejenige Schalteinrichtung bezeichnet wird, welche dem Pol einer Spannungsquelle am nächsten ist, an dem das höhere Potential anliegt, während in einer Schaltungsbaugruppe mit einer Gleichspannungsquelle insbesondere diejenige Schalteinrichtung eine Low-Side-Schalteinrichtung ist, die dem Pol mit dem niedrigeren Potential am nächsten ist.

N-MOS- und P-MOS-Schalteinrichtungen sind jeweils spezielle, grundsätzlich aus dem Stand bekannte Schalteinrichtungen mit wenigstens einem Halbleiterbauelement, insbesondere mit wenigstens einem Transistor, insbesondere mit wenigstens einem MOS-FET (Metal Oxide Semiconductor-Feldeffektransistor (FET)), wobei ein P-MOS-Transistor ein sogenannter p-Kanal-MOS-FET ist und ein N-MOS-Transistor ein sogenannter n-Kanal-MOS-FET ist.

Um einen entsprechenden Verpolungsschutz zu ermöglichen, kann eine erfindungsgemäße Sensor- und Heizvorrichtung ferner eine Verpolungsschutzeinrichtung aufweisen, wobei die Verpolungsschutzeinrichtung bevorzugt der ersten Baugruppe zugeordnet ist und insbesondere mit der zweiten Schalteinrichtung auf der vom zweiten Anschluss des Heiz- und Sensorelements abgewandten Anschlussseite der zweiten Schalteinrichtung in Reihe geschaltet ist. Durch die erfindungsgemäße Reihenschaltung zur elektrischen Verbindung der beiden Baugruppen, wobei die zweite Baugruppe besonders bevorzugt nur über die erste Baugruppe und die elektrische Verbindungseinrichtung signal- und/ energieversorgt wird, ist in vielen Fällen eine einzige Verpolungsschutzeinrichtung ausreichend.

In einer weiteren vorteilhaften Ausgestaltung einer Sensor- und Heizvorrichtung gemäß der vorliegenden Erfindung weist die kombinierte Sensor- und Heizvorrichtung ferner eine zwischen der ersten Schalteinrichtung und der dritten Schalteinrichtung angeordnete und mit der ersten Schalteinrichtung und der dritten Schalteinrichtung in Reihe geschaltete, weitere, insbesondere fünfte, Schalteinrichtung auf, wobei diese weitere Schalteinrichtung vorzugsweise ebenfalls Teil der zweiten Baugruppe ist und besonders bevorzugt insbesondere ebenfalls eine P-MOS-Schalteinrichtung ist. Denkbar ist aber auch eine als N-MOS ausgebildete fünfte Schalteinrichtung.

Diese weitere, insbesondere fünfte Schalteinrichtung ist dabei vorzugsweise zwischen der elektrischen Verbindungseinrichtung, über welche der die erste Schalteinrichtung und die dritte Schalteinrichtung elektrisch miteinander verbunden sind, insbesondere zwischen der elektrischen Verbindungseinrichtung und einem zugehörigen Sensor-Anschlussknoten, insbesondere dem dritten Sensor-Anschlussknoten, angeordnet und besonders bevorzugt von wenigstens einer Steuerungseinrichtung ansteuerbar, vorzugsweise von einer zur zumindest teilweisen Steuerung der Sensoreinrichtung eingerichteten Steuerungseinrichtung, insbesondere von der zweiten Steuerungseinrichtung. Diese fünfte Schalteinrichtung ermöglicht eine weitere Verbesserung der Erfassungsgenauigkeit einer erfindungsgemäßen Sensor- und Heizvorrichtung, da diese eine Entkopplung von unerwünschten Potenzialschwankungen am ersten Pol ermöglicht, welche jeweils mit einer Änderung der kapazitiven Kopplung des kombinierten Heiz- und Sensorelements mit der Umgebung und oder einer Referenzelektrode einhergehen und ebenfalls zu einer Verfälschung der erfassten kapazitiven Kopplung bzw. einer Änderung dieser führen können.

In einer weiteren vorteilhaften Ausgestaltung einer Sensor- und Heizvorrichtung gemäß der vorliegenden Erfindung weist die Sensor- und Heizvorrichtung ferner eine zwischen der vierten Schalteinrichtung und der zweiten Schalteinrichtung angeordnete und mit der vierten Schalteinrichtung und der zweiten Schalteinrichtung in Reihe geschaltete, weitere, insbesondere sechste, Schalteinrichtung auf, wobei diese weitere Schalteinrichtung vorzugsweise ebenfalls Teil der zweiten Baugruppe ist und besonders bevorzugt insbesondere ebenfalls eine N-MOS-Schalteinrichtung ist. Denkbar ist aber auch eine als P-MOS ausgebildete sechste Schalteinrichtung.

Diese weitere, insbesondere sechste Schalteinrichtung ist dabei vorzugsweise zwischen der elektrischen Verbindungseinrichtung, über welche der die vierte Schalteinrichtung und die zweite Schalteinrichtung elektrisch miteinander verbunden sind, insbesondere zwischen der elektrischen Verbindungseinrichtung und einem zugehörigen Sensor-Anschlussknoten, insbesondere dem vierten Sensor-Anschlussknoten, angeordnet und besonders bevorzugt von wenigstens einer Steuerungseinrichtung ansteuerbar, vorzugsweise von einer zur zumindest teilweisen Steuerung der Sensoreinrichtung eingerichteten Steuerungseinrichtung, insbesondere von der zweiten Steuerungseinrichtung. Diese sechste Schalteinrichtung ermöglicht eine weitere Verbesserung der Erfassungsgenauigkeit einer erfindungsgemäßen Sensor- und Heizvorrichtung, insbesondere eine Entkopplung von unerwünschten Potenzialschwankungen am zweiten Pol, welche jeweils mit einer Änderung der kapazitiven Kopplung des kombinierten Heiz- und Sensorelements mit der Umgebung und oder einer Referenzelektrode einhergehen und ebenfalls zu einer Verfälschung der erfassten kapazitiven Kopplung bzw. einer Änderung dieser führen können.

In einer weiteren vorteilhaften Ausgestaltung einer Sensor- und Heizvorrichtung gemäß der vorliegenden Erfindung, welche insbesondere wenigstens eine weitere Schalteinrichtung aufweist, insbesondere eine fünfte Schalteinrichtung und/oder eine sechste Schalteinrichtung, weist die Sensor- und Heizvorrichtung ferner einen zwischen der fünften Schalteinrichtung und der ersten Schalteinrichtung angeordneten, weiteren, insbesondere fünften, Sensor-Anschlussknoten auf, der über die fünfte Schalteinrichtung und die dritte Schalteinrichtung mit dem ersten Anschluss des kombinierten Heiz- und Sensorelements elektrisch verbindbar ist, und/oder einen zwischen einer sechsten Schalteinrichtung und der zweiten Schalteinrichtung angeordneten und/oder einen zwischen der zweiten Schalteinrichtung und dem zweiten Pol angeordneten, weiteren, insbesondere sechsten, Sensor-Anschlussknoten, der über die sechste Schalteinrichtung und die vierte Schalteinrichtung mit dem zweiten Anschluss des kombinierten Heiz- und Sensorelements elektrisch verbindbar ist, wobei wenigstens eine Steuerungseinrichtung, insbesondere die zweite Steuerungseinrichtung, dazu ausgebildet und eingerichtet ist, an diesem Sensor-Anschlussknoten ein definiertes Stabilisierungspotential anzulegen, beispielsweise +5V oder dergleichen, vorzugsweise jedoch ein Nullpotential, d. h. Masse (0V), wobei die Steuerungseinrichtung dazu vorzugsweise wenigstens einen Ausgang aufweist, der mit dem weiteren Sensor-Anschlussknoten elektrisch verbunden oder verbindbar ist, insbesondere über wenigstens eine weitere Schalteinrichtung, insbesondere über eine siebte Schalteinrichtung oder eine achte Schalteinrichtung, wobei der fünfte Sensor-Anschlussknoten insbesondere über eine siebte Schalteinrichtung mit der Steuerungseinrichtung elektrisch verbunden oder verbindbar ist und der sechste Sensor-Anschlussknoten über eine achte Schalteinrichtung. Der fünfte Sensor-Anschlussknoten und der sechste Sensor-Anschlussknoten können dabei mit demselben Ausgang einer zugehörigen Steuerungseinrichtung elektrisch verbunden oder verbindbar sein oder aber auch mit unterschiedlichen Ausgängen. Ein Stabilisierungspotential, das am fünften Sensor-Anschlussknoten angelegt wird und ein Stabilisierungspotential, das am sechsten Sensor-Anschlussknoten angelegt wird, sind besonders bevorzugt gleich, um einen besonders guten Stabilisierungseffekt zu erreichen.

Die siebte Schalteinrichtung und/oder die achte Schalteinrichtung können zum Betrieb der Sensor- und Heizvorrichtung als Sensoreinrichtung insbesondere jeweils geschlossen werden und zum Betrieb der Sensor- und Heizvorrichtung als Heizeinrichtung vorzugsweise jeweils geöffnet werden, wobei die siebte Schalteinrichtung und/oder die achte Schalteinrichtung beim Betrieb der Sensor- und Heizvorrichtung als Heizeinrichtung besonders bevorzugt stets geöffnet werden und besonders bevorzugt beim Betrieb der Sensor- und Heizvorrichtung als Sensoreinrichtung stets geschlossen werden.

Eine derartige Ausgestaltung einer erfindungsgemäßen Sensor- und Heizvorrichtung ermöglicht das Anlegen eines definierten Stabilisierungspotentials am fünften und/oder sechsten Sensor-Anschlussknoten, wodurch die kapazitive Kopplung des kombinierten Heiz- und Sensorelements mit der Umgebung und/oder einer Referenzelektrode stabilisiert werden kann, insbesondere auf einem definierten Referenzniveau eingestellt werden kann. Dadurch kann die Größe der kapazitiven Kopplung von der tatsächlich an der Spannungsquelle anliegenden Betriebsspannung entkoppelt werden, so dass Betriebsspannungsschwankungen nicht mehr zu einer Änderung der kapazitiven Kopplung führen, wodurch die Erfassungsgenauigkeit der Sensoreinrichtung verbessert werden kann. Wird als Stabilisierungspotential ein Nullpotential gewählt, können die achte Schalteinrichtung, der sechste Sensor-Anschlussknoten und die sechste Schalteinrichtung entfallen, wobei in diesem Fall am fünften Sensor-Anschlussknoten ebenfalls ein Nullpotential als Stabilisierungspotential angelegt werden muss. Dies ermöglicht die Bereitstellung einer besonders einfachen und kostengünstigen Ausgestaltung einer erfindungsgemäßen Sensor-und Heizvorrichtung mit einer hohen Erfassungsgenauigkeit.

Ist die Synchronisierungseinrichtung Teil der Steuerungseinrichtung, die zur zumindest teilweisen Steuerung einer Sensorfunktion eingerichtet ist, kann wenigstens ein Synchronisierungs-Anschlussknoten mit einem Sensor-Anschlussknoten zusammenfallen. Somit ist kein zusätzlicher elektrischer Pfad, insbesondere keine zusätzliche elektrische Verbindungsleitung und/oder ein zusätzlicher elektrischer Pfad erforderlich, wobei der Synchronisierungs-Anschlussknoten vorzugsweise mit dem dritten, vierten, fünften oder sechsten Sensor-Anschlussknoten zusammenfällt, sofern vorhanden, besonders bevorzugt mit dem fünften oder sechsten Sensor-Anschlussknoten, um möglichst unmittelbar nah bei der ersten Schalteinrichtung bzw. der zweiten Schalteinrichtung den Ist-Zustand der Heizeinrichtung erfassen zu können.

Grundsätzlich kann der Abgriff des Ist-Zustandes der Heizeinrichtung am ersten elektrischen Pfad und/oder am zweiten elektrischen Pfad aber auch über einen oder mehrere separate Synchronisierungs-Anschlussknoten und entsprechende separate, weitere elektrische Pfade erfolgen.

Ein separater Abgriff, d.h. über einen oder mehrere separate Synchronisierungs-Anschlussknoten hat den Vorteil, dass prinzipiell auch während einer kapazitiven Messung, d.h. während eines Messbetrieb bzw. eines Sensorbetriebs eine Erfassung des Ist-Zustands der Heizeinrichtung möglich ist, während eine Nutzung eines oder mehrerer der Sensor-Anschlussknoten dies nicht zulässt, da diese während einer kapazitiven Messung zum Einspeisen eines Eingangs-Messignals, zum Abgreifen eines Ausgangs-Messignals, zum Anlegen eines Kompensationssignals und/oder eines Stabilisierungspotenzials benötigt werden.

In einer weiteren möglichen, insbesondere vorteilhaften Ausgestaltung einer kombinierten, kapazitiven Sensor- und Heizvorrichtung gemäß der vorliegenden Erfindung ist die Synchronisierungseinrichtung besonders bevorzugt dazu ausgebildet und eingerichtet, in Abhängigkeit von der erfassten Ist-Spannung, insbesondere in Abhängigkeit von dem erfassten Ist-Spannungsverlauf über der Zeit, und/oder in Abhängigkeit von dem erfassten Ist-Stromfluss, insbesondere in Abhängigkeit von dem erfassten Ist-Stromfluss über der Zeit, wenigstens einen Einschaltzustand und/oder einen Heiz-Zustand und/oder einen Abschaltzustand und/oder einen Aus-Zustand als Ist-Zustand der Heizeinrichtung zu erkennen.

Die Synchronisierungseinrichtung ist dabei vorzugsweise derart ausgebildet und eingerichtet ist, dass ein Einschalt-Zustand als aktueller Ist-Zustand der Heizeinrichtung erkannt wird, wenn eine steigende Ist-Spannung und/oder ein steigender Ist-Spannungsverlauf und/oder ein steigender Ist-Stromfluss oder ein steigender Ist-Stromflussverlauf erfasst wird, insbesondere eine steigende Flanke eines Heizleistungspulses.

Bevorzugt wird hingegen ein Heiz-Zustand als aktueller Ist-Zustand der Heizeinrichtung erkannt, wenn eine von einer Nullspannung (0V) verschiedene, konstante Ist-Spannung und/oder ein von einer Nullspannung (0V) verschiedener, konstanter Ist-Spannungsverlauf und/oder ein von einem Nullstrom (0A) verschiedener, konstanter Ist-Stromfluss oder ein von einem Nullstrom (0A) verschiedener, konstanter Ist-Stromflussverlauf erfasst wird, insbesondere eine konstantes Plateau eines Heizleistungspulses.

Ein Abschalt-Zustand wird insbesondere als aktueller Ist-Zustand der Heizeinrichtung erkannt, wenn eine fallende Ist-Spannung und/oder ein fallender Ist-Spannungsverlauf und/oder ein fallender Ist-Stromfluss oder ein fallender Ist-Stromflussverlauf erfasst wird, insbesondere eine fallende Flanke eines Heizleistungspulses.

Eiin Aus-Zustand wird bevorzugt als aktueller Ist-Zustand der Heizeinrichtung erkannt, wenn eine Nullspannung (0V) als konstante Ist-Spannung und/oder ein konstanter Nullspannungsverlauf als Ist-Spannungsverlauf und/oder ein Nullstrom als konstanter Ist-Stromfluss oder ein konstanter Nullstromverlauf als Ist-Stromflussverlauf erfasst wird, insbesondere eine konstantes Null-Plateau eines Heizleistungspulses.

Eine erfindungsgemäße, kapazitive Sensor- und Heizvorrichtung kann auch dazu ausgebildet sein, insbesondere in einer Weiterbildung, eine Periodendauer einer Heizperiode zu erfassen und die Sensoreinrichtung insbesondere zusätzlich in Abhängigkeit davon anzusteuern, beispielsweise mithilfe der Bestimmung einer Zeitdifferenz zwischen dem Erkennen von zwei Einschaltvorgängen oder zwei Ausschaltvorgängen, oder eine Länge eines Heizpulses oder einer Heizpause durch Bestimmen einer Zeitdifferenz zwischen einem Einschalten und einem Ausschalten bzw. umgekehrt.

In einer weiteren möglichen, insbesondere vorteilhaften Ausgestaltung einer kombinierten, kapazitiven Sensor- und Heizvorrichtung gemäß der vorliegenden Erfindung ist die Synchronisierungseinrichtung insbesondere dazu ausgebildet und eingerichtet, wenn ein Abschalt-Zustand oder ein Einschalt-Zustand der Heizeinrichtung erkannt worden ist, einen Sensorbetrieb des kombinierten Sensor- und Heizelements auszulösen, insbesondere unmittelbar oder mit einer definierten, zeitlichen Verzögerung. Dies ermöglicht eine besonders vorteilhafte Ansteuerung der Sensoreinrichtung.

In einer weiteren möglichen, insbesondere vorteilhaften Ausgestaltung einer kombinierten, kapazitiven Sensor- und Heizvorrichtung gemäß der vorliegenden Erfindung ist die Synchronisierungseinrichtung vorzugsweise dazu ausgebildet und eingerichtet, zum Auslösen eines Sensorbetriebs ein Sensorbetrieb-Start-Signal zu erzeugen und auszugeben, insbesondere an die Steuerungs- und Auswerteinrichtung, die zur zumindest teilweisen Steuerung der Sensoreinrichtung ausgebildet und eingerichtet ist, insbesondere ein digitales Sensorbetrieb-Start-Signal, wobei die Steuerungs- und Auswerteinrichtung, die zur zumindest teilweisen Steuerung der Sensoreinrichtung ausgebildet und eingerichtet ist, vorzugsweise dazu ausgebildet und eingerichtet ist, in einem oder mehreren Schritten bei oder nach Empfang eines Sensor-Start-Signals sämtliche von ihr im ersten elektrischen Pfad und im zweiten elektrischen Pfad ansteuerbaren Schalteinrichtungen derart anzusteuern, dass diese geöffnet werden, und vorzugsweise in einem weiteren Schritt wenigstens eine kapazitive Messung zum Erkennen einer Anwesenheit eines kapazitiv wirksamen Betätigungsmittels in einem Detektionsbereich der Sensoreinrichtung und/oder eine Sensordiagnose zu durchzuführen.

Auf einen erkannten Abschalt-Zustand hin, d.h. auf eine erkannte fallende Flanke eines Heizpulses hin, kann bevorzugt unmittelbar oder mit einer definierten zeitlichen Verzögerung hin der Sensorbetrieb ausgelöst werden, indem beispielsweise sämtliche von der zugehörigen Steuerungs- und Auswerteeinrichtung zur Steuerung der Sensorfunktion ansteuerbaren Schalteinrichtungen im ersten elektrischen Pfad und im zweiten elektrischen Pfad derart angesteuert werden, dass sie öffnen. Anschließend kann dann beispielsweise eine kapazitive Messung durchgeführt werden, beispielswiese wie vorstehend beschrieben, bevorzugt unter Einspeisung eines Kompensationssignals. Wird ferner erkannt, dass das Sensor- und Heizelement allpolig abgeschaltet ist, kann insbesondere beispielsweise außerdem ein Stabilisierungspotential angelegt werden.

Solange wenigstens eine Schalteinrichtung geöffnet bleibt, was sich leicht realisieren lässt, wenn wenigstens eine Schalteinrichtung einzig von der Steuerungseinrichtung zur Steuerung der Sensorfunktion (Sensor-Steuerungseinrichtung) ansteuerbar ist, kann die Heizeinrichtung keinen Wechsel in den Heizbetrieb auslösen.

Um bei separat ausgebildeten Steuerungseinrichtungen eine Fehlermeldung der Heizeinrichtung zu vermeiden, weil die Heizeinrichtung beispielsweise versucht eine Heizleistung abzugeben und mittels einer Diagnosefunktion prüft, ob alle Schalter geschlossen sind, kann, insbesondere in einer Weiterbildung der vorliegenden Erfindung, beispielsweise über ein entsprechendes, von der Sensor-Steuerungseinrichtung erzeugtes Statussignal, welches beispielsweise über einen Datenbus an die Steuerungseinrichtung der Heizeinrichtung (Heiz-Steuerungseinrichtung) übermittelt werden kann, eine entsprechende Fehlermeldung abgefangen bzw. unterdrückt werden.

Alternativ oder zusätzlich kann grundsätzlich auch auf einen erkannten Einschalt-Zustand hin, d.h. auf eine erkannte steigende Flanke eines Heizpulses hin, der Sensorbetrieb ausgelöst werden, vorzugsweise ebenfalls wie vorstehend beschrieben, indem bevorzugt sämtliche von der zugehörigen Steuerungs- und Auswerteeinrichtung zur Steuerung der Sensorfunktion ansteuerbaren Schalteinrichtungen im ersten elektrischen Pfad und im zweiten elektrischen Pfad derart angesteuert werden, dass sie öffnen. Anschließend kann dann ebenfalls beispielsweise eine kapazitive Messung durchgeführt werden, insbesondere wie vorstehend beschrieben, bevorzugt unter Einspeisung eines Kompensationssignals. Wird ferner erkannt, dass das Sensor- und Heizelement allpolig abgeschaltet ist, kann insbesondere beispielsweise außerdem ein Stabilisierungspotential angelegt werden.

Soll jedoch auf eine steigende Flanke eines Heizpulses hin der Sensorbetrieb ausgelöst werden, ist es vorteilhaft, dies mit einer definierten zeitlichen Verzögerung zu tun, um die abgegebene Heizleistung nicht unnötig zu reduzieren durch frühzeitiges Öffnen einer oder mehrerer Schalteinrichtungen im ersten oder zweiten elektrischen Pfad, insbesondere noch während eines Heizleistungspulses.

Ist jedoch erkennbar, dass ein Zeitraum zwischen zwei Heizleistungspulsen vermutlich für eine Durchführung eines vollständigen Messzyklus, einer Sensordiagnose und/oder einer Plausibilisierung nicht ausreicht, kann durch das Auslösen eines Sensorbetriebs auf das Erkennen eines Einschalt-Zustands hin, bei einer erfindungsgemäßen Ausgestaltung einer kombinierten Sensor- und Heizvorrichtung, sofern diese eine oder mehrere weitere Schalteinrichtungen im ersten oder zweiten elektrischen Pfad aufweist, die von der Sensor-Steuerungseinrichtung auch ansteuerbar sind, mittels der Sensor-Steuerungseinrichtung auf einfache Art und Weise, ein Heizleistungspuls unterbrochen werden und somit ein Heizzyklus verkürzt werden und in den Sensorbetrieb gewechselt werden. Infolgedessen kann ein Zeitgewinn erreicht werden.

Die zeitliche Verzögerung kann dabei insbesondere vordefiniert und insbesondere in der Synchronisierungseinrichtung hinterlegt sein oder beim Aufstarten der Synchronisierungseinrichtung einmalig von der Heizeinrichtung übermittelt worden sein oder wiederholt übermittelt werden, insbesondere über einen Datenbus, oder aus einem oder mehreren erfassten Ist-Zuständen bestimmt werden, beispielsweise aus einer ermittelten Dauer einer Heizperiode, insbesondere beispielsweise aus der letzten ermittelten Dauer. Besonders bevorzugt ist die zeitliche Verzögerung von einer Pulsdauer eines Heizleistungspulses einer Pulsweitenmodulation abhängig oder wird abhängig davon bestimmt.

Bevorzugt kann insbesondere auf einen erkannten Abschalt-Zustand hin ein Sensorbetrieb ausgelöst werden. Scheint ein Zeitintervall zwischen zwei Heizleistungspulsen jedoch nicht ausreichend, kann bevorzugt auf einen erkannten Einschalt-Zustand hin der Sensorbetrieb ausgelöst werden, wobei dies vorzugsweise je nach Betrieb der Heizeinrichtung wechseln kann, so dass eine besonders vorteilhafte und dynamische Anpassung der Steuerung der Sensoreinrichtung an die Steuerung der Heizeinrichtung erreicht werden kann.

In einer möglichen Ausführung kann die Sensor-Steuerungseinrichtung auch ein Signal an die Heizeinrichtung ausgeben, um ein Schließen der von der Heizeinrichtung ansteuerbaren Schalteinrichtungen auszulösen, wobei die Heizeinrichtung in diesem Fall vorzugsweise dazu ausgebildet ist, dieses Signal zu empfangen und entsprechend auszuwerten und die gewünschte Ansteuerung der zugehörigen Schalteinrichtungen zu bewirken.

In einer weiteren möglichen, insbesondere vorteilhaften Ausgestaltung einer kombinierten, kapazitiven Sensor- und Heizvorrichtung gemäß der vorliegenden Erfindung ist die Sensor- und Heizvorrichtung insbesondere dazu ausgebildet und eingerichtet, nach Beendigung einer kapazitiven Messung den Sensorbetrieb unmittelbar zu beenden und/oder nach Ablauf einer definierten Zeit, insbesondere unmittelbar nach Ablauf der definierten Zeit, wobei die Sensor- und Heizvorrichtung vorzugsweise dazu ausgebildet und eingerichtet ist, nach Beendigung des Sensorbetriebs in den Heizbetrieb zu wechseln, wobei die Steuerungs- und Auswerteinrichtung, die zur zumindest teilweisen Steuerung der Sensoreinrichtung ausgebildet und eingerichtet ist, dafür insbesondere dazu ausgebildet und eingerichtet ist, nach Beendigung der kapazitiven Messung und/oder Ablauf der definierten Zeit, in einem oder mehreren Schritten sämtliche von ihr im ersten elektrischen Pfad und im zweiten elektrischen Pfad ansteuerbaren Schalteinrichtungen derart anzusteuern, dass diese geschlossen werden.

Bei einem Verfahren gemäß der vorliegenden Erfindung zum Betrieb einer erfindungsgemäßen kombinierten, kapazitiven Sensor- und Heizvorrichtung wird die Sensor- und Heizvorrichtung wahlweise, insbesondere wechselweise, als Heizeinrichtung oder als Sensoreinrichtung betrieben, wobei zum Betreiben der Sensor- und Heizvorrichtung als Heizeinrichtung das kombinierte Sensor- und Heizelement als elektrisches Heizelement betrieben wird, wobei zum Einschalten der Heizeinrichtung sämtliche Schalteinrichtungen entlang des ersten elektrischen Pfades und sämtliche Schalteinrichtungen entlang des zweiten elektrischen Pfades geschlossen werden und zum Abschalten der Heizeinrichtung wenigstens eine Schalteinrichtung entlang des ersten elektrischen Pfades, vorzugsweise wenigstens die erste Schalteinrichtung, insbesondere sämtliche Schalteinrichtungen entlang des ersten Pfades, und wenigstens eine Schalteinrichtung entlang des zweiten elektrischen Pfades, vorzugsweise wenigstens die zweite Schalteinrichtung, insbesondere sämtliche Schalteinrichtungen entlang des zweiten Pfades, geöffnet werden, und wobei zum Betreiben der Sensor- und Heizvorrichtung als Sensoreinrichtung das kombinierte Sensor- und Heizelement als kapazitive Sensorelektrode betrieben wird und wenigstens eine Schalteinrichtung des ersten elektrischen Pfades und wenigstens eine Schalteinrichtung des zweiten elektrischen Pfades geöffnet werden, insbesondere sämtliche Schalteinrichtungen entlang des ersten elektrischen Pfades und sämtliche Schalteinrichtungen entlang des zweiten elektrischen Pfades.

Ein erfindungsgemäßes Verfahren zum Betrieb einer erfindungsgemäßen Sensor- und Heizvorrichtung ist dadurch gekennzeichnet, dass eine am ersten elektrischen Pfad zwischen dem ersten Pol der Spannungsquelle und dem ersten Anschluss des kombinierten Sensor- und Heizelements anliegende Ist-Spannung, insbesondere ein Ist-Spannungsverlauf über der Zeit, und/oder ein aktueller Ist-Stromfluss, insbesondere ein Ist-Stromflussverlauf über der Zeit, entlang des ersten elektrisch Pfades erfasst wird, und/oder eine am zweiten elektrischen Pfad zwischen dem zweiten Anschluss des kombinierten Sensor- und Heizelements und dem zweiten Pol anliegende Ist-Spannung, insbesondere ein Ist-Spannungsverlauf über der Zeit, und/oder ein aktueller Ist-Stromfluss, insbesondere ein Ist-Stromflussverlauf über der Zeit, entlang des zweiten elektrisch Pfades erfasst wird, vorzugsweise (jeweils) über einen Synchronisierungs-Anschlussknoten und einen mit der Synchronisierungseinrichtung elektrisch verbundenen oder verbindbaren elektrischen Pfad, wobei in Abhängigkeit von der erfassten Ist-Spannung und/oder dem erfassten Ist-Stromfluss ein aktueller Ist-Zustand der Heizeinrichtung bestimmt wird und in Abhängigkeit von dem bestimmten Ist-Zustand der Heizeinrichtung die Sensoreinrichtung wenigstens zumindest teilweise angesteuert wird und/oder wenigstens ein Steuersignal zur zumindest teilweisen Ansteuerung der Sensoreinrichtung ausgegeben wird.

Ein erfindungsgemäßes Verfahren ermöglicht einen flexibel an den Betrieb der Heizeinrichtung angepassten Betrieb der Sensoreinrichtung ohne ein separates, zusätzliches Synchronisierungssignal, auch bei einer Abgabe einer gepulsten Heizleistung mit veränderlicher Pulsfrequenz, Pulsdauer und/oder Pausenzeit zwischen zwei Pulsen.

In einer möglichen, insbesondere vorteilhaften Ausführung eines Verfahrens gemäß der vorliegenden Erfindung wird die Heizleistung gepulst abgegeben, insbesondere eine gewünschte Heizleistung, vorzugsweise in Abhängigkeit von einer Anforderung, wobei dazu vorzugsweise ein gepulster Stromfluss, insbesondere mit einer definierten, vorzugsweise konstanten Spannung, durch das wenigstens eine kombinierte Sensor- und Heizelement hindurchgeleitet wird, wobei der gepulste Stromfluss insbesondere mittels einer Pulsweitenmodulation derart moduliert wird, dass die gewünschte Heizleistung abgegeben wird, insbesondere eine gewünschte mittlere Heizleistung, wobei dazu insbesondere eine Periodendauer, eine Pulsbreite und/oder ein Abstands zwischen zwei Pulsen (Pausenzeit) verändert werden kann und/oder eine Pulshöhe (Spannungsniveau).

In einer weiteren möglichen, insbesondere vorteilhaften Ausführung eines Verfahrens gemäß der vorliegenden Erfindung wird ein Sensorbetrieb, insbesondere eine oder mehrere kapazitive Messungen zum Erkennen einer Anwesenheit eines kapazitiv wirksamen Betätigungsmittels in einem Detektionsbereich der Sensoreinrichtung und/oder eine Diagnose der Sensoreinrichtung, zumindest teilweise zwischen zwei Heizleistungspulsen ausgeführt, insbesondere vollständig, wobei dazu insbesondere wenigstens eine Schalteinrichtung angesteuert und geöffnet wird, insbesondere von einer Steuerungs- und Auswerteinrichtung zur Steuerung der Sensoreinrichtung.

In einer möglichen, insbesondere vorteilhaften Ausführung eines Verfahrens gemäß der vorliegenden Erfindung wird die Ist-Spannung und/oder ein Ist-Stromfluss und/oder ein entsprechender -verlauf dabei über wenigstens einen weiteren elektrischen Pfad und über einen sich zwischen der ersten Schalteinrichtung und dem ersten Anschluss des kombinierten Sensor- und Heizelements entlang des ersten elektrischen Pfades befindenden Synchronisierungs-Anschlussknoten erfasst, der elektrisch mit dem ersten elektrischen Pfad verbunden oder verbindbar ist und/oder über wenigstens einen weiteren elektrischen Pfad und über einen sich zwischen dem zweiten Anschluss des kombinierten Sensor- und Heizelements und der zweiten Schalteinrichtung entlang des zweiten elektrischen Pfades befindenden Synchronisierung-Anschlussknoten, der elektrisch mit dem zweiten elektrischen Pfad verbunden oder verbindbar ist.

Besonders bevorzugt wird in einer vorteilhaften Ausführung eines Verfahrens gemäß der vorliegenden Erfindung wenigstens ein Einschalt-Zustand und/oder ein Heiz-Zustand und/oder ein Abschalt-Zustand und/oder ein Aus-Zustand als Ist-Zustand der Heizeinrichtung bestimmt, wobei ein Einschalt-Zustand als aktueller Ist-Zustand der Heizeinrichtung bestimmt wird, wenn eine steigende Ist-Spannung und/oder ein steigender Ist-Spannungsverlauf und/oder ein steigender Ist-Stromfluss oder ein steigender Ist-Stromflussverlauf erfasst wird, insbesondere eine steigende Flanke eines Heizleistungspulses, und/oder
ein Heiz-Zustand als aktueller Ist-Zustand der Heizeinrichtung bestimmt wird, wenn eine von einer Nullspannung (0V) verschiedene, konstante Ist-Spannung und/oder ein von einer Nullspannung (0V) verschiedener, konstanter Ist-Spannungsverlauf und/oder ein von einem Nullstrom (0A) verschiedener, konstanter Ist-Stromfluss oder ein von einem Nullstrom (0A) verschiedener, konstanter Ist-Stromflussverlauf erfasst wird, insbesondere eine konstantes Plateau eines Heizleistungspulses, und/oder
ein Abschalt-Zustand als aktueller Ist-Zustand der Heizeinrichtung bestimmt wird, wenn eine fallende Ist-Spannung und/oder ein fallender Ist-Spannungsverlauf und/oder ein fallender Ist-Stromfluss oder ein fallender Ist-Stromflussverlauf erfasst wird, insbesondere eine fallende Flanke eines Heizleistungspulses, und/oder
ein Aus-Zustand als aktueller Ist-Zustand der Heizeinrichtung bestimmt wird, wenn eine Nullspannung (0V) als konstante Ist-Spannung und/oder ein konstanter Nullspannungsverlauf als Ist-Spannungsverlauf und/oder ein Nullstrom als konstanter Ist-Stromfluss oder ein konstanter Nullstromverlauf als Ist-Stromflussverlauf erfasst wird, insbesondere eine konstantes Null-Plateau eines Heizleistungspulses.

In einer möglichen, besonders vorteilhaften Ausführung eines Verfahrens gemäß der vorliegenden Erfindung wird, wenn als Ist-Zustand der Heizeinrichtung ein Abschalt-Zustand, d.h. insbesondere eine fallende Flanke eines Heizleistungspulses, oder ein Einschalt-Zustand, d.h. insbesondere eine steigende Flanke eines Heizleistungspulses, der Heizeinrichtung erkannt oder bestimmt worden ist, ein Sensorbetrieb des kombinierten Sensor- und Heizelements ausgelöst, insbesondere unmittelbar oder mit einer definierten zeitlichen Verzögerung.

Zum Auslösen eines Sensorbetriebs werden die entsprechenden Schalteinrichtungen von wenigstens einer Steuerungseinrichtung jeweils entsprechend angesteuert, bevorzugt insbesondere geöffnet.

In einer vorteilhaften Ausführung eines erfindungsgemäßen Verfahrens wird während des Betriebs der Sensor- und Heizvorrichtung als Sensoreinrichtung zumindest zeitweise, sofern vorhanden, an einem ersten Sensor-Anschlussknoten ein definiertes Eingangs-Messsignal eingespeist, vorzugsweise mittels einer zur zumindest teilweisen Steuerung einer Sensorfunktion ausgebildeten und eingerichteten Steuerungseinrichtung, insbesondere mittels der zweiten Steuerungseinrichtung, und an einem zweiten Sensor-Anschlussknoten, sofern vorhanden, ein definiertes Ausgangs-Messsignal abgegriffen, welches insbesondere erfasst und ausgewertet wird, wobei gegebenenfalls ferner, insbesondere zeitgleich, an einem weiteren Sensor-Anschlussknoten, sofern vorhanden, insbesondere an einem dritten Sensor-Anschlussknoten, und/oder, sofern vorhanden, an einem weiteren Anschlussknoten, insbesondere an einem vierten Sensor-Anschlussknoten, ein definiertes Kompensationssignal angelegt, welches insbesondere dem Eingangs-Messsignal entspricht, und wobei gegebenenfalls ferner, insbesondere zeitgleich, an einem weiteren Sensor-Anschlussknoten, sofern vorhanden, insbesondere an einem fünften Anschlussknoten, und/oder an einem weiteren Anschlussknoten, insbesondere an einem sechsten Anschlussknoten, ein definiertes Stabilisierungspotential angelegt wird, insbesondere ein Nullpotential.

Hierdurch kann eine besonders hohe Erfassungsgenauigkeit der kapazitiven Kopplung des Heiz- und Sensorelements mit einer Umgebung und/oder einer Referenzelektrode erreicht werden. Das Stabilisierungspotential kann auch nur am fünften Anschlussknoten angelegt werden. Dies setzt allerdings eine geeignete Ausgestaltung einer erfindungsgemäßen Sensor- und Heizvorrichtung voraus, insbesondere eine Ausgestaltung, bei welcher am fünften Anschlussknoten ein Nullpotential angelegt wird, welche keine sechste Schalteinrichtung aufweist und bei welcher an der fünften Schalteinrichtung auf ihrer dem zweiten Pol zugewandten Anschlussseite ebenfalls ein Nullpotential anliegt, d.h. die fünfte Schalteinrichtung an Masse (0V) liegt. Hierdurch kann eine besonders vorteilhafte Sensor- und Heizvorrichtung bereitgestellt werden, welche nur wenige Komponenten erfordert und damit einen sehr einfachen Aufbau mit nur sehr wenigen Schalteinrichtungen ermöglicht.

Eine Lenkeingabevorrichtungs-Baugruppe, insbesondere eine Lenkradbaugruppe, gemäß der vorliegenden Erfindung für ein Fahrzeug mit einem lenkradseitigen Teil, der insbesondere wenigstens ein Lenkradmodul aufweist, insbesondere ein Lenkrad mit einem Lenkradmodul, und einem fahrzeugaufbauseitigen Teil, insbesondere einem Lenksäulenmodul, wobei in einem funktionsgemäßen Einbauzustand der Lenkeingabevorrichtungs-Baugruppe in einem Fahrzeug der lenkradseitige Teil relativ gegenüber dem fahrzeugaufbauseitigen Teil bewegbar ist, insbesondere drehbar gegenüber dem fahrzeugaufbauseitigen Teil, insbesondere um eine Drehachse einer Lenkwelle, ist dadurch gekennzeichnet, dass die Lenkeingabevorrichtungs-Baugruppe eine erfindungsgemäße, kombinierte, kapazitive Sensor- und Heizvorrichtung aufweist.

Weist die Sensor- und Heizvorrichtung eine erste Baugruppe und eine zweite Baugruppe auf, ist vorzugsweise die erste Baugruppe der kombinierten, kapazitiven Sensor- und Heizvorrichtung in den fahrzeugaufbauseitigen Teil der Lenkeingabevorrichtungs-Baugruppe integriert und die zweite Baugruppe der kombinierten, kapazitiven Sensor- und Heizvorrichtung in den lenkradseitigen Teil der Lenkeingabevorrichtungs-Baugruppe, wobei die erste Baugruppe und die zweite Baugruppe mit einer elektrischen Verbindungseinrichtung elektrisch miteinander verbunden sind, insbesondere zu Signal- und/oder Energieübertragung, wobei die elektrische Verbindungseinrichtung insbesondere eine Wickelfeder ist.

In einer bevorzugten Ausgestaltung einer Lenkeingabevorrichtungs-Baugruppe gemäß der vorliegenden Erfindung weist die Lenkeingabevorrichtungs-Baugruppe ferner vorzugsweise ein Lenkrad auf, wobei das kombinierte Sensor- und Heizelement dabei besonders bevorzugt in das Lenkrad integriert ist, wobei das Lenkrad insbesondere einen metallischen Lenkradkern aufweist, welcher vorzugsweise elektrisch mit einem definierten Referenzpotential beaufschlagbar ist oder mit einem definierten Referenzpotential fest elektrisch kontaktiert ist, wobei der Lenkradkern insbesondere als Referenzelektrode ausgebildet oder eingerichtet ist und/oder als Abschirmeinrichtung, insbesondere als Abschirmelektrode, wobei der metallischen Lenkradkern besonders bevorzugt mit dem gleichen Potenzial beaufschlagt werden kann, wie die fünfte Schalteinrichtung und/oder die sechste Schalteinrichtung, insbesondere mit einem Nullpotential, d. h. mit Masse.

Ein erfindungsgemäßes Fahrzeug ist dadurch gekennzeichnet, dass es eine erfindungsgemäße Lenkeingabevorrichtungs-Baugruppe aufweist, wobei der lenkradseitige Teil relativ gegenüber dem Fahrzeug aufbauseitigen Teil bewegbar ist, insbesondere drehbar, insbesondere um eine Drehachse einer Lenkwelle.

In einer vorteilhaften Ausgestaltung eines Fahrzeugs weist das Fahrzeug ferner eine Spannungsquelle mit einem ersten Pol und einem zweiten Pol auf, insbesondere eine Gleichspannungsquelle, wobei der erste Anschluss des kombinierten Sensor- und Heizelements der kombinierten, kapazitiven Sensor- und Heizvorrichtung wenigstens über die erste Schalteinrichtung und die zweite Schalteinrichtung und die dritte Schalteinrichtung, welche jeweils miteinander in Reihe geschaltet sind, mit dem ersten Pol einer Spannungsquelle elektrisch verbindbar und von diesem elektrisch trennbar ist, und der zweite Anschluss des kombinierten Sensor- und Heizelements wenigstens über die vierte Schalteinrichtung und die fünfte Schalteinrichtung, welche jeweils miteinander in Reihe geschaltet sind, mit dem zweiten Pol der Spannungsquelle elektrisch verbindbar und von diesem elektrisch trennbar ist.

Die mit Bezug auf eine erfindungsgemäße Sensor- und Heizvorrichtung vorgestellten vorteilhaften Ausgestaltungen und Ausführungsformen sowie deren Vorteile gelten entsprechend auch für ein erfindungsgemäßes Verfahren zum Betrieb einer erfindungsgemäßen Sensor- und Heizvorrichtung, für eine erfindungsgemäße Lenkeingabevorrichtungs-Baugruppe sowie für ein erfindungsgemäßes Fahrzeug.

Weitere Merkmale der Erfindung ergeben sich aus den Ansprüchen, den Figuren und der Figurenbeschreibung. Alle vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder aber in Alleinstellung verwendbar, sofern diese Kombinationen ausführbar und insbesondere technisch sinnvoll sind.

Die Erfindung wird nun anhand einiger bevorzugter, nicht einschränkender Ausführungsbeispiele sowie unter Bezugnahme auf die beigefügten Zeichnungen näher erläutert, wobei funktionsgleiche Bauelemente mit denselben Bezugszeichen versehen sind.

Es zeigen in schematischer Darstellung:
- Fig. 1: ein Prinzipschaltbild eines ersten Ausführungsbeispiels einer erfindungsgemäßen Lenkeingabevorrichtungs-Baugruppe mit einem ersten Ausführungsbeispiel einer erfindungsgemäßen Sensor- und Heizvorrichtung,
- Fig. 2: ein Prinzipschaltbild eines zweiten Ausführungsbeispiels einer erfindungsgemäßen Lenkeingabevorrichtungs-Baugruppe mit einem zweiten Ausführungsbeispiel einer erfindungsgemäßen Sensor- und Heizvorrichtung, und
- Fig. 3: ein Prinzipschaltbild eines dritten Ausführungsbeispiels einer erfindungsgemäßen Lenkeingabevorrichtungs-Baugruppe mit einem dritten Ausführungsbeispiel einer erfindungsgemäßen Sensor- und Heizvorrichtung.

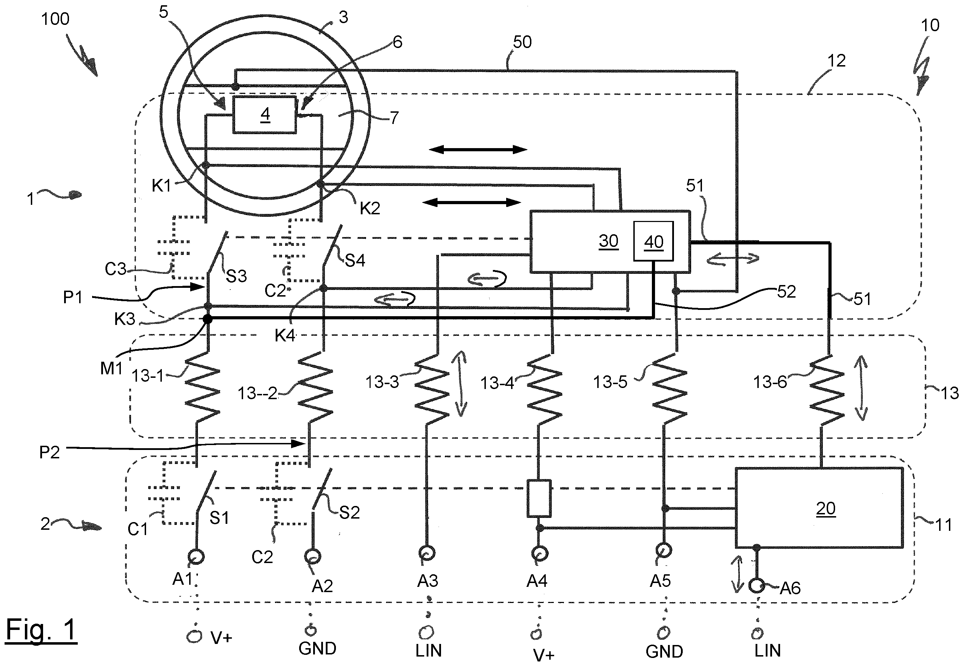

**Fig. 1** zeigt ein erstes Ausführungsbeispiel einer erfindungsgemäßen Lenkeingabevorrichtungs-Baugruppe 100 für ein Fahrzeug mit einem lenkradseitigen Teil 1, insbesondere mit einem Lenkrad 3, sowie einem hier nicht näher bezeichneten Lenkradmodul, welches dazu ausgebildet ist in das Lenkrad 3 integriert zu werden, sowie mit einem fahrzeugaufbauseitigen Teil 2, insbesondere einem Lenksäulenmodul 2, wobei in einem funktionsgemäßen Einbauzustand der Lenkbaugruppe 100 in einem Fahrzeug der lenkradseitige Teil 1 relativ gegenüber dem fahrzeugaufbauseitigen Teil 2 bewegbar ist, wobei der lenkradseitige Teil 1 insbesondere um eine Drehachse einer Lenkwelle des Fahrzeugs drehbar relativ gegenüber dem fahrzeugaufbauseitigen Teil 2 ist.

Erfindungsgemäß weist die Lenkeingabevorrichtungs-Baugruppe 100 eine erfindungsgemäße Sensor- und Heizeinrichtung 10 auf, wobei bei diesem Ausführungsbeispiel die erfindungsgemäße Sensor- und Heizeinrichtung 10 eine erste Baugruppe 11 und eine zweite Baugruppe 12 aufweist, wobei die erste Baugruppe 11 in den fahrzeugaufbauseitigen Teil 2 der Lenkeingabevorrichtungs-Baugruppe 100 integriert ist und die zweite Baugruppe 12 in den lenkradseitigen Teil 1. Dabei sind die erste Baugruppe 11 und die zweite Baugruppe 12 über eine elektrische Verbindungseinrichtung 13 in Form einer Wickelfeder 13, welche insbesondere einen Flachleiter mit mehreren einzelnen, voneinander isolierten Leiterbahnen 13-1, 13-2, 13-3, 13-4, 13-5 und 13-6 aufweist, elektrisch miteinander verbunden.

Gemäß der vorliegenden Erfindung weist die kombinierte, kapazitive Sensor- und Heizvorrichtung 10 ein elektrisches, kombiniertes Sensor- und Heizelement 4 auf, welches sowohl von einer hier nicht näher bezeichneten Heizeinrichtung, die Teil der erfindungsgemäßen, kombinierten Sensor- und Heizvorrichtung 10 ist, als elektrisches Heizelement 4 als auch von einer kapazitiven Sensoreinrichtung, die ebenfalls nicht näher bezeichnet ist und die Teil der erfindungsgemäßen, kombinierten Sensor- und Heizvorrichtung 10 ist, als kapazitives Sensorelement 4, insbesondere als kapazitive Sensorelektrode 4, genutzt werden kann.

Das kombinierte Sensor- und Heizelement 4 weist einen ersten Anschluss 5 und einen zweiten Anschluss 6 auf, wobei der ersten Anschluss 5 über einen ersten elektrischen Pfad P1 mit einer ersten Schalteinrichtung S1 und einer mit dieser in Reihe geschalteten, dritten Schalteinrichtung S3 und einen ersten Verbindungsanschluss A1 mit dem ersten Pol V+ einer Gleichspannungsquelle, an dem insbesondere eine positive Betriebsspannung V+ anliegt, vorzugsweise von etwa +12V, wie es in einem Fahrzeug üblich ist, elektrisch verbindbar ist und von diesem elektrisch trennbar ist. Zum elektrischen Verbinden des ersten Anschlusses 5 des Sensor- und Heizelements 4 können die erste Schalteinrichtung S1 und die dritte Schalteinrichtung S3 geschlossen werden. Zum elektrischen Trennen von dem ersten Pol V+ kann wenigstens die erste Schalteinrichtung S1 gezielt, d.h. bei Bedarf, geöffnet werden, vorzugsweise bei diesem Ausführungsbeispiel ferner zusätzlich noch die dritte Schalteinrichtung S3.

Der zweite Anschluss 6 des kombinierten Sensor- und Heizelements 4 ist über einen zweiten elektrischen Pfad P2 mit einer vierten Schalteinrichtung S4 und eine mit der vierten Schalteinrichtung S4 in Reihe geschalteten zweite Schalteinrichtung S2 und über einen zweiten Verbindunganschluss A2 mit einem zweiten Pol GND der Spannungsquelle elektrisch verbindbar und von diesem elektrisch trennbar, insbesondere mit einem zweiten Pol GND einer Gleichspannungsquelle, an dem ein Nullpotential GND anliegt, d.h. Masse (GND). Zum elektrischen Verbinden des zweiten Anschlusses 6 des Sensor- und Heizelements mit dem zweiten Pol GND der Spannungsquelle können entsprechend die zweite Schalteinrichtung S2 sowie die vierte Schalteinrichtung S4 geschlossen werden und zum elektrischen Trennen entsprechend geöffnet.

Die erste Schalteinrichtung S1 ist dabei vorliegend eine sogenannte High-Side-Schalteinrichtung (HSS) und die zweite Schalteinrichtung S2 eine Low-Side-Schalteinrichtung (LSS), wobei die erste Schalteinrichtung S1 und die dritte Schalteinrichtung S3 bei diesem Ausführungsbeispiel in einer besonders vorteilhaften Ausführung jeweils wenigstens ein P-MOS-Schaltelement aufweisen. Die zweite Schalteinrichtung S2 und die vierte Schalteinrichtung S4 weisen vorzugweise jeweils wenigstens ein N-MOS-Schaltelement auf.

Bei diesem Ausführungsbeispiel sind dabei die erste Schalteinrichtung S1 und die zweite Schalteinrichtung S2 der ersten Baugruppe 11 zugeordnet und die dritte Schalteinrichtung S3 und die vierte Schalteinrichtung S4 der zweiten Baugruppe 12, wobei die dritte Schalteinrichtung S3 und die erste Schalteinrichtung S1 sowie die zweite Schalteinrichtung S2 und die vierte Schalteinrichtung S4 erfindungsgemäß jeweils mittels der elektrischen Verbindungseinrichtung 13, insbesondere über eine erste Leiterbahn 13-1 bzw. 13-2 der elektrischen Verbindungseinrichtung 13, elektrisch miteinander verbunden sind.

Zur Steuerung der Heizeinrichtung weist bei diesem Ausführungsbeispiel die erfindungsgemäße Sensor- und Heizvorrichtung 10 ferner eine erste Steuerungseinrichtung 20 auf, welche zur Steuerung einer Heizfunktion eingerichtet ist, wobei diese erste Steuerungserrichtung 20 insbesondere zur Ansteuerung der ersten Schalteinrichtung S1 und der zweiten Schalteinrichtung S2 ausgebildet ist, was durch die gestrichelte Linie angedeutet ist, welche von der ersten Steuerungseinrichtung 20 zu der ersten Schalteinrichtung S1 und der zweiten Schalteinrichtung S2 führt.

Über den Verbindungsanschluss A6 kann die erste Steuerungseinrichtung 20 beispielsweise mit einem LIN-Bus eines Fahrzeugs elektrisch verbunden werden sowie über einen Verbindungsanschluss A4 mit einem ersten Pol V+ einer Spannungsquelle, insbesondere mit einem ersten Pol V+ einer Gleichspannungsquelle, an welchem eine positive Betriebsspannung V+ anliegt. Über einen Verbindungsanschluss A5 kann die erste Steuerungseinrichtung 20 ferner mit einem zweiten Pol GND, insbesondere einem zweiten Pol GND einer Gleichspannungsquelle, an dem insbesondere ein Nullpotential GND, d. h. Masse GND, anliegt, elektrisch verbunden werden.

Zur Steuerung der Sensorfunktion ist bei diesem Ausführungsbeispiel einer erfindungsgemäßen Sensor- und Heizvorrichtung 10 ferner eine zweite Steuerungseinrichtung 30 vorgesehen, wobei diese zweite Steuerungseinrichtung 30 insbesondere zur Ansteuerung der dritten Schalteinrichtung S3 und der vierten Schalteinrichtung S4 ausgebildet ist, was durch die gestrichelte Linie angedeutet ist, welche von der zweiten Steuerungseinrichtung 30 zu der dritten Schalteinrichtung S3 und der vierten Schalteinrichtung S4 führt.

Über die Leiterbahn 13-3 und den Verbindungsanschluss A3 kann die zweite Steuerungseinrichtung 30 zur Signalkommunikation, beispielsweise ebenfalls mit einem LIN-Bus, elektrisch verbunden werden.

Ebenfalls über den Verbindungsanschluss A4 sowie außerdem über die elektrische Verbindungseinrichtung 13, insbesondere über die zugehörige Leiterbahn 13-4, kann die zweite Steuerungseinrichtung 30 mit dem ersten Pol V+ der Gleichspannungsquelle elektrisch verbunden werden, wie die erste Steuerungseinrichtung 20, und über den Verbindungsanschluss A5 sowie die elektrische Verbindungseinrichtung 13, insbesondere über die Leiterbahn 13-5, kann die zweite Steuerungseinrichtung 30 mit dem zweiten Pol GND, d. h. mit Masse GND, elektrisch verbunden werden.

Der Lenkradkern 7 des Lenkrads 3 kann ebenfalls über die elektrische Verbindungseinrichtung 13, insbesondere über die Leiterbahn 13-5 sowie den Verbindungsanschluss A5, mit dem zweiten Pol GND elektrisch verbunden werden, insbesondere mithilfe einer weiteren Anschlussleitung 50. Dadurch kann der Lenkradkern 7 mit einem definierten Referenzpotential beaufschlagt werden, insbesondere mit einem Nullpotential GND.

Bei diesem Ausführungsbeispiel kann die Heizleistung gepulst abgegeben werden, insbesondere eine gewünschte Heizleistung, vorzugsweise in Abhängigkeit von einer Anforderung, wobei dazu vorzugsweise ein gepulster Stromfluss, insbesondere mit einer definierten, vorzugsweise konstanten Spannung V+, durch das kombinierte Sensor- und Heizelement 4 hindurchgeleitet wird, wobei der gepulste Stromfluss mittels einer Pulsweitenmodulation derart moduliert werden kann, dass die gewünschte Heizleistung abgegeben wird, insbesondere eine gewünschte mittlere Heizleistung, wobei dazu insbesondere eine Periodendauer, eine Pulsbreite und/oder ein Abstands zwischen zwei Pulsen (Pausenzeit) verändert werden kann.

Ein Sensorbetrieb, insbesondere eine oder mehrere kapazitive Messungen zum Erkennen einer Anwesenheit eines kapazitiv wirksamen Betätigungsmittels in einem Detektionsbereich der Sensoreinrichtung und/oder eine Diagnose der Sensoreinrichtung, wird zumindest teilweise zwischen zwei Heizleistungspulsen ausgeführt, insbesondere vollständig.

Zur zeitlichen Abstimmung von Heiz- und Sensoreinrichtung, insbesondere zur zeitlichen Abstimmung der Ansteuerung der ersten Schalteinrichtung S1 und der zweiten Schalteinrichtung S2 durch die erste Steuerungseinrichtung 20 und der Ansteuerung der dritten Schalteinrichtung S3 und der vierten Schalteinrichtung S4 durch die zweite Steuerungseinrichtung 30 weist dieses Ausführungsbeispiel einer erfindungsgemäßen Sensor- und Heizvorrichtung 10 erfindungsgemäß eine Synchronisierungseinrichtung 40 auf, welche bei diesem Ausführungsbeispiel in die Sensor-Steuerungseinrichtung 30 integriert ist und über einen separaten elektrischen Pfad 52 und einen Synchronisierungs-Anschlussknoten M1 mit dem ersten elektrischen Pfad P1 elektrisch verbunden ist.

Erfindungsgemäß kann die die Synchronisierungseinrichtung 40 über diesen elektrischen Pfad 52 sowie einen in diesem Fall separaten Synchronisierungs-Anschlussknoten M1 eine am ersten elektrischen Pfad P1 anliegende Ist-Spannung, insbesondere einen Ist-Spannungs-Verlauf, sowie einen Ist-Stromfluss, insbesondere einen Ist-StromflussVerlauf, erfassen und damit eine abgegebene Heizleistung. Erfindungsgemäß kann die Synchronisierungseinrichtung 40 in Abhängigkeit von der erfassten Heizleistung einen Ist-Zustand der Heizeinrichtung bestimmen und die Sensoreinrichtung entsprechend ansteuern, wobei die Synchronisierungseinrichtung 40 in diesem Fall insbesondere dazu ausgebildet und eingerichtet ist, bei Erkennen eines Abschalt-Zustands der Heizeinrichtung, d.h. einer fallenden Flanke in der abgegebenen Heizleistung, unmittelbar einen Sensorbetrieb auszulösen und die Schalteinrichtungen S3 und S4 derart anzusteuern, dass diese Öffnen. Anschließend kann eine kapazitive Messung durchgeführt werden. Nach Beendigung der kapazitiven Messung werden die dritten und vierten Schalteinrichtungen S3 und S4 wieder geschlossen. Bei Bedarf kann alternativ bei Erkennen eines Einschalt-Zustandes, d.h. bei Erkennen einer steigenden Flanke der abgegebenen Heizleistung, insbesondere mit einer definierten zeitlichen Verzögerung, der Sensorbetrieb ausgelöst werden, insbesondere falls ein Zeitintervall zwischen zwei Heizleistungspulsen für eine Durchführung einer vollständigen kapazitiven Messung nicht ausreicht.

Zusätzlich sind die Sensor-Steuerungseinrichtung 30 und die Synchronisierungseinrichtung 40 über eine Kommunikationsleitung 51 und die elektrische Verbindungseinrichtung 13, insbesondere über eine zugehörige Leiterbahn 13-6, mit der ersten Steuerungseinrichtung 20 elektrisch verbunden ist, um beispielsweise einmalig nach einer Initialisierung der erfindungsgemäßen Sensor- und Heizvorrichtung 100 nach einem ersten Aufstarten beispielsweise einen oder mehrere vordefinierte und als Parameter hinterlegte Werte der Heizeinrichtung empfangen zu können oder dergleichen, beispielsweise Parameter zur Bestimmung einer erforderlichen zeitlichen Verzögerung wie eine Diagnosedauer einer Diagnosefunktion der Heizeinrichtung nach einem Einschalt-Vorgang, und/oder um beispielsweise ein Status-Signal wie "Sensormessung läuft" an die Heizeinrichtung zu übermitteln, um ggf. eine Fehlermeldung infolge einer Diagnose abzufangen oder zu unterdrücken.

Zum Betreiben der Sensor- und Heizvorrichtung 10 als Heizeinrichtung, insbesondere zum Einschalten der Heizeinrichtung und damit zum Erzeugen von Heizwärme, können die erste Schalteinrichtung S1, die zweite Schalteinrichtung S2, die dritte Schalteinrichtung S3 und die vierte Schalteinrichtung S4 geschlossen werden, wobei dazu die erste Schalteinrichtung S1 und die zweite Schalteinrichtung S2 von der ersten Steuerungseinrichtung 20 entsprechend angesteuert werden können und die dritte Schalteinrichtung S3 und die vierte Schalteinrichtung S4 jeweils von der zweiten Steuerungseinrichtung 30, wobei mittels der Synchronisierungseinrichtung 40 die Ansteuerung der ersten und zweiten Schalteinrichtungen S1 und S2 sowie der dritten und vierten Schalteinrichtungen S3 und S4 zeitlich aufeinander abgestimmt werden kann, insbesondere mithilfe wenigstens eines Synchronisierungssignals.

Zum Abschalten der Heizeinrichtung und damit zum Beenden der Erzeugung von Heizwärme, insbesondere zum Beenden eines Stromflusses durch das Sensor- und Heizelement 4 hindurch, können bei diesem Ausführungsbeispiel die erste Schalteinrichtung S1, die zweite Schalteinrichtung S2, die dritte Schalterrichtung S3 und die vierte Schalteinrichtung S4 geöffnet werden, wodurch das Sensor- und Heizelement 4 allpolig von der Spannungsversorgung getrennt werden kann.

Zum Betreiben der kombinierten Sensor- und Heizvorrichtung 10 als Sensoreinrichtung und damit des kombinierten Sensor- und Heizelement als kapazitive Sensorelektrode kann das Sensor- und Heizelement über einen ersten, zwischen der dritten Schalteinrichtung S3 und dem ersten Anschluss 5 des Sensor- und Heizelements 4 angeordneten Sensor-Anschlussknoten K1 von der zweiten Steuerungseinrichtung 30 mit einem definierten Eingangs-Messsignal beaufschlagt werden, welches insbesondere am ersten Sensor-Anschlussknoten K1 eingespeist werden kann. Ebenfalls kann über den ersten Sensor-Anschlussknoten K1 ein entsprechendes Ausgangs-Messsignal abgegriffen werden, was durch den Doppelpfeil an den zugehörigen, nicht näher bezeichneten Anschlussleitungen symbolisiert ist.

Über einen zweiten Sensor-Anschlussknoten K2 kann die zweite Steuerungseinrichtung 30 ebenfalls ein definiertes Eingangs-Messsignal einspeisen und ein Ausgangs-Messsignal abgreifen und auswerten, insbesondere jedoch erst, wenn die Messung am ersten Sensor-Anschlussknoten K1 beendet ist, wobei dabei bevorzugt das am zweiten Ausgangsknoten K2 erfasste Ausgangs-Messignal insbesondere mit dem am ersten Sensor-Anschlussknoten K1 erfassten Messignal verglichen werden kann.

Gelangt ein kapazitiv wirksames Betätigungsmittel, beispielsweise eine menschliche Hand, in den Detektionsbereich der Sensoreinrichtung, wird eine Änderung der kapazitiven Kopplung des Sensor- und Heizelement 4 mit der Umgebung und/oder einer Referenzelektrode bewirkt, was anhand des Ausgangs-Messsignals messtechnisch erfasst werden kann. Somit kann anhand des empfangenen Ausgangs-Messsignals auf die Anwesenheit eines kapazitiv wirksamen Betätigungsmittels im Detektionsbereich der Sensoreinrichtung geschlossen werden.

Die erste Schalteinrichtung S1, die zweite Schalteinrichtung S2, die dritte Schalteinrichtung S3, und die vierte Schalteinrichtung S4 bewirken jeweils die Entstehung einer jeweils zugehörigen parasitären Kapazität, welche hier nur gestrichelt angedeutet sind und mit C1 bis C4 bezeichnet sind, über welche jeweils, wenn die zugehörige Schalteinrichtung S1, S2, S3 bzw. S4 geöffnet ist, ebenfalls ein Strom abfließen kann, wodurch es zu einer unerwünschten Verfälschung des Ausgangs-Messsignals kommen kann.

Um dem entgegenzuwirken, ist bei diesem Ausführungsbeispiel einer erfindungsgemäßen Sensor- und Heizvorrichtung 10 die zweite Steuerungseinrichtung 30 ferner dazu ausgebildet, an einem dritten Sensor-Anschlussknoten K3, welcher sich zwischen der ersten Schalteinrichtung S1 und der dritten Schalteinrichtung S3 befindet, insbesondere zwischen der elektrischen Verbindungseinrichtung 13 und der dritten Schalteinrichtung S3, sowie an einem vierten Sensor-Anschlussknoten K4, welcher sich zwischen der zweiten Schalteinrichtung S2 und der vierten Schalteinrichtung S4 befindet, insbesondere zwischen der elektrischen Verbindungseinrichtung 13 und der vierten Schalteinrichtung S4, ein definiertes Kompensationssignal anzulegen, welches insbesondere dem Eingangs-Messsignal entspricht. Dadurch kann eine Potenzialdifferenz zwischen dem ersten Sensor-Anschlussknoten K1 und dem dritten Sensor-Anschlussknoten K3 sowie zwischen dem zweiten Sensor-Anschlussknoten K2 und dem vierten Sensor-Anschlussknoten K4 nahezu aufgehoben werden, wodurch ein unerwünschter Abfluss des Eingangs-Messsignals über die dritte Schalteinrichtung S3 und weiter über die erste Schalteinrichtung S1 bzw. ein unerwünschter Abfluss des Ausgangs-Messsignals über die vierte Schalteinrichtung S4 und weiter über die zweite Schalteinrichtung S2 deutlich reduziert werden kann, was mit einer erheblich geringeren Verfälschung des Ausgangs-Messignals und damit einer verbesserten Erfassungsgenauigkeit der Sensor- und Heizvorrichtung 10 einhergeht.

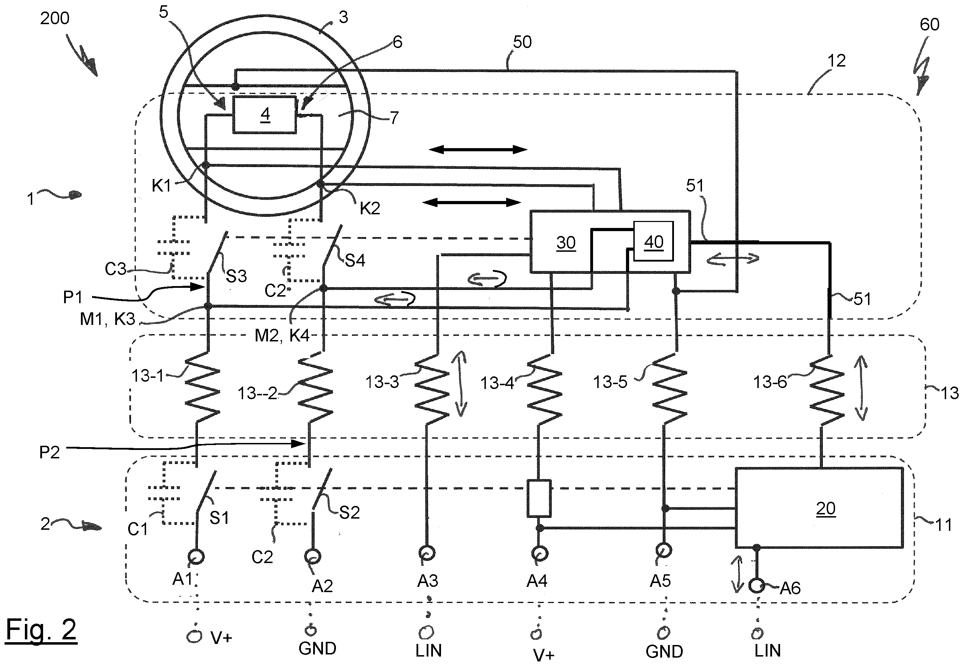

**Fig. 2** zeigt ein Prinzipschaltbild eines zweiten Ausführungsbeispiels einer erfindungsgemäßen Lenkeingabevorrichtungs-Baugruppe 200 mit einem zweiten Ausführungsbeispiel einer erfindungsgemäßen Sensor- und Heizvorrichtung 60, wobei diese Sensor- und Heizvorrichtung 60 auf der in Fig. 1 dargestellten, erfindungsgemäßen Sensor- und Heizvorrichtung 10 basiert. Bei diesem Ausführungsbeispiel weist die Sensor- und Heizvorrichtung 60 jedoch keinen separaten, elektrischen Pfad 52 sowie einen separaten Synchronisierungsknoten M1 zum Abgriff einer Heizleistung am ersten elektrischen Pfad P1 auf, sondern bedient sich hierfür der nicht näher bezeichneten elektrischen Pfade bzw. Verbindungen, welche über die Sensor-Anschlussknoten K3 und K4 jeweils mit dem ersten elektrischen Pfad P1 bzw. dem zweiten elektrischen Pfad P2 verbunden sind. D.h. hier dienen die Sensor-Anschlussknoten K3 und K4 jeweils als Synchronisierungs-Anschlussknoten M1 bzw. M2.

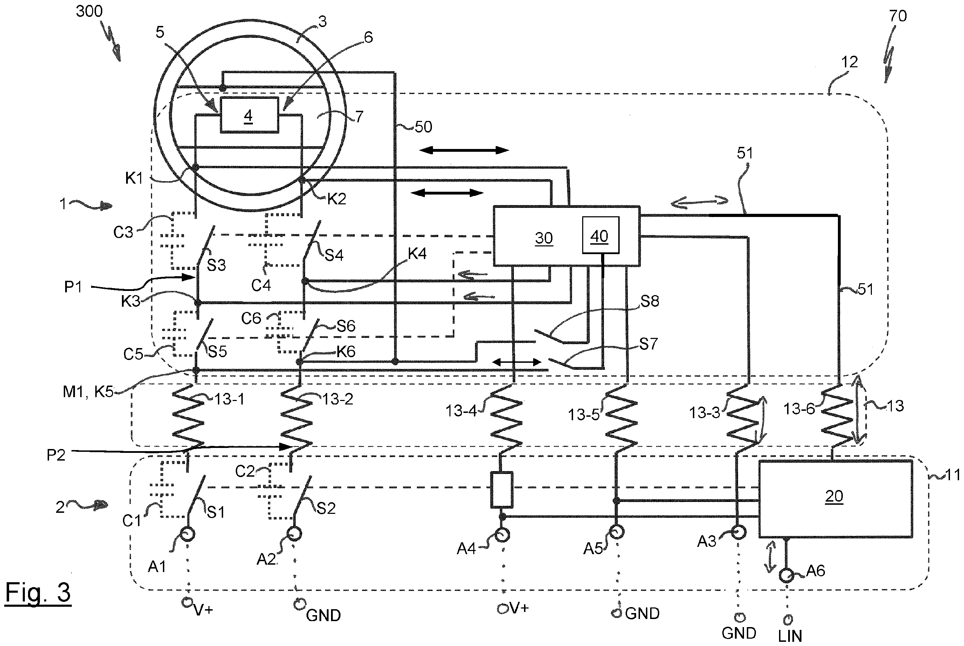

**Fig. 3** zeigt ein Prinzipschaltbild eines dritten Ausführungsbeispiels einer erfindungsgemäßen Lenkeingabevorrichtungs-Baugruppe 300 mit einem dritten Ausführungsbeispiel einer erfindungsgemäßen Sensor- und Heizvorrichtung 70, wobei diese Sensor- und Heizvorrichtung 70 auf der in Fig. 2 dargestellten, erfindungsgemäßen Sensor- und Heizvorrichtung 60 basiert, zusätzlich jedoch eine fünfte Schalterrichtung S5 mit einer fünften parasitären Kapazität C5 sowie eine sechste Schalterrichtung S6 mit einer sechsten parasitären Kapazität C6 aufweist, wobei die fünfte Schalteinrichtung S5 mit der ersten Schalteinrichtung S1 und der dritten Schalteinrichtung S3 in Reihe geschaltet ist und insbesondere zwischen der elektrischen Verbindungseinrichtung 13 und der dritten Schalteinrichtung S3 angeordnet ist und insbesondere der zweiten Baugruppe 12 zugeordnet ist. Die sechste Schalteinrichtung S6 ist mit der zweiten Schalteinrichtung S2 und der vierten Schalteinrichtung S4 in Reihe geschaltet, insbesondere zwischen der elektrischen Verbindungseinrichtung 13 und der vierten Schalteinrichtung S4.

Mittels der zweiten Steuerungseinrichtung 30 kann an einem fünften Sensor-Anschlussknoten K5 zwischen der ersten Schalteinrichtung S1 und der fünften Schalteinrichtung S5, insbesondere zwischen der elektrischen Verbindungseinrichtung 13 und der fünften Schalteinrichtung S5, sowie zwischen der zweiten Schalteinrichtung S2 und der sechsten Schalteinrichtung S6, insbesondere zwischen der elektrischen Verbindungseinrichtung 13 und der sechsten Schalteinrichtung S6, jeweils ein definiertes Referenzpotenzial als Stabilisierungspotential angelegt werden, wenn die gegenüber der in Fig. 1 abgebildeten Sensor- und Heizvorrichtung 10 ebenfalls zusätzlich vorhandenen weiteren, siebten und achten Schalteinrichtungen S7 und S8 geschlossen sind. Hierdurch kann eine Entkopplung der kapazitiven Kopplung der Sensorelektrode 4, d. h. des Sensor- und Heizelements 4, mit der Umgebung und/oder einer Referenzelektrode, wie beispielsweise dem Lenkradkern 7, von einem Zustand einer anliegenden Betriebsspannung erreicht werden. Eine besonders vorteilhafte Entkopplung ergibt sich, wenn das Stabilisierungspotential, welches am fünften Sensor-Anschlussknoten K5 und am sechste Sensor-Anschlussknoten K6 angelegt wird, ein Nullpotential ist, d. h. Masse ist.

Bei diesem Ausführungsbeipsiel dient der Sensor-Anschlussknoten K5 als Synchronisierungs-Anschlussknoten M1, über welchen ein Ist-Zustand der Heizeinrichtung, insbesondere eine abgegebene Heizleistung, erfasst werden kann.

Beträgt das Stabilisierungspotential 0V, d.h. Masse, kann der Lenkradkern 7 statt wie in Fig. 1 gezeigt über den Verbindungsanschluss A5 an Masse GND angebunden zu sein, auch über die mit der Schalteinrichtung S7 verbundene Anschlussleitung angebunden sein.

Ein derartiges Stabilisierungspotential mit 0V, d.h. an GND, ermöglicht, über die beschriebenen Ausführungsbeispiele hinaus, den Entfall der sechsten Schalteinrichtung S6, der achten Schalteinrichtung S8 sowie des sechsten Sensor-Anschlussknotens K6.

Gemäß einem erfindungsgemäßen Verfahren wird eine erfindungsgemäße kapazitive Sensor- und Heizvorrichtung 10, 60, 70 wahlweise, insbesondere wechselweise, als Heizeinrichtung oder als Sensoreinrichtung betrieben, wobei zum Betreiben der Sensor- und Heizvorrichtung 10, 60, 70 als Heizeinrichtung das kombinierte Sensor- und Heizelement 4 als elektrisches Heizelement betrieben wird, wobei zum Einschalten der Heizeinrichtung sämtliche Schalteinrichtungen S1 bis S6, mit denen das kombinierte Sensor- und Heizelement 6 in Reihe geschaltet ist, geschlossen werden und zum Abschalten der Heizeinrichtung wenigstens die erste Schalteinrichtung S1 und/oder die zweite Schalteinrichtung S2 geöffnet wird, und wobei zum Betreiben der Sensor- und Heizvorrichtung 10, 60, 70 als Sensoreinrichtung das kombinierte Sensor- und Heizelement 4 als kapazitive Sensorelektrode betrieben wird und wenigstens die erste Schalteinrichtung S1 und/oder die zweite Schalteinrichtung S2 geöffnet werden, insbesondere sämtliche Schalteinrichtungen S1 bis S6, mit denen das kombinierte Sensor- und Heizelement 4 in Reihe geschaltet ist.

Dazu werden die Schalteinrichtungen S1 bis S6 der Sensor- und Heizvorrichtung 10, 60, 70 von wenigstens einer Steuerungseinrichtung 20, 30 entsprechend angesteuert, wobei wenigstens die erste Schalteinrichtung S1 und/oder die zweite Schalteinrichtung S2 vorzugsweise von einer ersten, insbesondere der ersten Baugruppe 11 zugeordneten Steuerungseinrichtung 20 entsprechend angesteuert werden und die übrigen Schalteinrichtungen S3 bis S6, insbesondere die dritte Schalteinrichtung S3 und/oder die vierte Schalteinrichtung S4 und/oder die fünfte Schalteinrichtung S5 und/oder die sechste Schalteinrichtung S6 und/oder die siebte Schalteinrichtung S7 und/oder die achte Schalteinrichtung S8, vorzugsweise von einer zweiten, insbesondere der zweiten Baugruppe 12 zugeordneten Steuerungseinrichtung 30.

Besonders bevorzugt werden dabei die erste Steuerungseinrichtung 20 und die zweite Steuerungseinrichtung 30 zeitlich aufeinander abgestimmt betrieben, d. h. insbesondere synchronisiert, insbesondere mithilfe einer Synchronisierungseinrichtung 40, welche besonders bevorzugt dazu ausgebildet und eingerichtet ist, die Sensoreinrichtung in Abhängigkeit eines erfassten Ist-Zustandes der Heizeinrichtung hin anzusteuern, und insbesondere auf eine steigende und/oder eine fallende Flanke eines Heizleistungspulses hin, einen Sensorbetrieb auszulösen.

In einer vorteilhaften Ausführung eines erfindungsgemäßen Verfahrens wird während des Betriebs der Sensor- und Heizvorrichtung 10, 60, 70 als Sensoreinrichtung zumindest zeitweise am ersten Sensor-Anschlussknoten K1 ein definiertes Eingangs-Messsignal eingespeist, insbesondere mittels der zweiten Steuerungseinrichtung 30, und am zweiten Sensor-Anschlussknoten K2 ein definiertes Ausgangs-Messsignal abgegriffen, insbesondere ebenfalls mittels der zweiten Steuerungseinrichtung 30, welches insbesondere erfasst und ausgewertet wird, insbesondere ebenfalls mittels der zweiten Steuerungseinrichtung 30. Dabei wird gegebenenfalls ferner, insbesondere zeitgleich, an einem dritten Sensor-Anschlussknoten K3 zwischen der ersten Schalteinrichtung S1 und der dritten Schalteinrichtung S3, vorzugsweise an einem Sensor-Anschlussknoten zwischen der fünften Schalteinrichtung S5 und der dritten Schalteinrichtung S3, und/oder an einem vierten Sensor-Anschlussknoten K4 zwischen der vierten Schalteinrichtung S4 und der zweiten Schalteinrichtung S2, vorzugsweise zwischen der vierten Schalteinrichtung S4 und der sechsten Schalteinrichtung S6, ein definiertes Kompensationssignal angelegt, welches insbesondere dem Eingangs-Messsignal entspricht. Gegebenenfalls wird ferner, insbesondere zeitgleich, an einem fünften Sensor-Anschlussknoten K5 zwischen der ersten Schalteinrichtung S1 und der fünften Schalteinrichtung S5, und/oder an einem sechsten Sensor-Anschlussknoten K6 zwischen der sechsten Schalteinrichtung S6 und dem zweiten Pol GND der Spannungsquelle, insbesondere zwischen der sechsten Schalteinrichtung S6 und der zweiten Schalteinrichtung S2, ein definiertes Stabilisierungspotential angelegt, insbesondere in Nullpotential GND, wobei dazu insbesondere die siebte und achte Schalteinrichtung S7 und S8 geschlossen werden.

Darüber hinaus sind im Rahmen weitere Ausgestaltungen möglich, welche von den Patentansprüchen umfasst sind, hier jedoch nicht gezeigt sind.

### Bezugszeichenliste:

- 100, 200, 300: Ausführungsbeispiel einer erfindungsgemäßen Lenkeingabevorrichtungs-Baugruppe
- 10, 60, 70: Ausführungsbeispiel einer erfindungsgemäßen Sensor- und Heizvorrichtung
- 1: lenkradseitiger Teil der Lenkeingabevorrichtungs-Baugruppe
- 2: fahrzeugaufbauseitiger Teil der Lenkeingabevorrichtungs-Baugruppe
- 3: Lenkrad
- 4: kombiniertes Sensor- und Heizelement
- 5: erster Anschluss des Sensor- und Heizelements
- 6: zweiter Anschluss des Sensor- und Heizelements
- 7: Lenkradkern
- 11: erste Baugruppe
- 12: zweite Baugruppe
- 13: elektrische Verbindungseinrichtung
- 13-1... 13-6: Leiterbahnen der elektrischen Verbindungseinrichtung
- 20: erste Steuerungseinrichtung
- 30: zweite Steuerungseinrichtung
- 40: Synchronisierungseinrichtung
- 50: Anschlussleitung
- 51: Kommunikationsleitung, insbesondere LIN-Bus-Leitung
- 52: weiterer elektrischer Pfad

- A1 ... A6: Verbindungsanschluss
- C1 ... C6: parasitäre Kapazität der zugehörigen Schalteinrichtung
- GND: zweiter Pol einer Spannungsquelle, an dem insbesondere ein Nullpotential (0V) anliegt, d.h. Masse
- K1 ... K6: Sensor-Anschlussknoten
- M1, M2: Synchronisierungs-Anschlussknoten
- LIN: Kommunikationsanschluss (LIN-Bus)
- P1: erster elektrischer Pfad
- P2: zweiter elektrischer Pfad
- S1 .. S8: Schalteinrichtung
- V+: erster Pol einer Spannungsquelle, an dem insbesondere eine positive Betriebsspannung anliegt

## Patentansprüche

1. Kombinierte, kapazitive Sensor- und Heizvorrichtung (10, 60, 70) mit einer kapazitiven Sensoreinrichtung zum Erkennen einer Anwesenheit eines kapazitiv wirksamen Betätigungsmittels in einem Detektionsbereich der Sensoreinrichtung, insbesondere zum Erkennen einer Anwesenheit einer menschlichen Hand in einem Greifbereich einer Lenkeingabevorrichtung (3), und mit einer Heizeinrichtung, insbesondere mit einer Heizeinrichtung für eine Lenkeingabevorrichtung (3) eines Fahrzeugs,
wobei die kombinierte, kapazitive Sensor- und Heizvorrichtung (10, 60, 70) wenigstens ein elektrisches, kombiniertes Sensor- und Heizelement (4) aufweist, welches sowohl von der Sensoreinrichtung als kapazitives Sensorelement als auch von der Heizeinrichtung als elektrisches Heizelement nutzbar ist,
wobei das kombinierte Sensor- und Heizelement (4) einen ersten Anschluss (5) und einen zweiten Anschluss (6) aufweist,
wobei der erste Anschluss (5) des kombinierten Sensor- und Heizelements (4) über einen ersten elektrischen Pfad (P1) mit wenigstens einer ersten Schalteinrichtung (S1, S3, S5) mit einem ersten Pol (V+) einer Spannungsquelle elektrisch verbindbar und von diesem elektrisch trennbar ist,
wobei der zweite Anschluss (6) des kombinierten Sensor- und Heizelements (4) über einen zweiten elektrischen Pfad (P2) mit wenigstens einer zweiten Schalteinrichtung (S2, S4, S6) mit einem zweiten Pol (GND) der Spannungsquelle elektrisch verbindbar und von diesem elektrisch trennbar ist,
wobei zum Betreiben des kombinierten Sensor- und Heizelements (4) als Sensorelement der erste Anschluss (5) des kombinierten Sensor- und Heizelements (4) durch Öffnen wenigstens einer Schalteinrichtung (S1, S3, S5) des ersten elektrischen Pfades (P1) vom ersten Pol (V+) der Spannungsquelle elektrisch trennbar ist und durch Öffnen wenigstens einer Schalteinrichtung (S2, S4, S6) des zweiten elektrischen Pfades (P2) der zweite Anschluss (6) des kombinierten Sensor- und Heizelements (4) vom zweiten Pol (GND) der Spannungsquelle trennbar ist,
wobei zum Betreiben des kombinierten Sensor- und Heizelements (4) als Heizelement der erste Anschluss (5) des kombinierten Sensor- und Heizelements durch Schließen aller Schalteinrichtungen (S1, S3, S5) des ersten elektrischen Pfades (P1) mit dem ersten Pol (V+) der Spannungsquelle elektrisch verbindbar ist und der zweite Anschluss (S6) des kombinierten Sensor- und Heizelements (4) durch Schließen aller Schalteinrichtungen (S2, S4, S6) des zweiten elektrischen Pfades (P2) mit dem zweiten Pol (GND) der Spannungsquelle elektrisch verbindbar ist, und
wobei die kombinierte Sensor- und Heizvorrichtung (10, 60, 70) ferner eine Synchronisierungseinrichtung (40) aufweist zur zumindest teilweisen Synchronisierung einer Ansteuerung von Sensoreinrichtung und Heizeinrichtung,
**dadurch gekennzeichnet, dass** die Synchronisierungseinrichtung (40) über wenigstens einen weiteren elektrischen Pfad (52) mit dem ersten elektrischen Pfad (P1) oder dem zweiten elektrischen Pfad (P2) elektrisch verbunden oder verbindbar ist und dazu ausgebildet und eingerichtet ist, zumindest zeitweise eine am ersten elektrischen Pfad (P1) zwischen dem ersten Pol (V+) der Spannungsquelle und dem ersten Anschluss (5) des kombinierten Sensor- und Heizelements (4) anliegende Ist-Spannung, insbesondere einen Ist-Spannungsverlauf über der Zeit, oder einen aktuellen Ist-Stromfluss entlang des ersten elektrisch Pfades, insbesondere einen Ist-Stromflussverlauf über der Zeit, zu erfassen und/oder eine am zweiten elektrischen Pfad (P2) zwischen dem zweiten Anschluss (6) des kombinierten Sensor- und Heizelements (4) und dem zweiten Pol (GND) anliegende Ist-Spannung, insbesondere einen Ist-Spannungsverlauf über der Zeit, und/oder einen aktuellen Ist-Stromfluss entlang des zweiten elektrisch Pfades (P2), insbesondere einen Ist-Stromflussverlauf über der Zeit, zu erfassen,
wobei die Synchronisierungseinrichtung (40) dazu ausgebildet und eingerichtet ist, in Abhängigkeit von der erfassten Ist-Spannung und/oder in Abhängigkeit von dem erfassten Ist-Stromfluss einen aktuellen Ist-Zustand der Heizeinrichtung zu erkennen oder zu bestimmen, und in Abhängigkeit von dem erkannten oder bestimmten Ist-Zustand der Heizeinrichtung wenigstens zumindest teilweise die Sensoreinrichtung anzusteuern und/oder wenigstens ein Steuersignal zur zumindest teilweisen Ansteuerung der Sensoreinrichtung auszugeben.

2. Kombinierte, kapazitive Sensor- und Heizvorrichtung (10, 60, 70) nach Anspruch 1, **dadurch gekennzeichnet, dass** die kombinierte, kapazitive Sensor- und Heizvorrichtung (10, 60, 70), insbesondere die Heizeinrichtung, dazu ausgebildet und eingerichtet ist, eine Heizleistung gepulst abzugeben, insbesondere eine gewünschte Heizleistung, vorzugsweise in Abhängigkeit von einer Anforderung, wobei dazu vorzugsweise ein gepulster Stromfluss durch das wenigstens eine kombinierte Sensor- und Heizelement (4) hindurchleitbar ist, wobei der gepulste Stromfluss insbesondere mittels einer Pulsweitenmodulation derart modulierbar ist, dass die gewünschte Heizleistung abgegeben wird.

3. Kombinierte, kapazitive Sensor- und Heizvorrichtung (10, 60, 70) nach Anspruch 2, **dadurch gekennzeichnet, dass** die kombinierte, kapazitive Sensor- und Heizvorrichtung (10, 60, 70), insbesondere die Sensoreinrichtung, dazu ausgebildet und eingerichtet ist, einen Sensorbetrieb, insbesondere eine oder mehrere kapazitive Messungen zum Erkennen einer Anwesenheit eines kapazitiv wirksamen Betätigungsmittels in einem Detektionsbereich der Sensoreinrichtung und/oder eine Diagnose der Sensoreinrichtung, zumindest teilweise zwischen zwei Heizleistungspulsen auszuführen, insbesondere vollständig.

4. Kombinierte, kapazitive Sensor- und Heizvorrichtung (10, 60, 70) nach einem der vorhergehenden Ansprüche, **dadurch gekennzeichnet, dass** der wenigstens eine weitere elektrische Pfad (52), über welchen die Synchronisierungseinrichtung (40) eine Ist-Spannung und/oder einen Ist-Stromfluss im ersten elektrischen Pfad (P1) oder im zweiten elektrischen Pfad (P2) erfassen kann, über einen sich zwischen der ersten Schalteinrichtung (S1) und dem ersten Anschluss (5) des kombinierten Sensor- und Heizelements (4) entlang des ersten elektrischen Pfades (P1) befindenden Synchronisierungs-Anschlussknoten (M1) elektrisch mit dem ersten elektrischen Pfad (P1) verbunden oder verbindbar ist und/oder über einen sich zwischen dem zweiten Anschluss (6) des kombinierten Sensor- und Heizelements (4) und der zweiten Schalteinrichtung (S2) entlang des zweiten elektrischen Pfades (P2) befindenden Synchronisierungs-Anschlussknoten (M2) mit dem zweiten elektrischen Pfad (P2).

5. Kombinierte, kapazitive Sensor- und Heizvorrichtung (10, 60, 70) nach einem der vorhergehenden Ansprüche, **dadurch gekennzeichnet, dass** die kombinierte Sensor- und Heizvorrichtung (10, 60, 70) ferner wenigstens eine Steuerungs- und Auswerteeinrichtung (20, 30) aufweist, insbesondere eine erste Steuerungs- und Auswerteinrichtung (30), die zur zumindest teilweisen Steuerung der Sensoreinrichtung der kombinierten, kapazitiven Sensor- und Heizvorrichtung (10, 60, 70) eingerichtet ist, insbesondere zur Steuerung eines Betriebs des kombinierten Sensor- und Heizelementes (4) als Sensorelement, und eine Steuerungs- und Auswerteeinrichtung (20), die zur zumindest teilweisen Steuerung der Heizeinrichtung der kombinierten, kapazitiven Sensor- und Heizvorrichtung (10, 60, 70) eingerichtet ist, insbesondere eine zweite Steuerungs- und Auswertungseinrichtung, insbesondere zur Steuerung eines Betriebs des Sensor- und Heizelementes (4) als Heizelement, wobei die zweite Steuerungs- und Auswerteinrichtung (20) insbesondere separat von der ersten Steuerungs- und Auswertungseinrichtung (30) ausgebildet ist.

6. Kombinierte, kapazitive Sensor- und Heizvorrichtung (10, 60, 70) nach einem der vorhergehenden Ansprüche, **dadurch gekennzeichnet, dass** die kombinierte Sensor- und Heizvorrichtung (10, 60, 70) zur Integration in eine Lenkeingabevorrichtungs-Baugruppe (100, 200, 300) eines Kraftfahrzeugs mit einem lenkradseitigen Teil (1) und einem fahrzeugaufbauseitigen Teil (2) ausgebildet und eingerichtet ist,
wobei die kombinierte Sensor- und Heizvorrichtung (10, 60, 70) eine erste Baugruppe (11) aufweist, welche zur Integration im fahrzeugaufbauseitigen Teil (2) einer Lenkeingabevorrichtungs-Baugruppe (100, 200, 300) ausgebildet und eingerichtet ist, und eine zweite Baugruppe (12), welche zur Integration im lenkradseitigen Teil (1) einer Lenkeingabevorrichtungs-Baugruppe (100, 200, 300) ausgebildet und eingerichtet ist, und
wobei einige Teile der kombinierten Sensor- und Heizvorrichtung (10, 60, 70) der ersten Baugruppe (11) zugeordnet sind und andere Teile der zweiten Baugruppe (12).

7. Kombinierte, kapazitive Sensor- und Heizvorrichtung (10, 60, 70) nach Anspruch 6, **dadurch gekennzeichnet, dass** die erste Baugruppe (11) und die zweite Baugruppe (12) über eine elektrische Verbindungseinrichtung (13) elektrisch miteinander verbunden sind, wobei die elektrische Verbindungseinrichtung (13) insbesondere eine Wickelfeder aufweist oder eine Wickelfeder ist.

8. Kombinierte, kapazitive Sensor- und Heizvorrichtung (10, 60, 70) nach Anspruch 5 in Verbindung mit einem der Ansprüche 6 oder 7, **dadurch gekennzeichnet, dass** die Steuerungs- und Auswerteeinrichtung (30), die zur zumindest teilweisen Steuerung der Sensoreinrichtung ausgebildet und eingerichtet ist, insbesondere die erste Steuerungs- und Auswerteinrichtung (30), der zweiten Baugruppe (12) zugeordnet ist und vorzugsweise die Steuerungs- und Auswerteeinrichtung (20), die zur zumindest teilweisen Steuerung der Heizeinrichtung ausgebildet und eingerichtet ist, insbesondere die zweite Steuerungs- und Auswerteinrichtung (20), der ersten Baugruppe (11) zugeordnet ist.

9. Kombinierte, kapazitive Sensor- und Heizvorrichtung (10, 60, 70) nach einem der Ansprüche 6 bis 8, **dadurch gekennzeichnet, dass** die Synchronisierungseinrichtung (40) Teil der zweiten Baugruppe (12) ist.

10. Kombinierte, kapazitive Sensor- und Heizvorrichtung (10, 60, 70) nach einem der Ansprüche 5 bis 9, **dadurch gekennzeichnet, dass** die Steuerungs- und Auswertungseinrichtung (20), die zur zumindest teilweisen Steuerung der der Heizeinrichtung ausgebildet ist, zur Steuerung der ersten Schalteinrichtung (S1) und/oder der zweiten Schalteinrichtung (S2) ausgebildet ist, wobei die erste Schalteinrichtung (S1) und/oder die zweite Schalteinrichtung (S2) vorzugsweise ebenfalls Teile der ersten Baugruppe (11) sind.

11. Kombinierte, kapazitive Sensor- und Heizvorrichtung (10, 60, 70) nach einem der vorhergehenden Ansprüche, **dadurch gekennzeichnet, dass** die Synchronisierungseinrichtung (40) dazu ausgebildet und eingerichtet ist, in Abhängigkeit von der erfassten Ist-Spannung, insbesondere in Abhängigkeit von einem erfassten Ist-Spannungsverlauf über der Zeit, und/oder in Abhängigkeit von einem erfassten Ist-Stromfluss, insbesondere in Abhängigkeit von dem erfassten Ist-Stromfluss über der Zeit, wenigstens einen Einschalt-Zustand und/oder einen Heiz-Zustand und/oder einen Abschalt-Zustand und/oder einen Aus-Zustand als Ist-Zustand der Heizeinrichtung zu erkennen oder zu bestimmen,
wobei die Synchronisierungseinrichtung (40) vorzugsweise derart ausgebildet und eingerichtet ist, dass
ein Einschalt-Zustand als aktueller Ist-Zustand der Heizeinrichtung erkannt oder bestimmt wird, wenn eine steigende Ist-Spannung und/oder ein steigender Ist-Spannungsverlauf und/oder ein steigender Ist-Stromfluss oder ein steigender Ist-Stromflussverlauf erfasst wird, insbesondere eine steigende Flanke eines Heizleistungspulses, und/oder
ein Heiz-Zustand als aktueller Ist-Zustand der Heizeinrichtung erkannt oder bestimmt wird, wenn eine von einer Nullspannung (0V) verschiedene, konstante Ist-Spannung und/oder ein von einer Nullspannung (0V) verschiedener, konstanter Ist-Spannungsverlauf und/oder ein von einem Nullstrom (0A) verschiedener, konstanter Ist-Stromfluss oder ein von einem Nullstrom (0A) verschiedener, konstanter Ist-Stromflussverlauf erfasst wird, insbesondere eine konstantes Plateau eines Heizleistungspulses, und/oder
ein Abschalt-Zustand als aktueller Ist-Zustand der Heizeinrichtung erkannt oder bestimmt wird, wenn eine fallende Ist-Spannung und/oder ein fallender Ist-Spannungsverlauf und/oder ein fallender Ist-Stromfluss oder ein fallender Ist-Stromflussverlauf erfasst wird, insbesondere eine fallende Flanke eines Heizleistungspulses, und/oder
ein Aus-Zustand als aktueller Ist-Zustand der Heizeinrichtung erkannt oder bestimmt wird, wenn eine Nullspannung (0V) als konstante Ist-Spannung und/oder ein konstanter Nullspannungsverlauf als Ist-Spannungsverlauf und/oder ein Nullstrom als konstanter Ist-Stromfluss oder ein konstanter Nullstromverlauf als Ist-Stromflussverlauf erfasst wird, insbesondere eine konstantes Null-Plateau eines Heizleistungspulses.

12. Kombinierte, kapazitive Sensor- und Heizvorrichtung (10, 60, 70) nach Anspruch 11, **dadurch gekennzeichnet, dass** die Synchronisierungseinrichtung (40) dazu ausgebildet und eingerichtet ist, wenn ein Abschalt-Zustand oder ein Aus-Zustand oder ein Einschalt-Zustand der Heizeinrichtung erkannt worden ist, einen Sensorbetrieb des kombinierten Sensor- und Heizelements (4) auszulösen, insbesondere unmittelbar oder mit einer definierten, zeitlichen Verzögerung.

13. Kombinierte, kapazitive Sensor- und Heizvorrichtung (10, 60, 70) nach einem der vorhergehenden Ansprüche, **dadurch gekennzeichnet, dass** die Sensor- und Heizvorrichtung (10, 60, 70) dazu ausgebildet und eingerichtet ist, nach Beendigung einer kapazitiven Messung den Sensorbetrieb unmittelbar zu beenden und/oder nach Ablauf einer definierten Zeit, insbesondere unmittelbar nach Ablauf der definierten Zeit, wobei die Sensor- und Heizvorrichtung (10, 60, 70) vorzugsweise dazu ausgebildet und eingerichtet ist, nach Beendigung des Sensorbetriebs in den Heizbetrieb zu wechseln.

14. Verfahren zum Betrieb einer kombinierten Sensor- und Heizvorrichtung (10, 60, 70), die nach einem der Ansprüche 1 bis 13 ausgebildet ist, wobei die kapazitive Sensor- und Heizvorrichtung (10, 60, 70) wahlweise, insbesondere wechselweise, als Heizeinrichtung oder als Sensoreinrichtung betrieben wird,
wobei zum Betreiben der Sensor- und Heizvorrichtung (10, 60, 70) als Heizeinrichtung das kombinierte Sensor- und Heizelement (4) als elektrisches Heizelement betrieben wird,
wobei zum Einschalten der Heizeinrichtung sämtliche Schalteinrichtungen (S1, S3, S5) entlang des ersten elektrischen Pfades (P1) und sämtliche Schalteinrichtungen (S2, S4, S6) entlang des zweiten elektrischen Pfades (P2) geschlossen werden und zum Abschalten der Heizeinrichtung wenigstens eine Schalteinrichtung (S1, S3, S5) entlang des ersten elektrischen Pfades (P1) und wenigstens eine Schalteinrichtung (S2, S4, S6) entlang des zweiten elektrischen Pfades (P2) geöffnet werden,
wobei zum Betreiben der Sensor- und Heizvorrichtung (10, 60, 70) als Sensoreinrichtung das kombinierte Sensor- und Heizelement (4) als kapazitive Sensorelektrode betrieben wird und wenigstens eine Schalteinrichtung (S1, S3, S5) des ersten elektrischen Pfades (P1) und wenigstens eine Schalteinrichtung (S2, S4, S6) des zweiten elektrischen Pfades (P2) geöffnet werden,
**dadurch gekennzeichnet, dass**
eine am ersten elektrischen Pfad (P1) zwischen dem ersten Pol 8V+) der Spannungsquelle und dem ersten Anschluss (5) des kombinierten Sensor- und Heizelements (4) anliegende Ist-Spannung, insbesondere ein Ist-Spannungsverlauf über der Zeit, und/oder ein aktueller Ist-Stromfluss, insbesondere ein Ist-Stromflussverlauf über der Zeit, entlang des ersten elektrisch Pfades (P1) erfasst wird, und/oder
eine am zweiten elektrischen Pfad (P2) zwischen dem zweiten Anschluss (6) des kombinierten Sensor- und Heizelements (4) und dem zweiten Pol (GND) anliegende Ist-Spannung, insbesondere ein Ist-Spannungsverlauf über der Zeit, und/oder ein aktueller Ist-Stromfluss, insbesondere ein Ist-Stromflussverlauf über der Zeit, entlang des zweiten elektrisch Pfades (P2) erfasst wird,
wobei in Abhängigkeit von der erfassten Ist-Spannung und/oder dem erfassten Ist-Stromfluss ein aktueller Ist-Zustand der Heizeinrichtung bestimmt wird und in Abhängigkeit von dem bestimmten Ist-Zustand der Heizeinrichtung die Sensoreinrichtung wenigstens zumindest teilweise angesteuert wird und/oder wenigstens ein Steuersignal zur zumindest teilweisen Ansteuerung der Sensoreinrichtung ausgegeben wird.

15. Verfahren nach Anspruch 14, **dadurch gekennzeichnet, dass**, wenn als Ist-Zustand der Heizeinrichtung ein Abschalt-Zustand oder ein Einschalt-Zustand der Heizeinrichtung erkannt oder bestimmt worden ist, einen Sensorbetrieb des kombinierten Sensor- und Heizelements (4) ausgelöst wird, insbesondere unmittelbar oder mit einer definierten zeitlichen Verzögerung.

16. Lenkeingabevorrichtungs-Baugruppe (100, 200, 300), insbesondere Lenkeingabevorrichtungs-Baugruppe (100, 200, 300), für ein Fahrzeug mit einem lenkradseitigen Teil (1), der insbesondere wenigstens ein Lenkradmodul aufweist, insbesondere ein Lenkrad (3) mit einem Lenkradmodul, und einem fahrzeugaufbauseitigen Teil (2), insbesondere einem Lenksäulenmodul,
wobei der lenkradseitige Teil (1) der Lenkeingabevorrichtungs-Baugruppe (100, 200, 300) in einem funktionsgemäßen Einbauzustand der Lenkeingabevorrichtungs-Baugruppe (100, 200, 300) in einem Fahrzeug relativ gegenüber dem fahrzeugaufbauseitigen Teil (2) bewegbar ist, insbesondere drehbar gegenüber dem fahrzeugaufbauseitigen Teil (2), insbesondere um eine Drehachse einer Lenkwelle, und wobei die Lenkeingabevorrichtungs-Baugruppe (100, 200, 300) eine kombinierte, kapazitive Sensor- und Heizvorrichtung (10, 60, 70) aufweist,
**dadurch gekennzeichnet, dass** die kombinierte, kapazitive Sensor- und Heizvorrichtung (10, 60, 70) nach einem der Ansprüche 1 bis 13 ausgebildet ist.

17. Fahrzeug mit einer Lenkeingabevorrichtungs-Baugruppe (100, 200, 300), **dadurch gekennzeichnet, dass** die Lenkeingabevorrichtungs-Baugruppe (100, 200, 300) nach Anspruch 16 ausgebildet ist, wobei der lenkradseitige Teil (1) relativ gegenüber dem fahrzeugaufbauseitigen Teil (2) bewegbar ist, insbesondere drehbar gegenüber dem fahrzeugaufbauseitigen Teil (2), insbesondere um eine Drehachse einer Lenkwelle.

## Claims

1. Combined capacitive sensor and heating apparatus (10, 60, 70) having a capacitive sensor device for detecting the presence of a capacitively effective actuation means in a detection region of the sensor device, in particular for detecting the presence of a human hand in a gripping region of a steering input apparatus (3), and having a heating device, in particular having a heating device for a steering input apparatus (3) of a vehicle,
wherein the combined capacitive sensor and heating apparatus (10, 60, 70) has at least one electrical combined sensor and heating element (4) which can be used both as a capacitive sensor element by the sensor device and as an electrical heating element by the heating device,
wherein the combined sensor and heating element (4) has a first connection (5) and a second connection (6),
wherein the first connection (5) of the combined sensor and heating element (4) can be electrically connected to and electrically disconnected from a first pole (V+) of a voltage source via a first electrical path (P1) having at least one first switching device (S1, S3, S5),
wherein the second connection (6) of the combined sensor and heating element (4) can be electrically connected to and electrically disconnected from a second pole (GND) of the voltage source via a second electrical path (P2) having at least one second switching device (S2, S4, S6),
wherein, in order to operate the combined sensor and heating element (4) as a sensor element, the first connection (5) of the combined sensor and heating element (4) can be electrically disconnected from the first pole (V+) of the voltage source by opening at least one switching device (S1, S3, S5) of the first electrical path (P1), and the second connection (6) of the combined sensor and heating element (4) can be disconnected from the second pole (GND) of the voltage source by opening at least one switching device (S2, S4, S6) of the second electrical path (P2),
wherein, in order to operate the combined sensor and heating element (4) as a heating element, the first connection (5) of the combined sensor and heating element can be electrically connected to the first pole (V+) of the voltage source by closing all switching devices (S1, S3, S5) of the first electrical path (P1), and the second connection (S6) of the combined sensor and heating element (4) can be electrically connected to the second pole (GND) of the voltage source by closing all switching devices (S2, S4, S6) of the second electrical path (P2), and
wherein the combined sensor and heating apparatus (10, 60, 70) also has a synchronization device (40) for at least partially synchronizing control of the sensor device and heating device,
**characterized in that** the synchronization device (40) is or can be electrically connected to the first electrical path (P1) or to the second electrical path (P2) via at least one further electrical path (52) and is designed and configured to capture, at least occasionally, an actual voltage applied to the first electrical path (P1) between the first pole (V+) of the voltage source and the first connection (5) of the combined sensor and heating element (4), in particular an actual voltage profile over time, or an instantaneous actual current flow along the first electrical path, in particular an actual current flow profile over time, and/or to capture an actual voltage applied to the second electrical path (P2) between the second connection (6) of the combined sensor and heating element (4) and the second pole (GND), in particular an actual voltage profile over time, and/or an instantaneous actual current flow along the second electrical path (P2), in particular an actual current flow profile over time,
wherein the synchronization device (40) is designed and configured to detect or determine an instantaneous actual state of the heating device on the basis of the captured actual voltage and/or on the basis of the captured actual current flow, and at least to at least partially control the sensor device and/or output at least one control signal for at least partially controlling the sensor device on the basis of the detected or determined actual state of the heating device.

2. Combined capacitive sensor and heating apparatus (10, 60, 70) according to Claim 1, **characterized in that** the combined capacitive sensor and heating apparatus (10, 60, 70), in particular the heating device, is designed and configured to output a heating power, in particular a desired heating power, in a pulsed manner, preferably on the basis of a requirement, wherein a pulsed current flow can preferably be guided through the at least one combined sensor and heating element (4) for this purpose, wherein the pulsed current flow can be modulated, in particular, by means of pulse width modulation in such a manner that the desired heating power is output.

3. Combined capacitive sensor and heating apparatus (10, 60, 70) according to Claim 2, **characterized in that** the combined capacitive sensor and heating apparatus (10, 60, 70), in particular the sensor device, is designed and configured to carry out sensor operation, in particular one or more capacitive measurements for detecting the presence of a capacitively effective actuation means in a detection region of the sensor device and/or a diagnosis of the sensor device, at least partially, in particular completely, between two heating power pulses.

4. Combined capacitive sensor and heating apparatus (10, 60, 70) according to one of the preceding claims, **characterized in that** the at least one further electrical path (52), via which the synchronization device (40) can capture an actual voltage and/or an actual current flow in the first electrical path (P1) or in the second electrical path (P2), is or can be electrically connected to the first electrical path (P1) via a synchronization connection node (M1) situated along the first electrical path (P1) between the first switching device (S1) and the first connection (5) of the combined sensor and heating element (4) and/or to the second electrical path (P2) via a synchronization connection node (M2) situated along the second electrical path (P2) between the second connection (6) of the combined sensor and heating element (4) and the second switching device (S2).

5. Combined capacitive sensor and heating apparatus (10, 60, 70) according to one of the preceding claims, **characterized in that** the combined sensor and heating apparatus (10, 60, 70) also has at least one control and evaluation device (20, 30), in particular a first control and evaluation device (30), which is configured to at least partially control the sensor device of the combined capacitive sensor and heating apparatus (10, 60, 70), in particular to control operation of the combined sensor and heating element (4) as a sensor element, and a control and evaluation device (20) which is configured to at least partially control the heating device of the combined capacitive sensor and heating apparatus (10, 60, 70), in particular a second control and evaluation device, in particular for controlling operation of the sensor and heating element (4) as a heating element, wherein the second control and evaluation device (20) is, in particular, separate from the first control and evaluation device (30).

6. Combined capacitive sensor and heating apparatus (10, 60, 70) according to one of the preceding claims, **characterized in that** the combined sensor and heating apparatus (10, 60, 70) is designed and configured for integration in a steering input apparatus assembly (100, 200, 300) of a motor vehicle having a part (1) on the steering wheel side and a part (2) on the vehicle body side,
wherein the combined sensor and heating apparatus (10, 60, 70) has a first assembly (11) which is designed and configured for integration **in that** part (2) of a steering input apparatus assembly (100, 200, 300) which is on the vehicle body side, and a second assembly (12) which is designed and configured for integration **in that** part (1) of a steering input apparatus assembly (100, 200, 300) which is on the steering wheel side, and
wherein some parts of the combined sensor and heating apparatus (10, 60, 70) are assigned to the first assembly (11) and other parts are assigned to the second assembly (12).

7. Combined capacitive sensor and heating apparatus (10, 60, 70) according to Claim 6, **characterized in that** the first assembly (11) and the second assembly (12) are electrically connected to one another via an electrical connecting device (13), wherein the electrical connecting device (13) has a coil spring, in particular, or is a coil spring.

8. Combined capacitive sensor and heating apparatus (10, 60, 70) according to Claim 5 in conjunction with either of Claims 6 and 7, **characterized in that** the control and evaluation device (30) which is designed and configured to at least partially control the sensor device, in particular the first control and evaluation device (30), is assigned to the second assembly (12), and the control and evaluation device (20) which is designed and configured to at least partially control the heating device, in particular the second control and evaluation device (20), is preferably assigned to the first assembly (11) .

9. Combined capacitive sensor and heating apparatus (10, 60, 70) according to one of Claims 6 to 8, **characterized in that** the synchronization device (40) is part of the second assembly (12).

10. Combined capacitive sensor and heating apparatus (10, 60, 70) according to one of Claims 5 to 9, **characterized in that** the control and evaluation device (20) which is designed to at least partially control the heating device is designed to control the first switching device (S1) and/or the second switching device (S2), wherein the first switching device (S1) and/or the second switching device (S2) is/are preferably likewise parts of the first assembly (11).

11. Combined capacitive sensor and heating apparatus (10, 60, 70) according to one of the preceding claims, **characterized in that** the synchronization device (40) is designed and configured to detect or determine at least a switched-on state and/or a heating state and/or a switched-off state and/or an off state as the actual state of the heating device on the basis of the captured actual voltage, in particular on the basis of a captured actual voltage profile over time, and/or on the basis of a captured actual current flow, in particular on the basis of the captured actual current flow over time,
wherein the synchronization device (40) is preferably designed and configured in such a manner that
a switched-on state is detected or determined as the instantaneous actual state of the heating device if a rising actual voltage and/or a rising actual voltage profile and/or a rising actual current flow or a rising actual current flow profile, in particular a rising edge of a heating power pulse, is/are captured, and/or
a heating state is detected or determined as the instantaneous actual state of the heating device if a constant actual voltage that differs from a zero voltage (0 V) and/or a constant actual voltage profile that differs from a zero voltage (0 V) and/or a constant actual current flow that differs from a zero current (0 A) or a constant actual current flow profile that differs from a zero current (0 A), in particular a constant plateau of a heating power pulse, is/are captured, and/or
a switched-off state is detected or determined as the instantaneous actual state of the heating device if a falling actual voltage and/or a falling actual voltage profile and/or a falling actual current flow or a falling actual current flow profile, in particular a falling edge of a heating power pulse, is/are captured, and/or
an off state is detected or determined as the instantaneous actual state of the heating device if a zero voltage (0 V) is captured as a constant actual voltage and/or a constant zero voltage profile is captured as an actual voltage profile and/or a zero current is captured as a constant actual current flow or a constant zero current profile is captured as an actual current flow profile, in particular a constant zero plateau of a heating power pulse.

12. Combined capacitive sensor and heating apparatus (10, 60, 70) according to Claim 11, **characterized in that** the synchronization device (40) is designed and configured to initiate sensor operation of the combined sensor and heating element (4), in particular immediately or with a defined time delay, if a switched-off state or an off state or a switched-on state of the heating device has been detected.

13. Combined capacitive sensor and heating apparatus (10, 60, 70) according to one of the preceding claims, **characterized in that** the sensor and heating apparatus (10, 60, 70) is designed and configured to terminate sensor operation immediately and/or after expiry of a defined time, in particular immediately after expiry of the defined time, after completion of a capacitive measurement, wherein the sensor and heating apparatus (10, 60, 70) is preferably designed and configured to change to heating operation after termination of sensor operation.

14. Method for operating a combined sensor and heating apparatus (10, 60, 70) designed according to one of Claims 1 to 13, wherein the capacitive sensor and heating apparatus (10, 60, 70) is operated selectively, in particular alternately, as a heating device or as a sensor device,
wherein, in order to operate the sensor and heating apparatus (10, 60, 70) as a heating device, the combined sensor and heating element (4) is operated as an electrical heating element,
wherein, in order to switch on the heating device, all switching devices (S1, S3, S5) along the first electrical path (P1) and all switching devices (S2, S4, S6) along the second electrical path (P2) are closed and, in order to switch off the heating device, at least one switching device (S1, S3, S5) along the first electrical path (P1) and at least one switching device (S2, S4, S6) along the second electrical path (P2) are opened,
wherein, in order to operate the sensor and heating apparatus (10, 60, 70) as a sensor device, the combined sensor and heating element (4) is operated as a capacitive sensor electrode and at least one switching device (S1, S3, S5) of the first electrical path (P1) and at least one switching device (S2, S4, S6) of the second electrical path (P2) are opened,
**characterized in that**
an actual voltage applied to the first electrical path (P1) between the first pole (V+) of the voltage source and the first connection (5) of the combined sensor and heating element (4), in particular an actual voltage profile over time, and/or an instantaneous actual current flow, in particular an actual current flow profile over time, is/are captured along the first electrical path (P1), and/or
an actual voltage applied to the second electrical path (P2) between the second connection (6) of the combined sensor and heating element (4) and the second pole (GND), in particular an actual voltage profile over time, and/or an instantaneous actual current flow, in particular an actual current flow profile over time, is/are captured along the second electrical path (P2),
wherein an instantaneous actual state of the heating device is determined on the basis of the captured actual voltage and/or the captured actual current flow, and the sensor device is at least controlled at least partially and/or at least one control signal for at least partially controlling the sensor device is output on the basis of the determined actual state of the heating device.

15. Method according to Claim 14, **characterized in that** sensor operation of the combined sensor and heating element (4) is initiated, in particular immediately or with a defined time delay, if a switched-off state or a switched-on state of the heating device has been detected or determined as the actual state of the heating device.

16. Steering input apparatus assembly (100, 200, 300), in particular steering input apparatus assembly (100, 200, 300) for a vehicle having a part (1) which is on the steering wheel side and has in particular at least one steering wheel module, in particular a steering wheel (3) having a steering wheel module, and a part (2) on the vehicle body side, in particular a steering column module,
wherein, in a functional installation state of the steering input apparatus assembly (100, 200, 300) in a vehicle, that part (1) of the steering input apparatus assembly (100, 200, 300) which is on the steering wheel side can be moved relative to the part (2) on the vehicle body side, in particular can be rotated with respect to the part (2) on the vehicle body side, in particular about an axis of rotation of a steering shaft, and wherein the steering input apparatus assembly (100, 200, 300) has a combined capacitive sensor and heating apparatus (10, 60, 70),
**characterized in that** the combined capacitive sensor and heating apparatus (10, 60, 70) is designed according to one of Claims 1 to 13.

17. Vehicle having a steering input apparatus assembly (100, 200, 300), **characterized in that** the steering input apparatus assembly (100, 200, 300) is designed according to Claim 16, wherein the part (1) on the steering wheel side can be moved relative to the part (2) on the vehicle body side, in particular can be rotated with respect to the part (2) on the vehicle body side, in particular about an axis of rotation of a steering shaft.

## Revendications

1. Dispositif combiné de chauffage et de détection capacitive (10, 60, 70) comprenant un module de détection capacitive destiné à détecter la présence d'un moyen d'actionnement à effet capacitif dans une zone de détection du module de détection, en particulier pour détecter la présence d'une main humaine dans une zone de préhension d'un dispositif d'entrée de direction (3), et un module de chauffage, en particulier un module de chauffage destiné à un dispositif d'entrée de direction (3) d'un véhicule,
le dispositif combiné de chauffage et de détection capacitive (10, 60, 70) comporte au moins un élément combiné de chauffage et de détection électrique (4), qui peut être utilisé aussi bien par le module de détection comme élément de détection capacitive et par le module de chauffage comme élément de chauffage électrique,
l'élément combiné de chauffage et de détection (4) comportant une première borne (5) et une deuxième borne (6),
la première borne (5) de l'élément combiné de chauffage et de détection (4) pouvant être reliée électriquement à un premier pôle (V+) d'une source de tension par le biais d'un premier chemin électrique (P1) comprenant au moins un premier module de commutation (S1, S3, S5) et pouvant être séparée électriquement dudit premier pôle,
la deuxième borne (6) de l'élément combiné de chauffage et de détection (4) pouvant être reliée électriquement à un deuxième pôle (GND) de la source de tension par le biais d'un deuxième chemin électrique (P2) comprenant au moins un deuxième module de commutation (S2, S4, S6) et pouvant être séparée électriquement dudit deuxième pôle,
pour faire fonctionner l'élément combiné de chauffage et de détection (4) comme élément de détection, la première borne (5) de l'élément combiné de chauffage et de détection (4) pouvant être séparée électriquement du premier pôle (V+) de la source de tension par ouverture d'au moins un module de commutation (S1, S3, S5) du premier chemin électrique (P1) et la deuxième borne (6) de l'élément combiné de chauffage et de détection (4) pouvant être séparée du deuxième pôle (GND) de la source de tension par ouverture d'au moins un module de commutation (S2, S4, S6) du deuxième chemin électrique (P2),
pour faire fonctionner l'élément combiné de chauffage et de détection (4) comme élément de chauffage, la première borne (5) de l'élément combiné de chauffage et de détection pouvant être reliée électriquement au premier pôle (V+) de la source de tension par fermeture de tous les modules de commutation (S1, S3, S5) du premier chemin électrique (P1) et la deuxième borne (S6) de l'élément combiné de chauffage et de détection (4) pouvant être reliée électriquement au deuxième pôle (GND) de la source de tension par fermeture de tous les modules de commutation (S2, S4, S6) du deuxième chemin électrique (P2), et
le dispositif combiné de chauffage et de détection (10, 60, 70) comportant en outre un module de synchronisation (40) destiné à synchroniser au moins partiellement une activation du module de détection et du module de chauffage,
**caractérisé en ce que** le module de synchronisation (40) est ou peut être relié électriquement au premier chemin électrique (P1) ou au deuxième chemin électrique (P2) par le biais d'au moins un autre chemin électrique (52) et étant conçu et adapté pour détecter au moins temporairement une tension réelle, en particulier une variation de tension réelle dans le temps, ou un courant réel actuel le long du premier chemin électrique, en particulier une variation de courant réel dans le temps, lesquels sont appliqués à un premier chemin électrique (P1) entre le premier pôle (V+) de la source de tension et la première borne (5) de l'élément combiné de chauffage et de détection (4) et/ou pour détecter une tension réelle, en particulier une variation de tension réelle dans le temps, et/ou un courant réel actuel le long du premier chemin électrique, en particulier une variation de courant réel dans le temps, lesquels sont appliqués à un deuxième chemin électrique (P2) entre la deuxième borne (6) de l'élément combiné de chauffage et de détection (4) et le deuxième pôle (GND) de la source de tension,
le module de synchronisation (40) étant conçu et adapté pour détecter ou déterminer un état réel actuel du module de chauffage en fonction de la tension réelle détectée et/ou en fonction du courant réel détecté et, en fonction de l'état réel détecté ou déterminé du module de chauffage, pour activer au moins partiellement le module de détection et/ou pour délivrer au moins un signal de commande destiné à activer au moins partiellement le module de détection.

2. Dispositif combiné de chauffage et de détection capacitive (10, 60, 70) selon la revendication 1, **caractérisé en ce que** le dispositif combiné de chauffage et de détection capacitive (10, 60, 70), en particulier le module de chauffage, est conçu et adapté pour délivrer de manière pulsée une puissance de chauffage, notamment une puissance de chauffage souhaitée, de préférence en fonction d'un besoin, de préférence un courant pulsé pouvant pour cela être mis en circulation à travers l'au moins un élément combiné de chauffage et de détection (4), le courant pulsé pouvant être modulé en particulier au moyen d'une modulation de largeur d'impulsion de manière à délivrer la puissance de chauffage souhaitée.

3. Dispositif combiné de chauffage et de détection capacitive (10, 60, 70) selon la revendication 2, **caractérisé en ce que** le dispositif combiné de chauffage et de détection capacitive (10, 60, 70), en particulier le module de détection, est conçu et adapté pour réaliser un mode de détection, notamment une ou plusieurs mesures capacitives destinées à détecter la présence d'un moyen d'actionnement à effet capacitif dans une zone de détection du module de détection et/ou un diagnostic du module de détection, au moins partiellement, notamment complètement, entre deux impulsions de puissance de chauffage.

4. Dispositif combiné de chauffage et de détection capacitive (10, 60, 70) selon l'une des revendications précédentes, **caractérisé en ce que** l'au moins un autre chemin électrique (52), par lequel le module de synchronisation (40) peut détecter une tension réelle et/ou un courant réel dans le premier chemin électrique (P1) ou dans le deuxième chemin électrique (P2), est ou peut être relié électriquement au premier chemin électrique (P1) par le biais d'un noeud de borne de synchronisation (M1) situé le long du premier chemin électrique (P1) entre le premier module de commutation (S1) et la première borne (5) de l'élément combiné de chauffage et de détection (4) et/ou au deuxième chemin électrique (P2) par le biais d'un noeud de borne de synchronisation (M2) situé le long du deuxième chemin électrique (P2) entre la deuxième borne (6) de l'élément combiné de chauffage et de détection (4) et le deuxième module de commutation (S2).

5. Dispositif combiné de chauffage et de détection capacitive (10, 60, 70) selon l'une des revendications précédentes, **caractérisé en ce que** le dispositif combiné de chauffage et de détection capacitive (10, 60, 70) comporte en outre au moins un module de commande et d'évaluation (20, 30), en particulier un premier module de commande et d'évaluation (30), qui est adapté pour commander au moins partiellement le module de détection du dispositif combiné de chauffage et de détection capacitive (10, 60, 70), en particulier pour commander un fonctionnement de l'élément combiné de chauffage et de détection (4) comme élément de détection, et un module de commande et d'évaluation (20) qui est adapté pour commander au moins partiellement le module de chauffage du dispositif combiné de chauffage et de détection capacitive (10, 60, 70), en particulier un deuxième module de commande et d'évaluation, en particulier pour commander un fonctionnement de l'élément de chauffage et de détection (4) comme élément de chauffage, le deuxième module de commande et d'évaluation (20) étant en particulier conçu séparément du premier module de commande et d'évaluation (30).

6. Dispositif combiné de chauffage et de détection capacitive (10, 60, 70) selon l'une des revendications précédentes, **caractérisé en ce que** le dispositif combiné de chauffage et de détection capacitive (10, 60, 70) est conçu et adapté pour être intégré dans un ensemble de dispositif d'entrée de direction (100, 200, 300) d'un véhicule automobile comprenant une partie côté volant (1) et une partie côté carrosserie (2) du véhicule,
le dispositif combiné de chauffage et de détection capacitive (10, 60, 70) comportant un premier ensemble (11) qui est conçu et adapté pour être intégré dans la partie côté carrosserie (2) d'un ensemble de dispositif d'entrée de direction (100, 200, 300), et un deuxième ensemble (12) qui est conçu et adapté pour être intégré dans la partie côté volant (1) d'un ensemble de dispositif d'entrée de direction (100, 200, 300), et
certaines parties du dispositif combiné de chauffage et de détection capacitive (10, 60, 70) étant associées au premier ensemble (11) et d'autres parties étant associées au deuxième ensemble (12).

7. Dispositif combiné de chauffage et de détection capacitive (10, 60, 70) selon la revendication 6, **caractérisé en ce que** le premier ensemble (11) et le deuxième ensemble (12) sont reliés électriquement l'un à l'autre par le biais d'un module de liaison électrique (13), le module de liaison électrique (13) comportant notamment un ressort hélicoïdal ou étant un ressort hélicoïdal.

8. Dispositif combiné de chauffage et de détection capacitive (10, 60, 70) selon la revendication 5 en liaison avec l'une des revendications 6 et 7, **caractérisé en ce que** le module de commande et d'évaluation (30) est conçu et adapté pour commander au moins partiellement le module de détection, en particulier le premier module de commande et d'évaluation (30) est associé au deuxième ensemble (12) et de préférence le module de commande et d'évaluation (20), qui est conçu et adapté pour commander au moins partiellement le module de chauffage, en particulier le deuxième module de commande et d'évaluation (20), est associé au premier ensemble (11).

9. Dispositif combiné de chauffage et de détection capacitive (10, 60, 70) selon l'une des revendications 6 à 8, **caractérisé en ce que** le module de synchronisation (40) fait partie du deuxième ensemble (12) .

10. Dispositif combiné de chauffage et de détection capacitive (10, 60, 70) selon l'une des revendications 5 à 9, **caractérisé en ce que** le module de commande et d'évaluation (20), qui est conçu pour commander au moins partiellement le module de chauffage, est conçu pour commander le premier module de commutation (S1) et/ou le deuxième module de commutation (S2), le premier module de commutation (S1) et/ou le deuxième module de commutation (S2) faisant de préférence également partie du premier ensemble (11).

11. Dispositif combiné de chauffage et de détection capacitive (10, 60, 70) selon l'une des revendications précédentes, **caractérisé en ce que** le module de synchronisation (40) est conçu et adapté pour détecter ou déterminer, en fonction de la tension réelle détectée, notamment en fonction d'une variation de tension réelle détectée dans le temps, et/ou en fonction d'un courant réel détecté, en particulier en fonction de la variation de courant réel détecté dans le temps, au moins un état activé et/ou un état de chauffage et/ou un état désactivé et/ou un état d'arrêt comme état réel du module de chauffage,
le module de synchronisation (40) étant de préférence conçu et adapté de manière à ce que
un état activé est détecté ou déterminé comme état réel actuel du module de chauffage lorsqu'une tension réelle croissante et/ou une variation de tension réelle croissante et/ou un courant réel croissant ou une variation de courant réel croissante sont détectés, dans notamment un flanc montant d'une impulsion de puissance de chauffage, et/ou
un état de chauffage est détecté ou déterminé comme état réel actuel du module de chauffage lorsqu'une tension réelle constante différente d'une tension nulle (0V) et/ou une variation de tension réelle constante différente de la tension nulle (0V) et/ou un courant réel constant différent du courant nul (0A) ou une variation de courant réel constant différent du courant nul (0A) sont détectés, notamment un plateau constant d'une impulsion de puissance de chauffage, et/ou
un état désactivé est détecté ou déterminé comme état réel actuel du module de chauffage lorsqu'une tension réelle décroissante et/ou une variation de tension réelle décroissante et/ou un courant réel décroissant ou une variation de courant réel décroissante sont détectés, en particulier un flanc descendant d'une impulsion de puissance de chauffage, et/ou
un état d'arrêt est détecté ou déterminé comme état réel actuel du module de chauffage lorsqu'une tension nulle (0V) comme tension réelle constante et/ou une variation de tension nulle constante comme variation de tension réelle et/ou un courant nul comme courant réel constant ou une variation de courant nul constant comme variation de courant réel sont détectés, en particulier un plateau nul constant d'une impulsion de puissance de chauffage.

12. Dispositif combiné de chauffage et de détection capacitive (10, 60, 70) selon la revendication 11, **caractérisé en ce que** le module de synchronisation (40) est conçu et adapté pour déclencher, lorsqu'un état désactivé ou un état d'arrêt ou un état activé du module de chauffage a été détecté, un mode de détection de l'élément combiné de chauffage et de détection (4), en particulier immédiatement ou avec un retard défini.

13. Dispositif combiné de chauffage et de détection capacitive (10, 60, 70) selon l'une des revendications précédentes, **caractérisé en ce que** le dispositif de chauffage et de détection (10, 60, 70) est conçu et adapté pour mettre fin immédiatement au mode de détection une fois qu'une mesure capacitive est terminée et/ou après un laps de temps défini, en particulier immédiatement après un laps de temps défini, le dispositif de chauffage et de détection (10, 60, 70) étant de préférence conçu et adapté pour passer au mode de chauffage une fois que le mode de détection est terminé.

14. Procédé de fonctionnement d'un dispositif combiné de chauffage et de détection (10, 60, 70), qui est conçu selon l'une des revendications 1 à 13, le dispositif de chauffage et de détection capacitive (10, 60, 70) fonctionnant au choix, en particulier en alternance, comme module de chauffage ou comme module de détection,
pour faire fonctionner le dispositif de chauffage et de détection (10, 60, 70) comme module de chauffage, l'élément combiné de chauffage et de détection (4) étant utilisé comme élément de chauffage électrique,
pour activer le module de chauffage, tous les modules de commutation (S1, S3, S5) le long du premier chemin électrique (P1) et tous les modules de commutation (S2, S4, S6) le long du deuxième chemin électrique (P2) étant fermés et, pour désactiver le module de chauffage, au moins un module de commutation (S1, S3, S5) le long du premier chemin électrique (P1) et au moins un module de commutation (S2, S4, S6) le long du deuxième chemin électrique (P2) étant ouverts,
pour faire fonctionner le dispositif de chauffage et de détection (10, 60, 70) comme module de détection, l'élément combiné de chauffage et de détection (4) étant utilisé comme électrode de détection capacitive et au moins un module de commutation (S1, S3, S5) du premier chemin électrique (P1) et au moins un module de commutation (S2, S4, S6) du deuxième chemin électrique (P2) étant ouverts,
**caractérisé en ce que**
une tension réelle, notamment une variation de tension réelle dans le temps, et/ou un courant réel actuel, en particulier une variation de courant réel dans le temps, lesquels sont appliqués sur le premier chemin électrique (P1) entre le premier pôle 8V+) de la source de tension et la première borne (5) de l'élément combiné de chauffage et de détection (4), sont détectés le long du premier chemin électrique (P1), et/ou
une tension réelle, notamment une variation de tension réelle dans le temps, et/ou un courant réel, en particulier une variation de courant réel dans le temps, lesquels sont appliqués sur le deuxième chemin électrique (P2) entre la deuxième borne (6) de de l'élément combiné de chauffage et de détection (4) et le deuxième pôle (GND), sont détectés le long du deuxième chemin électrique (P2),
un état réel actuel du module de chauffage est déterminé en fonction de la tension réelle détectée et/ou du courant réel détecté, et le module de détection est activé au moins partiellement, et/ou au moins un signal de commande est délivré pour activer au moins partiellement le module de détection, en fonction de l'état réel déterminé du module de chauffage.

15. Procédé selon la revendication 14, **caractérisé en ce que**, lorsqu'un état d'arrêt ou un état activé du module de chauffage a été détecté ou déterminé comme état réel du module de chauffage, un mode de détection de l'élément combiné de chauffage et de détection (4) est déclenché, notamment immédiatement ou avec un retard défini.

16. Ensemble de dispositif d'entrée de direction (100, 200, 300), en particulier ensemble de dispositif d'entrée de direction (100, 200, 300) destiné à un véhicule comprenant une partie côté volant (1), qui comporte notamment au moins un module de volant, en particulier un volant (3) pourvu d'un module de volant, et une partie côté carrosserie (2), en particulier un module de colonne de direction,
la partie côté volant (1) de l'ensemble de dispositif d'entrée de direction (100, 200, 300) étant mobile par rapport à la partie côté carrosserie (2), en particulier rotative par rapport à la partie côté carrosserie (2), en particulier sur un axe de rotation d'un arbre de direction, lorsque l'ensemble de dispositif d'entrée de direction (100, 200, 300) est fonctionnellement installé dans un véhicule, et l'ensemble de dispositif d'entrée de direction (100, 200, 300) comportant un dispositif combiné de chauffage et de détection capacitive (10, 60, 70),
**caractérisé en ce que** le dispositif combiné de chauffage et de détection capacitive (10, 60, 70) est conçu selon l'une des revendications 1 à 13.

17. Véhicule comprenant un ensemble de dispositif d'entrée de direction (100, 200, 300), **caractérisé en ce que** l'ensemble de dispositif d'entrée de direction (100, 200, 300) est conçu selon la revendication 16, la partie côté volant (1) étant mobile par rapport à la partie côté carrosserie (2), notamment rotative par rapport à la partie côté carrosserie (2), notamment sur un axe de rotation d'un arbre de direction.
